# EUROPEAN PATENT APPLICATION

(11) **EP 4 284 144 A1**
(43) Date of publication of application: **29.11.2023**
(21) Application number: 23174665.2
(22) Date of filing: 22.05.2023
(51) Int. Cl.: H10K 50/11, H10K 50/15

(54) **LIGHT-EMITTING DEVICE, ELECTRONIC DEVICE INCLUDING THE SAME, AND ELECTRONIC APPARATUS INCLUDING THE SAME**

(30) Priority: 23.05.2022 KR 20220063069; 30.12.2022 KR 20220191039
(71) Applicant: Samsung Display Co., Ltd., Yongin-si, Gyeonggi-do 17113 (KR)
(72) Inventor: Kim, Gyeongheon, 17113 Yongin-si (KR); Jung, Hyojoo, 17113 Yongin-si (KR); Kim, Sohae, 17113 Yongin-si (KR); Kim, Jihye, 17113 Yongin-si (KR); Park, Saerom, 17113 Yongin-si (KR); Yoo, Dongsun, 17113 Yongin-si (KR); Cho, Jintaek, 17113 Yongin-si (KR); Choi, Jinyoung, 17113 Yongin-si (KR)
(74) Representative: Taor, Simon Edward William

(57) **Abstract**

Embodiments provide a light-emitting device, an electronic device including the same, and an electronic apparatus including the light-emitting device. The light-emitting device includes a first electrode, a second electrode facing the first electrode, and an interlayer between the first electrode and the second electrode. The interlayer includes a hole transport region and an emission layer; the hole transport region is disposed between the first electrode and the emission layer; the hole transport region includes a first layer, which directly contacts the emission layer; the emission layer includes a first host and a first emitter; the first emitter emits first light having a first emission spectrum; and the first layer includes a first material.

## Description

### CROSS-REFERENCE TO RELATED APPLICATIONS

This application claims priority to and benefits of Korean Patent Application Nos. 10-2022-0063069 and 10-2022-0191039 under 35 U.S.C. §119, filed on May 23, 2022 and December 30, 2022, respectively, in the Korean Intellectual Property Office.

### BACKGROUND

### 1. Technical Field

Embodiments relate to a light-emitting device, an electronic device including the same, and an electronic apparatus including the same.

### 2. Description of the Related Art

Self-emissive devices (for example, organic light-emitting devices) in light-emitting devices have wide viewing angles, high contrast ratios, short response times, and excellent characteristics in terms of luminance, driving voltage, and response speed.

In a light-emitting device, a first electrode is located on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transition from an excited state to a ground state to thereby generate light.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Embodiments include a light-emitting device having a low driving voltage and high power efficiency, an electronic device including the same, and an electronic apparatus including the same.

Additional aspects will be set forth in part in the description which follows and, in part, will be apparent from the description, or may be learned by practice of the embodiments of the disclosure.

According to embodiments, a light-emitting device may include
a first electrode,
a second electrode facing the first electrode, and
an interlayer disposed between the first electrode and the second electrode, wherein
the interlayer may include a hole transport region and an emission layer,
the hole transport region may be disposed between the first electrode and the emission layer,
the hole transport region may include a first layer,
the first layer may directly contact the emission layer,
the emission layer may include a first host and a first emitter,
the first emitter may emit first light having a first emission spectrum,
the first layer may include a first material,
an absolute value of a difference between a highest occupied molecular orbital (HOMO) energy level of the first material and a HOMO energy level of the first host may be in a range of about 0 eV to about 0.20 eV,
an absolute value of a HOMO energy level of the first emitter may be greater than an absolute value of the HOMO energy level of the first host, and
the HOMO energy level of each of the first material, first host and first emitter may be a negative value measured by cyclic voltammetry.

In an embodiment, the HOMO energy level of the first material may be in a range of about -5.60 eV to about -4.80 eV.

In an embodiment, the HOMO energy level of the first host may be in a range of about -5.10 eV to about -4.50 eV.

In an embodiment, an absolute value of a difference between the HOMO energy level of the first emitter and the HOMO energy level of the first host may be in a range of about 0.01 eV to about 1.0 eV.

In an embodiment, the hole transport region may further include a second layer and a third layer; the second layer may be disposed between the first electrode and the first layer; the third layer may be disposed between the first electrode and the second layer; the second layer may include a second material; the third layer may include a third material; and the first material, the second material, and the third material may be different from each other.

In an embodiment, one of the following conditions may be satisfied:
HOMO energy level of the third material > HOMO energy level of the second material > HOMO energy level of the first material; or
HOMO energy level of the third material > HOMO energy level of the first material > HOMO energy level of the second material,
wherein the HOMO energy level of each of the second material and the third material may be a negative value measured by cyclic voltammetry.

In an embodiment, a HOMO energy level of the second material may be in a range of about -5.40 eV to about -4.70 eV; and the HOMO energy level of the second material may be a negative value measured by cyclic voltammetry.

In an embodiment, a HOMO energy level of the third material may be in a range of about -5.25 eV to about -4.50 eV; and the HOMO energy level of the third material may be a negative value measured by cyclic voltammetry.

In an embodiment, the hole transport region may further include a p-dopant.

In an embodiment, a HOMO energy level of the first emitter may be in a range of about -5.50 eV to about -4.00 eV.

In an embodiment, a peak wavelength of the first light may be in a range of about 510 nm to about 610 nm.

In an embodiment, a full width at half maximum of the first light may be in a range of about 15 nm to about 85 nm.

In an embodiment, the light-emitting device may further include at least one of a first capping layer outside the first electrode and a second capping layer outside the second electrode, wherein the at least one of the first capping layer and the second capping layer may each independently include a material having a refractive index of greater than or equal to about 1.6 with respect to a wavelength of about 589 nm.

In an embodiment, the at least one of the first capping layer and the second capping layer may each independently include a material having a refractive index of greater than or equal to about 1.8 with respect to a wavelength of about 589 nm.

In an embodiment, the first emitter may be an organometallic compound that includes platinum, and a first ligand bound to the platinum; and the first emitter may satisfy at least one of Conditions A to C, which are explained below.

In an embodiment, the first emitter may be an organometallic compound that includes iridium, and a first ligand, a second ligand, and a third ligand, each bonded to the iridium; the first ligand may be a bidentate ligand comprising Y₁-containing ring B₁ and Y₂-containing ring B₂; the second ligand may be a bidentate ligand including Y₃-containing ring B₃ and Y₄-containing ring B₄; the third ligand may be a bidentate ligand comprising Y₅-containing ring B₅ and Y₆-containing ring Bs; ring B₁ to ring B₆ may each independently be a C₃-C₆₀ carbocyclic group or a C₁-C₆₀ heterocyclic group; Y₁, Y₃, and Y₅ may each be nitrogen (N); Y₂, Y₄, and Y₆ may each be carbon (C); and Y₂-containing ring B₂ and Y₄-containing ring B₄ may be different from each other.

According to embodiments, an electronic device may include the light-emitting device.

In an embodiment, the electronic device may further include a color filter, a color conversion layer, a touch screen layer, a polarizing layer, or any combination thereof.

According to embodiments, an electronic apparatus may include the light-emitting device.

In an embodiment, the electronic apparatus may be a flat panel display, a curved display, a computer monitor, a medical monitor, a TV, a billboard, an indoor light, an outdoor light, a signal light, a head-up display, a fully transparent display, a partially transparent display, a flexible display, a rollable display, a foldable display, a stretchable display, a laser printer, a phone, a cell phone, a tablet, a phablet, a personal digital assistant (PDA), a wearable device, a laptop computer, a digital camera, a camcorder, a viewfinder, a microdisplay, a three-dimensional (3D) display, a virtual reality display, an augmented reality display, a vehicle, a video wall including multiple displays tiled together, a theater screen, a stadium screen, a phototherapy device, or a signage.

According to an aspect, there is provided a light-emitting device as set out in claim 1. Additional features are set out in claims 2 to 15. According to an aspect, there is provided an electronic device as set out in claim 16. According to an aspect, there is provided an electronic apparatus as set out in claim 17.

It is to be understood that the embodiments above are described in a generic and explanatory sense only and not for the purpose of limitation, and the disclosure is not limited to the embodiments described above.

### BRIEF DESCRIPTION OF THE DRAWINGS

The above and other aspects and features of the disclosure will be more apparent by describing in detail embodiments thereof with reference to the accompanying drawings, in which:
FIG. 1 is a schematic cross-sectional view of a light-emitting device according to an embodiment;
FIG. 2 is a schematic cross-sectional view of an electronic device according to an embodiment;
FIG. 3 is a schematic cross-sectional view an electronic device according to an embodiment;
FIG. 4 is a schematic perspective view of an electronic apparatus according to an embodiment;
FIG. 5 is a schematic perspective view of an exterior of a vehicle as an electronic apparatus according to an embodiment; and
FIGS. 6A, 6B, and 6C are each a schematic diagram of an interior of a vehicle according to embodiments.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, the sizes, thicknesses, ratios, and dimensions of the elements may be exaggerated for ease of description and for clarity. Like numbers refer to like elements throughout.

In the description, it will be understood that when an element (or region, layer, part, etc.) is referred to as being "on", "connected to", or "coupled to" another element, it can be directly on, connected to, or coupled to the other element, or one or more intervening elements may be present therebetween. In a similar sense, when an element (or region, layer, part, etc.) is described as "covering" another element, it can directly cover the other element, or one or more intervening elements may be present therebetween.

In the description, when an element is "directly on," "directly connected to," or "directly coupled to" another element, there are no intervening elements present. For example, "directly on" may mean that two layers or two elements are disposed without an additional element such as an adhesion element therebetween.

As used herein, the expressions used in the singular such as "a," "an," and "the," are intended to include the plural forms as well, unless the context clearly indicates otherwise.

As used herein, the term "and/or" includes any and all combinations of one or more of the associated listed items. For example, "A and/or B" may be understood to mean "A, B, or A and B." The terms "and" and "or" may be used in the conjunctive or disjunctive sense and may be understood to be equivalent to "and/or".

In the specification and the claims, the term "at least one of" is intended to include the meaning of "at least one selected from the group consisting of" for the purpose of its meaning and interpretation. For example, "at least one of A, B, and C" may be understood to mean A only, B only, C only, or any combination of two or more of A, B, and C, such as ABC, ACC, BC, or CC. When preceding a list of elements, the term, "at least one of," modifies the entire list of elements and does not modify the individual elements of the list.

It will be understood that, although the terms first, second, etc. may be used herein to describe various elements, these elements should not be limited by these terms. These terms are only used to distinguish one element from another element. Thus, a first element could be termed a second element without departing from the teachings of the disclosure. Similarly, a second element could be termed a first element, without departing from the scope of the disclosure.

The spatially relative terms "below", "beneath", "lower", "above", "upper", or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

The terms "about" or "approximately" as used herein is inclusive of the stated value and means within an acceptable range of deviation for the recited value as determined by one of ordinary skill in the art, considering the measurement in question and the error associated with measurement of the recited quantity (i.e., the limitations of the measurement system). For example, "about" may mean within one or more standard deviations, or within ±20%, ±1 0%, or ±5% of the stated value.

It should be understood that the terms "comprises," "comprising," "includes," "including," "have," "having," "contains," "containing," and the like are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

A light-emitting device according to an embodiment may include a first electrode, a second electrode facing the first electrode, and an interlayer disposed between the first electrode and the second electrode.

The interlayer may include a hole transport region and an emission layer, and the hole transport region may be disposed between the first electrode and the emission layer.

The hole transport region may include a first layer, and the first layer may directly contact the emission layer.

In an embodiment, a first electrode, a first layer, an emission layer, and a second electrode in the light-emitting devices may be sequentially stacked.

The emission layer may include a first host and a first emitter, and the first emitter may emit first light having a first emission spectrum.

The first layer may include a first material.

An absolute value of a difference between a HOMO energy level of the first material and a HOMO energy level of the first host may be in a range of about 0 eV to about 0.20 eV, about 0 eV to about 0.15 eV, about 0 eV to about 0.10 eV, about 0.01 eV to about 0.20 eV, about 0.01 eV to about 0.15 eV, about 0.01 eV to about 0.10 eV, about 0.03 eV to about 0.20 eV, about 0.03 eV to about 0.15 eV, or about 0.03 eV to about 0.10 eV.

In an embodiment, the HOMO energy level of the first material may be in a range of about -5.60 eV to about -4.80 eV. For example, the HOMO energy level of the first material may be in a range of about -5.40 eV to about -4.80 eV, about -5.20 eV to about -4.80 eV, about -5.00 eV to about -4.80 eV, about -5.60 eV to about -4.90 eV, about -5.40 eV to about -4.90 eV, about -5.20 eV to about -4.90 eV, or about -5.00 eV to about -4.90 eV.

According to an embodiment, a hole mobility of the first material may be in a range of about 6.80 × 10⁻⁵ cm²/Vs to about 1.85 × 10⁻³ cm²/Vs. For example, the hole mobility of the first material may be in a range of about 1.00 × 10⁻⁴ cm²/Vs to about 1.70 × 10⁻³ cm²/Vs.

The hole mobility and electron mobility of each of a third material, a second material, a first material, a first host, a buffer layer material, an electron transport layer material, etc. are evaluated by using a space-charge-limited current (SCLC) method described in "Hole mobility of N,N'-bis(naphtanlen-1-yl)-N,N'-bis(phenyl)benzidine investigated by using space-charge-limited currents, 'Appl. Phys. Lett. 90, 203512 (2007)."

According to an embodiment, the HOMO energy level of the first host may be in a range of about -5.10 eV to about -4.50 eV. For example, the HOMO energy level of the first host may be in a range of about -5.10 eV to about -4.60 eV, about -5.10 eV to about -4.70 eV, about -5.10 eV to about -4.80 eV, about -5.00 eV to about -4.50 eV, -5.00 eV to about -4.60 eV, about -5.00 eV to about -4.70 eV, or about -5.00 eV to about -4.80 eV.

In an embodiment, the hole mobility of the first host may be in a range of about 5.01 × 10⁻⁵ cm²/Vs to about 5.60 × 10⁻³ cm²/Vs. For example, the hole mobility of the first host may be in a range of about 2.00 × 10⁻⁴ cm²/Vs to about 3.00 × 10⁻³ cm²/Vs.

In an embodiment, a lowest unoccupied molecular orbital (LUMO) energy level of the first host may be in a range of about -2.20 eV to about -2.00 eV. For example, the LUMO energy level of the first host may be in a range of about -2.15 eV to about - 2.00 eV.

In an embodiment, the electron mobility of the first host may be in a range of about 1.97 × 10⁻⁷ cm²/Vs to about 2.30 × 10⁻⁴cm²/Vs. For example, the electron mobility of the first host may be in a range of about 3.00 × 10⁻⁷ cm²/Vs to about 1.00 × 10⁻⁴ cm²/Vs.

An absolute value of the HOMO energy level of the first emitter may be greater than an absolute value of the HOMO energy level of the first host.

For example, an absolute value of a difference between the HOMO energy level of the first emitter and the HOMO energy level of the first host may be in a range of about 0.01 eV to about 1.00 eV. For example, the absolute value of the difference between the HOMO energy level of the first emitter and the HOMO energy level of the first host may be in a range of about 0.01 eV to about 0.7 eV.

In an embodiment, the absolute value of the difference between the HOMO energy level of the first material and the HOMO energy level of the first host may be in a range of about 0 eV to about 0.20 eV, and the absolute value of the HOMO energy level of the first emitter may be greater than the absolute value of the HOMO energy level of the first host. Accordingly, injection of holes from the first electrode into the emission layer may be readily performed, and excitons may be effectively formed in the emission layer, so that the driving voltage and power efficiency characteristics of the light-emitting device can be improved.

According to an embodiment, the hole transport region may further include a second layer and a third layer. The second layer may be disposed between the first electrode and the first layer, and the third layer may be disposed between the first electrode and the first layer. The second layer may include a second material, and the third layer may include a third material. For example, the light-emitting device may further include a second layer and a third layer, and may have a structure in which the first electrode, the third layer, the second layer, the first layer, the emission layer, and the second electrode are sequentially stacked. In an embodiment, each of the first material, the second material, and the third material may be different from each other.

The light-emitting device may satisfy one of the following conditions:
HOMO energy level of the third material > HOMO energy level of the second material > HOMO energy level of the first material; or
HOMO energy level of the third material > HOMO energy level of the first material > HOMO energy level of the second material.

In an embodiment, the HOMO energy level of the second material may be in a range of about -5.40 eV to about -4.70 eV. For example, the HOMO energy level of the second material may be in a range of about -5.30 eV to about -4.70 eV, about -5.20 eV to about -4.70 eV, about -5.10 eV to about -4.70 eV, about -5.40 eV to about -4.80 eV, about -5.30 eV to about -4.80 eV, about -5.20 eV to about -4.80 eV, or about -5.10 eV to about -4.80 eV.

According to an embodiment, the hole mobility of the second material may be in a range of about 6.80 × 10⁻⁵ cm²/Vs to about 1.85 × 10⁻³ cm²/Vs. For example, the hole mobility of the second material may be in a range of about 1.00 × 10⁻⁴ cm²/Vs to about 3.00 × 10⁻³ cm²/Vs.

In an embodiment, a LUMO energy level of the second material may be in a range of about -1.70 eV to about -0.90 eV. For example, the LUMO energy level of the second material may be in a range of about -1.51 eV to about -1.01 eV.

In an embodiment, a HOMO energy level of the third material may be in a range of about -5.25 eV to about -4.50 eV. For example, the HOMO energy level of the third material may be in a range of about -5.15 eV to about -4.50 eV, about -5.05 eV to about -4.50 eV, about -4.95 eV to about -4.50 eV, about -4.85 eV to about -4.50 eV, about - 4.75 eV to about -4.50 eV, about -5.25 eV to about -4.60 eV, about -5.15 eV to about -4.60 eV, about -5.05 eV to about -4.60 eV, about -4.95 eV to about -4.60 eV, about - 4.85 eV to about -4.60 eV, or about -4.75 eV to about -4.60 eV.

In an embodiment, the hole mobility of the third material may be in a range of about 6.20 × 10⁻⁵ cm²/Vs to about 1.25 × 10⁻³ cm²/Vs. For example, the hole mobility of the third material may be in a range of about 7.00 × 10⁻⁴ cm²/Vs to about 8.00 × 10⁻⁴ cm²/Vs.

In an embodiment, a LUMO energy level of the third material may be in a range of about -1.30 eV to about -0.90 eV. For example, the LUMO energy level of the third material may be in a range of about -1.28 eV to about -1.03 eV.

In an embodiment, an absolute value of a difference between the HOMO energy level of the third material and the HOMO energy level of the second material may be in a range of about 0.10 eV to about 0.70 eV. For example, the absolute value of the difference between the HOMO energy level of the third material and the HOMO energy level of the second material may be in a range of about 0.137 eV to about 0.686 eV.

In an embodiment, an absolute value of a difference between the HOMO energy level of the second material and the HOMO energy level of the first material may be in a range of about 0.40 eV to about 0.70 eV. For example, the absolute value of the difference between the HOMO energy level of the second material and the HOMO energy level of the first material may be in a range of about 0.412 eV to about 0.686 eV.

The HOMO energy levels used herein may be negative values measured by cyclic voltammetry. For example, an example of the HOMO energy level measurement method may be understood by referring to Evaluation Example 1 below.

As described above, the hole transport region including the first layer and optionally including the second layer and/or the third layer may further include a p-dopant. A description of the p-dopant will be described below.

In an embodiment, the HOMO energy level of the first emitter in the emission layer may be in a range of about -5.50 eV to about -4.00 eV. For example, the HOMO energy level of the first emitter may be in a range of about -5.50 eV to about -4.80 eV, about -5.45 eV to about -4.80 eV, about -5.50 eV to about -4.85 eV, about -5.45 eV to about -4.85 eV, about -5.50 eV to about -4.90 eV, or about -5.45 eV to about -4.90 eV.

In an embodiment, the LUMO energy level of the first emitter in the emission layers may be in a range of about -2.40 eV to about -2.00 eV. For example, the LUMO energy level of the first emitter in the emission layers may be in a range of about -2.20 eV to about -2.00 eV.

A triplet (T₁) energy of the first emitter may be in a range of about 2.10 eV to about 2.60 eV. For example, the triplet energy of the first emitter may be in a range of about 2.20 eV to about 2.50 eV.

For the method of evaluating the triplet energy of the first emitter, Evaluation Example 1 of the application may be referred to.

A peak wavelength (maximum emission wavelength, or maximum emission peak wavelength) of the first light may be in a range of about 510 nm to about 610 nm.

For example, the peak wavelength of the first light may be in a range of about 510 nm to about 565 nm, about 510 nm to about 560 nm, about 510 nm to about 555 nm, about 510 nm to about 550 nm, about 510 nm to about 545 nm, about 510 nm to about 540 nm, about 515 nm to about 570 nm, about 515 nm to about 565 nm, about 515 nm to about 560 nm, about 515 nm to about 555 nm, about 515 nm to about 550 nm, about 515 nm to about 545 nm, about 515 nm to about 540 nm, about 520 nm to about 570 nm, about 520 nm to about 565 nm, about 520 nm to about 560 nm, about 520 nm to about 555 nm, about 520 nm to about 550 nm, about 520 nm to about 545 nm, about 520 nm to about 540 nm, about 525 nm to about 570 nm, about 525 nm to about 565 nm, about 525 nm to about 560 nm, about 525 nm to about 555 nm, about 525 nm to about 550 nm, about 525 nm to about 545 nm, or about 525 nm to about 540 nm.

A full width at half maximum (FWHM) of the first light may be in a range of about 15 nm to about 85 nm.

For example, the FWHM of the first light may be in a range of about 20 nm to about 85 nm, about 25 nm to about 85 nm, about 30 nm to about 85 nm, about 35 nm to about 85 nm, about 40 nm to about 85 nm, about 45 nm to about 85 nm, about 50 nm to about 85 nm, about 15 nm to about 80 nm, about 20 nm to about 80 nm, about 25 nm to about 80 nm, about 30 nm to about 80 nm, about 35 nm to about 80 nm, about 40 nm to about 80 nm, about 45 nm to about 80 nm, about 50 nm to about 80 nm, about 15 nm to about 75 nm, about 20 nm to about 75 nm, about 25 nm to about 75 nm, about 30 nm to about 75 nm, about 35 nm to about 75 nm, about 40 nm to about 75 nm, about 45 nm to about 75 nm, about 50 nm to about 75 nm, about 15 nm to about 70 nm, about 20 nm to about 70 nm, about 25 nm to about 70 nm, about 30 nm to about 70 nm, about 35 nm to about 70 nm, about 40 nm to about 70 nm, about 45 nm to about 70 nm, about 50 nm to about 70 nm, about 15 nm to about 65 nm, about 20 nm to about 65 nm, about 25 nm to about 65 nm, about 30 nm to about 65 nm, about 35 nm to about 65 nm, about 40 nm to about 65 nm, about 45 nm to about 65 nm, about 50 nm to about 65 nm, about 15 nm to about 60 nm, about 20 nm to about 60 nm, about 25 nm to about 60 nm, about 60 nm to about 60 nm, about 35 nm to about 60 nm, about 40 nm to about 60 nm, about 45 nm to about 60 nm, or about 50 nm to about 60 nm.

The peak wavelength (or maximum emission wavelength) and FWHM of the first light described in the specification may be evaluated from the emission spectrum of a film including the first emitter (for example, see Evaluation Example 2). The peak wavelength in the specification may be a peak wavelength having a maximum emission intensity in the emission spectrum or electroluminescence spectrum.

The first light may be a green light.

The first emitter may be a transition metal-containing organometallic compound.

The first emitter may be a platinum-containing organometallic compound. In an embodiment, the first emitter may be neutral, may include one platinum, and may not include a transition metal other than platinum.

A triplet metal-to-ligand charge transfer state (³MLCT) of the platinum-containing organometallic compound may be greater than or equal to about 7%.

For example, the ³MLCT of the platinum-containing organometallic compound may be in a range of about 7 % to about 30 %, about 7 % to about 25 %, about 7 % to about 20 %, about 7 % to about 18 %, about 7 % to about 16 %, about 8 % to about 30 %, about 8 % to about 25 %, about 8 % to about 20 %, about 8 % to about 18 %, about 8 % to about 16 %, about 9 % to about 30 %, about 9 % to about 25 %, about 9 % to about 20 %, about 9 % to about 18 %, or about 9 % to about 16 %.

According to an embodiment, the platinum-containing organometallic compound may further include a first ligand bonded to the platinum in addition to the platinum.

In an embodiment, the platinum-containing organometallic compound may satisfy at least one of Conditions A to C:

### [Condition A]

The first ligand is a tetradentate ligand, and
a number of cyclometallated rings formed by a chemical bond between the platinum and the first ligand is three.

### [Condition B]

Each of carbon, nitrogen, and oxygen of the first ligand is chemically bonded to the platinum.

### [Condition C]

The first ligand includes an imidazole group, a benzimidazole group, a naphthoimidazole group, or any combination thereof.

In an embodiment, the platinum-containing organometallic compound may satisfy both Condition A to Condition C.

The platinum-containing organometallic compound may be understood by referring to the description to be provided below.

In an embodiment, the first emitter may be an iridium-containing organometallic compound. The first emitter may be neutral, may include one iridium, and may not include a transition metal other than iridium.

For example, the iridium-containing organometallic compound may include a first ligand, a second ligand, and a third ligand which are each bonded to iridium. In an embodiment, the first ligand may be a bidentate ligand including Y₁-containing ring B₁ and Y₂-containing ring B₂, the second ligand may be a bidentate ligand including Y₃-containing ring B₃ and Y₄-containing ring B₄, the third ligand may be a bidentate ligand including Y₅-containing ring B₅ and Y₆-containing ring B₆, each of Y₁, Y₃ and Y₅ may be nitrogen (N), and each of Y₂, Y₄ and Y₆ may be carbon (C).

In an embodiment, Y₂-containing ring B₂ and Y₄-containing ring B₄ may be different from each other.

In embodiments, Y₂-containing ring B₂ may be a polycyclic group. For example, Y₂-containing ring B₂ may be a polycyclic group in which three or more monocyclic groups (for example, 3 to 15 monocyclic groups) are condensed with each other. The monocyclic group may be, for example, a furan group, a thiophene group, a selenophene group, a pyrrole group, a cyclopentadiene group, a silole group, a benzene group, a pyridine group, a pyrimidine group, a pyrazine group, or a pyridazine group. In an embodiment, Y₂-containing ring B₂ may be a monocyclic group as described above.

In an embodiment, Y₂-containing ring B₂ may be a polycyclic group in which a 5-membered monocyclic group (for example, a furan group, a thiophene group, a selenophene group, a pyrrole group, a cyclopentadiene group, a silole group, etc.) is condensed with at least two 6-membered monocyclic groups (for example, a benzene group, a pyridine group, a pyrimidine group, a pyrazine group, a pyridazine group, etc.)

In an embodiment, Y₄-containing ring B₄ may be a monocyclic group. For example, Y₄-containing ring B₄ may be a 6-membered monocyclic group (for example, a benzene group, a pyridine group, a pyrimidine group, a pyrazine group, a pyridazine group, a triazine group, etc.).

In an embodiment, Y₄-containing ring B₄ may be a naphthalene group, a phenanthrene group, or an anthracene group.

In an embodiment, the iridium-containing organometallic compound may be a homoleptic complex. For example, the first ligand, second ligand, and third ligand may be the same as each other.

In an embodiment, the iridium-containing organometallic compound may be a heteroleptic complex.

In an embodiment, the third ligand and the second ligand may be identical.

In an embodiment, the third ligand and the first ligand may be identical.

In an embodiment, the third ligand may be different from each of the first ligand and the second ligand.

The iridium-containing organometallic compound may be understood by referring to the description to be provided below.

In an embodiment, the first emitter may include at least one deuterium.

In an embodiment, the first host may include at least one deuterium.

In an embodiment, the first host may include a spiro[fluorene-9,9'-xanthene] group, a spiro[fluorene-9,9'-thioxanthene] group, a phenoxazine group, a phenothiazine group, an indoline group, a 1,2,3,3a,4,8b-hexahydrocyclopenta[b]indole group, 2,3,4,4a,9,9a-hexahydro-1H-carbazole group, a C₁-C₃₀ alkoxy group, a di[(C₁-C₃₀ alkoxy)phenyl]amino group, or a combination thereof.

In an embodiment, the first host may be an electron-transporting compound, a hole-transporting compound, a bipolar compound, or a combination thereof. The first host may not include metal. The electron-transporting compound, the hole-transporting compound, and the bipolar compound may be different from each other.

In an embodiment, an electron-transporting compound may include at least one π electron-deficient nitrogen-containing C₁-C₆₀ cyclic group. In an embodiment, the electron-transporting compound may include a pyridine group, a pyrimidine group, a pyrazine group, a pyridazine group, a triazine group, or any combination thereof.

In an embodiment, the first host may be an electron-transporting compound, or may include an electron-transporting compound, and an electron-transporting compound may include:
at least one π electron-deficient nitrogen C₁-C₆₀ cyclic group; and
a spiro[fluorene-9,9'-xanthene] group, a spiro[fluorene-9,9'-thioxanthene] group, a phenoxazine group, a phenothiazine group, a C₁-C₃₀ alkoxy group, or a combination thereof.

In an embodiment, the first host (or the electron-transporting compound) may include:
a pyrimidine group, a pyrazine group, a pyrizadine group, a triazine group, or a combination thereof; and
a spiro[fluorene-9,9'-xanthene] group, a spiro[fluorene-9,9'-thioxanthene] group, a phenoxazine group, a phenothiazine group, an indoline group, a 1,2,3,3a,4,8b-hexahydrocyclopenta[b]indole group, a 2,3,4,4a,9,9a-hexahydro-1H-carbazole group, a carbazole group, a di[(C₁-C₃₉ alkoxy)phenyl]amino group-substituted carbazole group, or a combination thereof.

In an embodiment, the hole-transporting compound may include at least one π electron-rich C₃-C₆₀ cyclic group, a pyridine group, or a combination thereof, and may not include an electron-transporting group (for example, a π electron-deficient nitrogen-containing C₁-C₆₀ cyclic group excluding a pyridine group, a cyano group, a sulfoxide group, and a phosphine oxide group).

In an embodiment, the hole-transporting compound may not be CBP or mCBP.

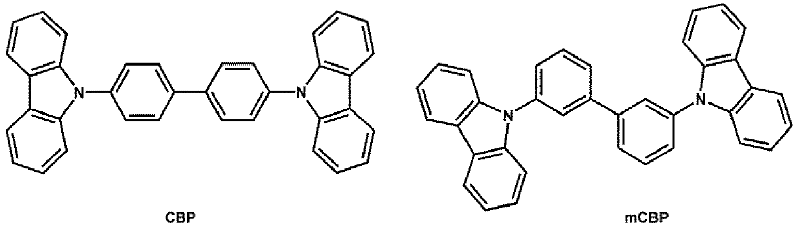

For example, the first host may be a hole-transporting compound, or may include a hole-transporting compound, and a hole-transporting compound may include:
at least one π electron-deficient nitrogenous C₁-C₆₀ cyclic group (for example, an anthracene group, a phenanthrene group, a pyrene group, a triphenylene group, or a combination thereof); and
a phenoxazine group, a phenothiazine group, an indoline group, a 1,2,3,3a,4,8b-hexahydrocyclopenta[b]indole group, a 2,3,4,4a,9,9a-hexahydro-1H-carbazole group, a carbazole group, a di[(C₁-C₃₀ alkoxy)phenyl]amino group, a pyridine group, or a combination thereof.

In an embodiment, an electron-transporting compound may include a compound represented by Formula 2-1:

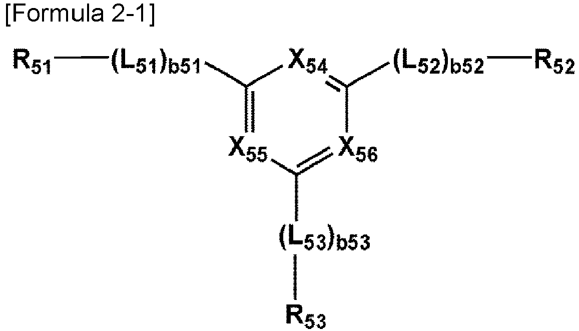

In Formula 2-1,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
X₅₄ may be N or C(R₅₄), X₅₅ may be N or C(R₅₅), X₅₆ may be N or C(R₅₆), and at least two of X₅₄ to X₅₆ may each be N, and
R₅₁ to R₅₆ and R₁₀ₐ are respectively the same as described in the specification.

For example, at least one of R₅₁ to R₅₃ may be: a spiro[fluorene-9,9'-xanthene] group; a spiro[fluorene-9,9'-thioxanthene] group; a phenoxazine group; a phenothiazine group; or -N(Q₁)(Q₂)(wherein Q₁ and Q₂ may each independently be a C₆-C₂₀ aryl group substituted with at least one C₁-C₃₀ alkoxy group (for example, a phenyl group substituted with at least one C₁-C₃₀ alkoxy group).

In an embodiment, the hole-transporting compound may include a compound represented by Formula 3-1, a compound represented by Formula 3-2, a compound represented by Formula 3-3, a compound represented by Formula 3-4, a compound represented by Formula 3-5, a compound represented by Formula 3-6, or any combination thereof:

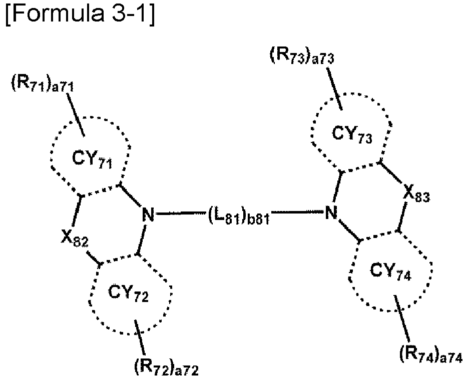

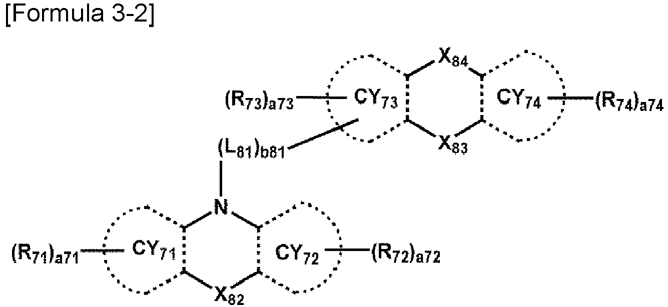

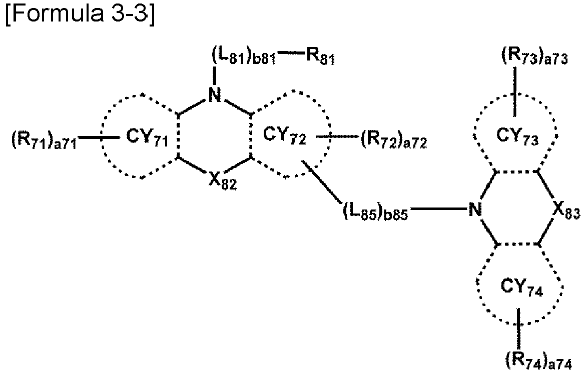

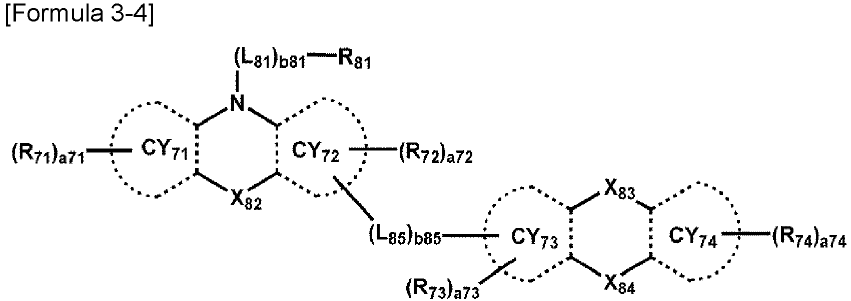

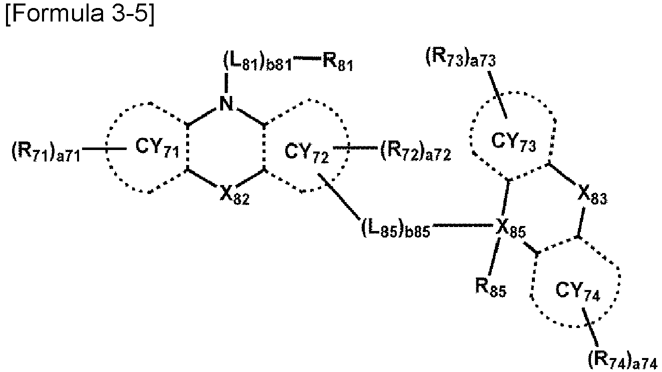

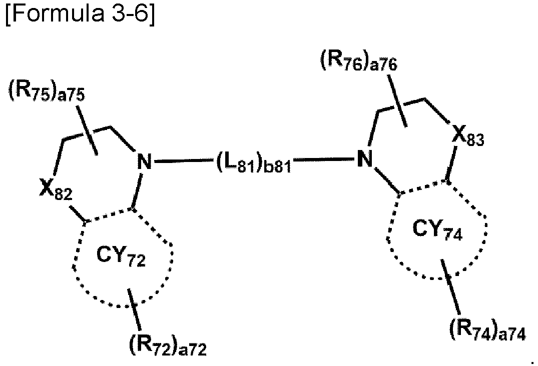

In Formulae 3-1 to 3-6,
ring CY₇₁ to ring CY₇₄ may each independently be a π electron-rich C₃-C₆₀ cyclic group (for example, a benzene group, a naphthalene group, a fluorene group, an anthracene group, a carbazole group, a dibenzofuran group, or a dibenzothiophene group), or a pyridine group,
X₈₂ may be a single bond, O, S, N-[(L₈₂)_{b82}-R₈₂], C(R₈₂ₐ)(R_{82b}), or Si(R₈₂ₐ)(R_{82b}),
X₈₃ may be a single bond, O, S, N-[(L₈₃)_{b83}-R₈₃], C(R₈₃ₐ)(R_{83b}), or Si(R₈₃ₐ)(R_{83b}),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ (for example, a benzene group, a naphthalene group, a fluorene group, a anthracene group, a carbazole group, a dibenzofuran group, or a dibenzothiophene group, each unsubstituted or substituted with at least one R₁₀ₐ), or a pyridine group unsubstituted or substituted with at least one R₁₀ₐ, wherein Q₄ and Q₅ are the same as described in connection with Q₁,
b81 to b85 may each independently be an integer from 1 to 5,
R₇₁ to R₇₆, R₈₁ to R₈₅, R₈₂ₐ, R_{82b}, R₈₃ₐ, R_{83b}, R₈₄ₐ, and R_{84b} are respectively the same as described in the specification,
a71 to a74 may each independently be an integer from 0 to 20,
a75 and a76 may each independently be an integer from 0 to 4, and
R₁₀ₐ may be understood by referring to the description of R₁₀ₐ provided herein.

In an embodiment, the hole-transporting compound may be a compound represented by Formula 3-1 or a compound represented by Formula 3-6. In Formulae 3-1 and 3-6, L₈₁ may be a π electron-rich C₃-C₆₀ cyclic group unsubstituted or substituted with R₁₀ₐ (for example, a benzene group, a naphthalene group, a fluorene group, an anthracene group, a carbazole group, a dibenzofuran group, a dibenzothiophene group, etc., each unsubstituted or substituted with R₁₀ₐ), a81 may be 1 or 2, ring CY₇₁ and ring CY₇₃ may each independently be a cyclopentane group or a cyclohexane group, and ring CY₇₂ and CY₇₄ may each be a benzene group.

In an embodiment, the emission layer may further include, in addition to the first emitter and the first host, an auxiliary dopant, a sensitizer, a delayed fluorescence material, or a combination thereof. Each of the auxiliary dopant, the sensitizer, the delayed fluorescence material, or any combination thereof may include at least one deuterium.

The term "interlayer" as used herein may be a single layer and/or all layers between the first electrode and the second electrode of the light-emitting device.

Another embodiment provides an electronic device including the light-emitting device. The electronic device may further include a thin-film transistor. In an embodiment, the electronic device may include a thin-film transistor including a source electrode and a drain electrode, and the first electrode of the light-emitting device may be electrically connected to the source electrode or the drain electrode. In an embodiment, the electronic device may further include a color filter, a color conversion layer, a touch screen layer, a polarizing layer, or any combination thereof. For more details on the electronic device, related descriptions provided herein may be referred to.

Another embodiment provides an electronic apparatus including the light-emitting device. By using a light-emitting device having an emission layer and a first layer as described in the specification, the quality, power consumption, durability, and the like of the electronic apparatus may be improved.

For example, the electronic apparatus may be one of a flat panel display, a curved display, a computer monitor, a medical monitor, a TV, a billboard, indoor or outdoor illuminations and/or signal light, a head-up display, a fully or partially transparent display, a flexible display, a rollable display, a foldable display, a stretchable display, a laser printer, a phone, a cell phone, a tablet, a phablet, a personal digital assistant (PDA), a wearable device, laptop computers, digital cameras, camcorders, viewfinders, micro displays, 3D displays, virtual or augmented reality displays, vehicles, a video wall including multiple displays tiled together, a theater or stadium screen, a phototherapy device, and a signage.

### [Descriptions of Formulae]

In an embodiment, a platinum-containing organometallic compound may be an organometallic compound represented by Formula 10:

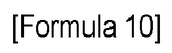

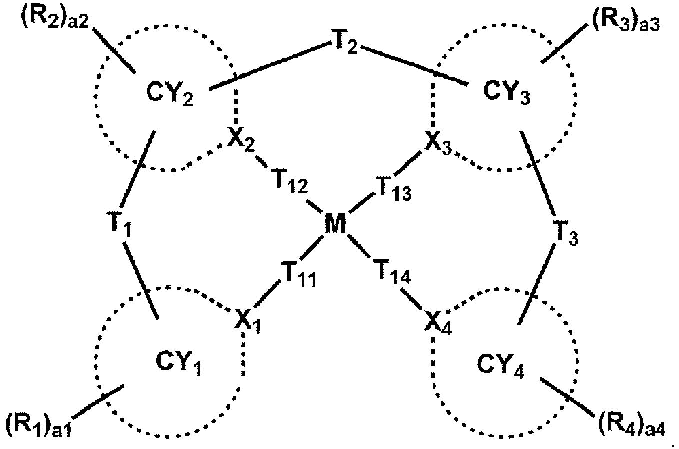

In Formula 10,
M may be platinum (Pt),
X₁ to X₄ may each independently be N or C,
T₁₁ to T₁₄ may each independently be a chemical bond, O, S, B(R'), N(R'), P(R'), C(R')(R"), Si(R')(R"), Ge(R')(R"), C(=O), B(R')(R"), N(R')(R"), or P(R')(R"),
when T₁₁ is a chemical bond, X₁ and M may be directly bonded to each other; when T₁₂ is a chemical bond, X₂ and M may be directly bond to each other; when T₁₃ is a chemical bond, X₃ and M may be directly bond to each other; and when T₁₄ is a chemical bond, X₄ and M may be directly bond to each other,
two bonds selected from a bond between X₁ or T₁₁ and M, a bond between X₂ or T₁₂ and M, a bond between X₃ or T₁₃ and M, and a bond between X₄ or T₁₄ and M may each be a coordinate bond, and the remainder of a bond between X₁ or T₁₁ and M, a bond between X₂ or T₁₂ and M, a bond between X₃ or T₁₃ and M, and a bond between X₄ or T₁₄ and M may each be a covalent bond,
T₁ may be a single bond, a double bond, *-N(R₅)-*', *-B(R₅)-*', *-P(R₅)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)₂-*', *-C(R₅)=*', *=C(R₅)-*', *-C(R₅ₐ)=C(R_{5b})-*', *-C(=S)-*', or*-C≡C-*',
T₂ may be a single bond, a double bond, *-N(R₆)-*', *-B(R₆)-*', *-P(R₆)-*', *-C(R₆ₐ)(R_{6b})-*', *-Si(R₆ₐ)(R_{6b})-*', *-Ge(R₆ₐ)(R_{6b})-*', *-S-*', *-Se-*', *-O-*', *-C(=O)-*', *-S(=O)-*', *-S(=O)₂-*', *-C(R₆)=*', *=C(R₆)-*', *-C(R₆a)=C(R_{6b})-*', *-C(=S)-*', or *-C≡C-*',
T₃ may be a single bond, a double bond, *-N(R₇)-*', *-B(R₇)-*', *-P(R₇)-*', *-C(R₇ₐ)(R_{7b})-*', *-Si(R₇ₐ)(R_{7b})-*', *-Ge(R₇ₐ)(R_{7b})-*', *-S-*', *-Se-*', *-O-*', *-C(=O)-*', *-S(=O)-*', *-S(=O)₂-*', *-C(R₇)=*', *=C(R₇)-*', *-C(R₇a)=C(R_{7b})-*', *-C(=S)-*', or*-C≡C-*',
ring CY₁ to ring CY₄ may each independently be a C₃-C₆₀ carbocyclic group or a C₁-C₆₀ heterocyclic group,
R₁ to R₇, R₅ₐ, R_{5b}, R₆ₐ, R_{6b}, R₇ₐ, R_{7b}, R', and R" may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ aryl alkyl group unsubstituted or substituted with at least one R₁₀ₐ, a C₂-C₆₀ heteroaryl alkyl group unsubstituted or substituted with at least one R₁₀ₐ, - C(Q₁)(Q₂)(Q₃), -Si(Qi)(Q₂)(Q₃), -N(Q₁)(Q₂), -B(Q₁)(Q₂), -C(=O)(Q₁), -S(=O)₂(Q₁), or - P(=O)(Q₁)(Q₂),
a1 to a4 may each independently be an integer from 0 to 20,
* and *' each indicate a binding site to an adjacent atom, and
each of two groups of R₁ in the number of a1, two groups of R₂ in the number of a2, two groups of R₃ in the number of a3, two groups of R₄ in the number of a4, R₅ₐ and R_{5b}, R₆ₐ and R_{6b}, and R₇ₐ and R_{7b}, may optionally be bonded to each other via a single bond, a double bond, or a first linking group to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ may be:
   deuterium, -F, -Cl, -Br, -I, a hydroxyl group, a cyano group, or a nitro group;
   a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
   a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), wherein
   Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In embodiments, in Formula 10,
X₁ and X₃ may each be C, and X₂ and X₄ may each be N,
X₁ and X₄ may each be C, and X₂ and X₃ may each be N, or
X₁, X₂, and X₃ may each be C, and X₄ may be N.

In embodiments, in Formula 10,
T₁₁ may be O or S, and
T₁₂ to T₁₄ may each be a chemical bond.

In embodiments, in Formula 10,
T₁₁ may be O or S, and
T₁₂ to T₁₄ may each be a chemical bond, and
a bond between T₁₁ and M and a bond between X₃ and M may each be a covalent bond, and a bond between X₂ and M and a bond between X₄ and M may each be a coordinate bond; or a bond between T₁₁ and M and a bond between X₄ and M may each be a covalent bond, and a bond between X₂ and M and a bond between X₃ and M may each be a coordinate bond.

In an embodiment, in Formula 10, T₁ to T₃ may each be a single bond.

In an embodiment, in Formula 10, ring CY₁ may be a benzene group, a naphthalene group, a dibenzofuran group, a dibenzothiophene group, a carbazole group, a fluorene group, or a dibenzosilole group.

In an embodiment, in Formula 10, ring CY₂ may be an imidazole group, a benzimidazole group, a naphthoimidazole group, a pyridine group, a pyrimidine group, a pyrazine group, a pyridazine group, a quinoline group, an isoquinoline group, or a quinoxaline group.

In an embodiment, in Formula 10, ring CY₃ may be a benzene group, a naphthalene group, a dibenzofuran group, a dibenzothiophene group, a carbazole group, a fluorene group, a dibenzosilole group, a pyridine group, a pyrimidine group, a pyrazine group, a pyridazine group, a quinoline group, an isoquinoline group, a quinoxaline group, an azadibenzofuran group, an azadibenzothiophene group, an azacarbazole group, an azafluorene group, or an azadibenzosilole group.

In an embodiment, in Formula 10, ring CY₄ may be a benzene group, a naphthalene group, a dibenzofuran group, a dibenzothiophene group, a carbazole group, a fluorene group, a dibenzosilole group, a pyridine group, a pyrimidine group, a pyrazine group, a pyridazine group, a quinoline group, an isoquinoline group, a quinoxaline group, an azadibenzofuran group, an azadibenzothiophene group, an azacarbazole group, an azafluorene group, an azadibenzosilole group, an imidazole group, a benzimidazole group, or a naphthoimidazole group.

In an embodiment, in Formula 10, at least one of ring CY₂ and ring CY₄ may each independently be an imidazole group, a benzimidazole group, or a naphthoimidazole group.

In an embodiment, in Formula 10, R₁ to R₇, R₅ₐ, R_{5b}, R₆ₐ, R_{6b}, R₇ₐ, R_{7b}, R', and R" may each independently be:
hydrogen, deuterium, -F, or a cyano group;
a C₁-C₂₀ alkyl group or a C₃-C₁₀ cycloalkyl group, each unsubstituted or substituted with deuterium, -F, cyano group, or any combination thereof; or
a phenyl group, a biphenyl group, a naphthyl group, a dibenzofuranyl group, or a dibenzothiophenyl group (or a thienyl group), each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

In Formula 10, a1 to a4 may respectively indicate the number of R₁, the number of R₂, the number of R₃, and the number of R₄, and a1 to a4 may each independently be 0, 1, 2, 3, 4, 5, or 6.

In embodiments, in Formula 10, a moiety represented by 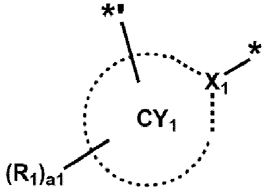 may be a moiety represented by one of CY₁ (1) to CY₁ (16):

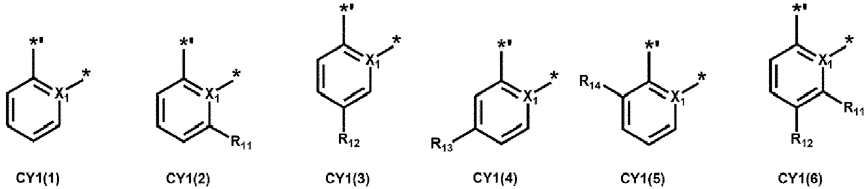

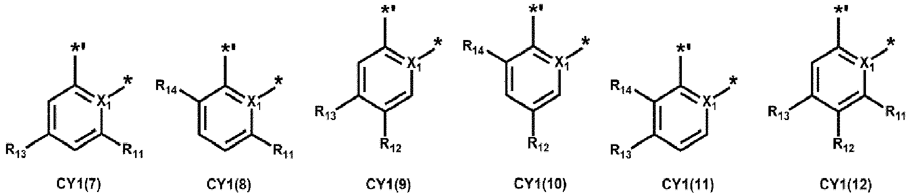

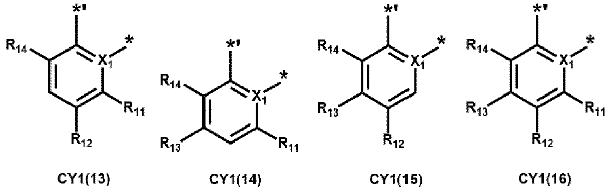

In Formulae CY₁ (1) to CY₁ (16),
X₁ may be the same as described above,
R₁₁ to R₁₄ may each independently the same as described in connection with R₁ in the specification, except that R₁₁ to R₁₄ may each not be hydrogen,
the symbol * may indicate a binding site to T₁₁ in Formula 10, and
the symbol *' may indicate a binding site to T₁ in Formula 10.

In embodiments, in Formula 10, a moiety represented by 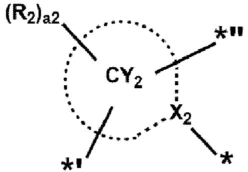 may be a moiety represented by one of CY2(1) to CY2(21):

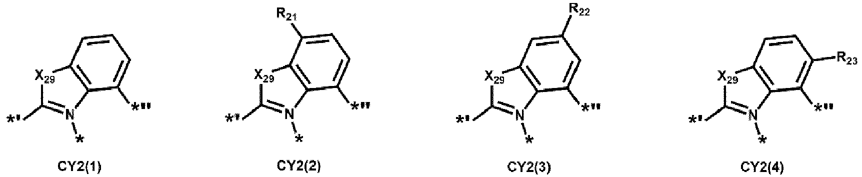

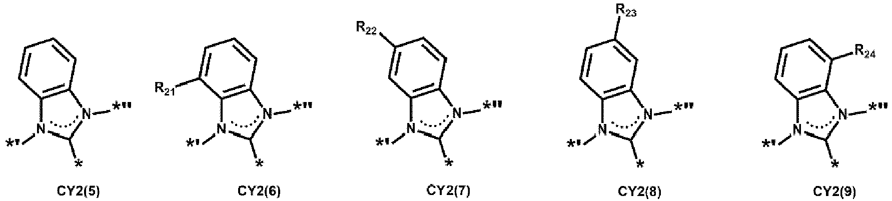

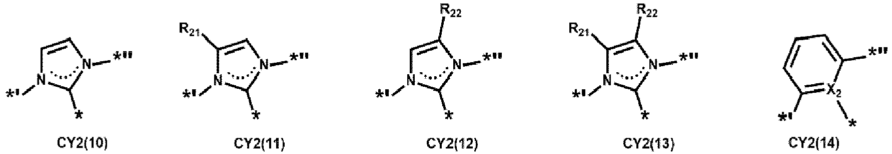

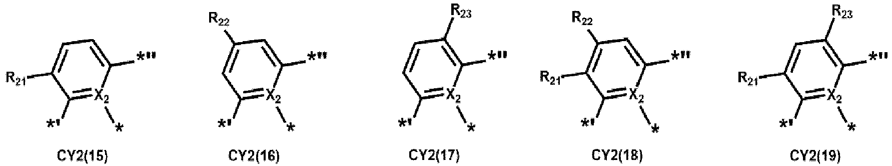

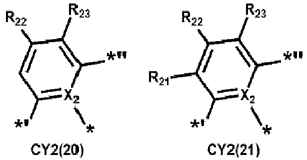

In Formulae CY2(1) to CY2(21),
X₂ may be the same as described in the specification,
X₂₉ may be O, S, N(R₂₉), C(R₂₉ₐ)(R_{29b}), or Si(R₂₉ₐ)(R_{29b}),
R₂₁ to R₂₄, R₂₉, R₂₉ₐ, and R_{29b} may each independently be the same as described in connection with R₂ in the specification, except that R₂₁ to R₂₄ may each not be hydrogen,
* indicates a binding site to T₁₂ in Formula 10,
*' indicates a binding site to T₁ in Formula 10, and
*" indicates a binding site to T₂ in Formula 1.

Formulae CY2(1) to CY2(4) are embodiments of a moiety represented by 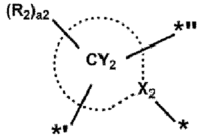 wherein X₂ is nitrogen, and Formulae CY2(5) to CY2(13) are embodiments of a moiety represented by 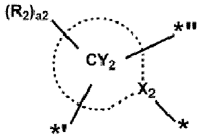 wherein X₂ is carbon (for example, a carbon of a carbene moiety).

In embodiments, in Formula 10, a moiety represented by 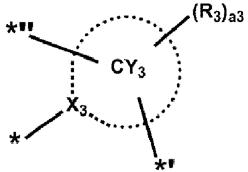 may be a moiety represented by one of CY3(1) to CY3(12):

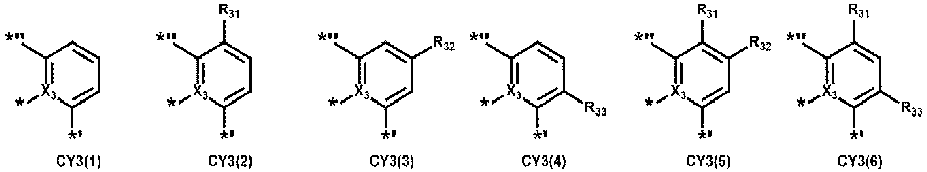

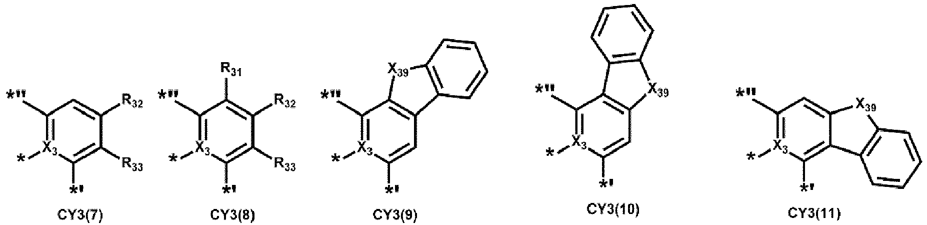

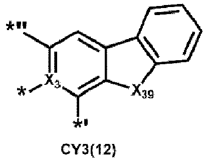

In Formulae CY3(1) to CY3(12),
X₃ may be the same as described in the specification,
X₃₉ may be O, S, N(R₃₉), C(R₃₉ₐ)(R_{39b}), or Si(R₃₉ₐ)(R_{39b}),
R₃₁ to R₃₃, R₃₉, R₃₉ₐ, and R_{39b} may each independently be the same as described in connection with R₃ in the specification, except that R₃₁ to R₃₃ may each not be hydrogen,
* indicates a binding site toT₁₃ in Formula 10,
*' indicates a binding site to T₃ in Formula 10, and
*" indicates a binding site to T₂ in Formula 10.

In embodiments, in Formula 10, a moiety represented by 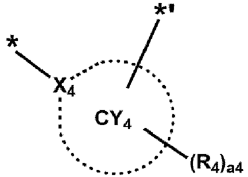 may be a moiety represented by one of CY4(1) to CY4(27):

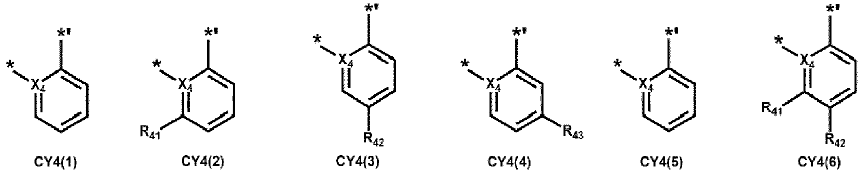

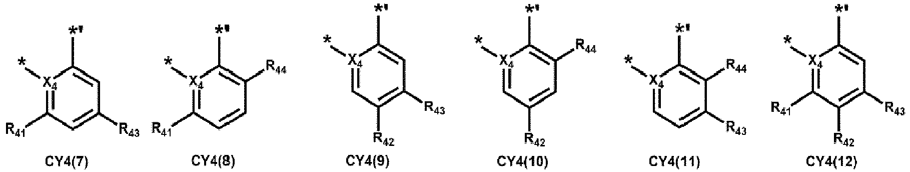

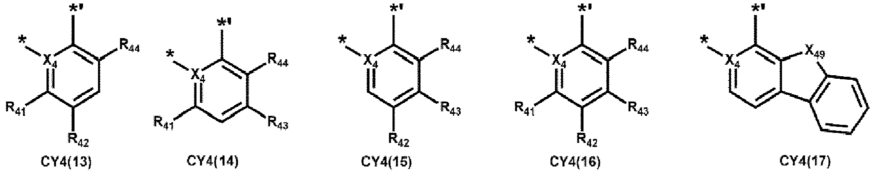

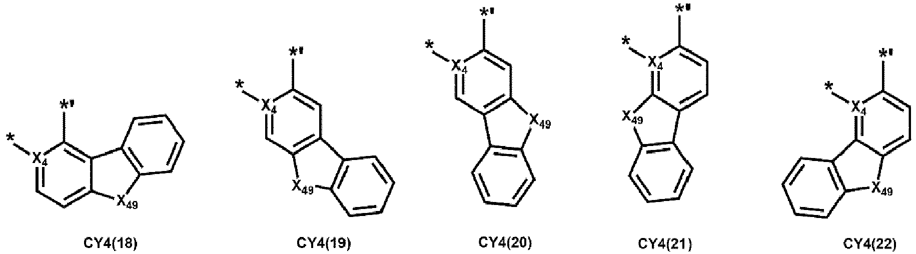

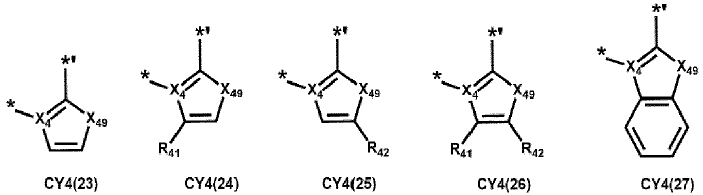

In Formulae CY4(1) to CY4(27),
X₄ may be the same as described in the specification,
X₄₉ may be O, S, N(R₄₉), C(R₄₉ₐ)(R_{49b}), or Si(R₄₉ₐ)(R_{49b}),
R₄₁ to R₄₄, R₄₉, R₄₉ₐ and R_{49b} may each independently be the same as described in connection with R₄, except that R₄₁ to R₄₄ may each not be hydrogen,
* indicates a binding site to T₁₄ in Formula 10, and
*' indicates a binding site to T₃ in Formula 10.

In an embodiment, the iridium-containing organometallic compound may be an organometallic compound represented by Formula 1:

[Formula 1] Ir(L₁)(L₂)(L₃)

In Formula 1,
L₁ may be a first ligand which is bonded to Ir, and may be represented by Formula 1-1,
L₂ may be a second ligand which is bonded to Ir, and may be represented by Formula 1-2, and
L₃ may be a third ligand which is bonded to Ir, and may be represented by Formula 1-3:

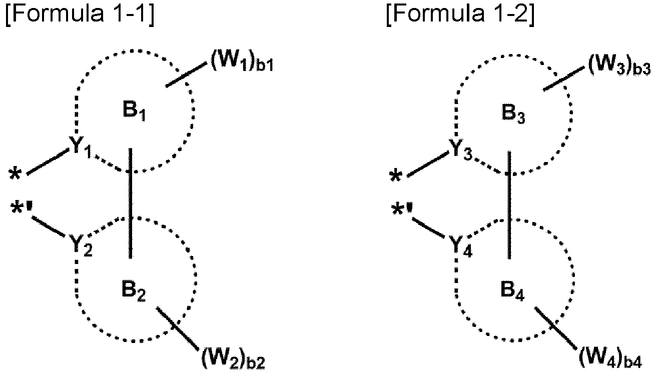

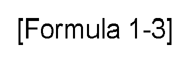

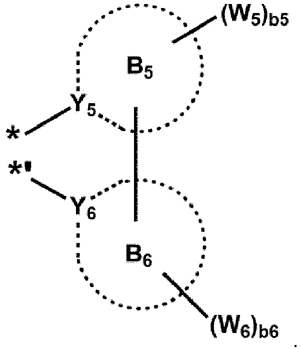

In Formulae 1-1 to 1-3,
each of Y₁, Y₃, and Y₅ may be nitrogen (N),
each of Y₂, Y₄, and Y₆ may be carbon (C),
ring B₁ to ring B₆ may each independently be a C₃-C₆₀ carbocyclic group or a C₁-C₆₀ heterocyclic group,
W₁ to W₆ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
b1 to b6 may each independently be an integer from 0 to 20,
* and *' in Formulae 1-1 to 1-3 each indicate a binding site to Ir in Formula 1,
two groups of W₁ in the number of b1, two groups of W₂ in the number of b2, two groups of W₃ in the number of b3, two groups of W₄ in the number of b4, two groups of W₅ in the number of b5, and two groups of W₆ in the number of b6 may each optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ may be the same as described herein.

In an embodiment, the organometallic compound represented by Formula 1 may be a heteroleptic complex.

In embodiments, in Formula 1,
L₃ may be identical to L₂,
L₃ may be identical to L₁,
L₃ may be different from each of L₁ and L₂, or
L₁, L₂, and L₃ may all be identical to each other.

In an embodiment, ring B₁, ring B₃, and ring B₅ may each independently be:
a pyridine group, a pyrimidine group, a pyrazine group, a pyridazine group, or a triazine group; or
a pyridine group, a pyrimidine group, a pyrazine group, a pyridazine group, or a triazine group, to which a cyclopentane group, a cyclohexane group, a norbornane group, a benzene group, a pyridine group, a pyrimidine group, a pyrazine group, a pyridazine group, a triazine group, a furan group, a thiophene group, a selenophene group, a pyrrole group, a cyclopentadiene group, a silole group, or any combination thereof is condensed. In an embodiment, ring B₁, ring B₃, and ring B₅ may each be a pyridine group.

In an embodiment, ring B₂, ring B₄, and ring B₆ may each independently be:
a benzene group, a pyridine group, a pyrimidine group, a pyrazine group, or a pyridazine group; or
a benzene group, a pyridine group, a pyrimidine group, a pyrazine group, or a pyridazine group, to which a cyclopentane group, a cyclohexane group, a norbornane group, a benzene group, a pyridine group, a pyrimidine group, a pyrazine group, a pyridazine group, a furan group, a thiophene group, a selenophene group, a pyrrole group, a cyclopentadiene group, a silole group, or any combination thereof is condensed.

In an embodiment, ring B₂ may be a benzene group, a pyridine group, a pyrimidine group, a pyrazine group, or a pyridazine group, to which a cyclopentane group, a cyclohexane group, a norbornane group, a benzene group, a pyridine group, a pyrimidine group, a pyrazine group, a pyridazine group, a furan group, a thiophene group, a selenophene group, a pyrrole group, a cyclopentadiene group, a silole group, or any combination thereof is condensed.

In an embodiment, ring B₂ may be a polycyclic group in which one of a furan group, a thiophene group, a selenophene group, a pyrrole group, a cyclopentadiene group, and a silole group is condensed with at least two of a benzene group, a pyridine group, a pyrimidine group, a pyrazine group, and a pyridazine group.

In an embodiment, ring B₂ may be a dibenzofuran group, a dibenzothiophene group, a dibenzoselenophene group, a carbazole group, a fluorene group, a dibenzosilole group, a naphthobenzofuran group, a naphthobenzothiophene group, a naphthobenzoselenophene group, a benzocarbazole group, a benzofluorene group, a benzodibenzosilole group, a dinaphthofuran group, a dinaphthothiophene group, a dinaphthoselenophene group, a dibenzocarbazole group, a dibenzofluorene group, a dinaphthosilole group, a phenanthrenonbenzofuran group, a phenanthrenonbenzothiophene group, a phenanthrenobenzoselenophene group, a naphthocarbazole group, a naphthofluorene group, a phenanthrenobenzosilole group, an azadibenzofuran group, an azadibenzothiophene group, an azadibenzoselenophene group, an azacarbazole group, an azafluorene group, an azadibenzosilole group, an azanaphthobenzofuran group, an azanaphthobenzothiophene group, an azanaphthobenzoselenophene group, an azabenzocarbazole group, an azabenzofluorene group, an azabenzodibenzosilole group, an azadinaphthofuran group, an azadinaphthothiophene group, an azadinaphthoselenophene group, an azadibenzocarbazole group, an azadibenzofluorene group, an azadinaphthosilole group, an azaphenanthrenonbenzofuran group, an azaphenanthrenonbenzothiophene group, an azaphenanthrenobenzoselenophene group, an azanaphthocarbazole group, an azanaphthofluorene group, or an azaphenanthrenobenzosilole group.

In an embodiment, ring B₂ may be a dibenzofuran group, a dibenzothiophene group, a dibenzoselenophene group, a naphthobenzofuran group, a naphthobenzothiophene group, a naphthobenzoselenophene group, a dinaphthofuran group, a dinaphthothiophene group, a dinaphthoselenophene group, a phenanthrenonbenzofuran group, a phenanthrenonbenzothiophene group, a phenanthrenonbenzoselenophene group, an azadibenzofuran group, an azadibenzothiophene group, an azadibenzoselenophene group, an azanaphthobenzofuran group, an azanaphthobenzothiophene group, an azanaphthobenzoselenophene group, an azadinaphthofuran group, an azadinaphthothiophene group, an azadinaphthoselenophene group, an azaphenanthrenonbenzofuran group, an azaphenanthrenonbenzothiophene group, or an azaphenanthrenonbenzoselenophene group.

In an embodiment, ring B₄ may be a benzene group, a naphthalene group, a phenanthrene group, an anthracene group, a pyridine group, a pyrimidine group, a pyrazine group, or a pyridazine group.

In an embodiment, ring B₆ may be a benzene group, a naphthalene group, a phenanthrene group, an anthracene group, a pyridine group, a pyrimidine group, a pyrazine group, a pyridazine group, a dibenzofuran group, a dibenzothiophene group, a dibenzoselenophene group, a carbazole group, a fluorene group, a dibenzosilole group, a naphthobenzofuran group, a naphthobenzothiophene group, a naphthobenzoselenophene group, a benzocarbazole group, a benzofluorene group, a benzodibenzosilole group, a dinaphthofuran group, a dinaphthothiophene group, a dinaphthoselenophene group, a benzocarbazole group, a dibenzofluorene group, a dinaphthosilole group, a phenanthrenobenzofuran group, a phenanthrenobenzothiophene group, a phenanthrenobenzoselenophene group, a naphthocarbazole group, a naphthofluorene group, a phenanthrenobenzosilole group, an azadibenzofuran group, an azadibenzothiophene group, an azadibenzoselenophene group, an azacarbazole group, an azafluorene group, an azadibenzosilole group, an azanaphthobenzofuran group, an azanaphthobenzothiophene group, an azanaphthobenzoselenophene group, an azabenzocarbazole group, an azabenzofluorene group, an azabenzodibenzosilole group, an azadinaphthofuran group, an azadinaphthothiophene group, an azadinaphtho selenophene group, an azadibenzocarbazole group, an azadibenzofluorene group, an azadinaphthosilole group, an azaphenanthrenobenzofuran group, an azaphenanthrenobenzothiophene group, an azaphenanthrenobenzoselenophene group, an azanaphthocarbazole group, an azanaphthofluorene group, or an phenanthrenobenzosilole group.

In an embodiment, Y₂-containing ring B₂ of Formula 1-1 and Y₄-containing ring B₄ of Formula 1-2 may be different from each other.

In an embodiment, in Formula 1, W₁ to W₆ may each independently be:
hydrogen, deuterium, -F, or a cyano group;
a C₁-C₂₀ alkyl group or a C₃-C₁₀ cycloalkyl group, each unsubstituted or substituted with deuterium, -F, a cyano group, or any combination thereof;
a phenyl group, a biphenyl group, a naphthyl group, a dibenzofuranyl group, or a dibenzothiophenyl group (or a thienyl group), each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof; or
-Si(Q₁)(Q₂)(Q₃).
Q₁ to Q₃ may each be the same as described above.

In an embodiment, at least one of W₁ to W₆ may include at least one deuterium.

In an embodiment, at least one of W₁ to W₆ may be a deuterated C₁-C₂₀ alkyl group, or a deuterated C₃-C₁₀ cycloalkyl group.

The term "biphenyl group" as used herein may be a monovalent substituent having a structure in which two benzene groups are connected to each other through a single bond.

Examples of a C₃-C₁₀ cycloalkyl group as used herein may include a cyclopentyl group, a cyclohexyl group, a cycloheptyl group, an adamantanyl group, a norbornanyl group, and the like.

The term "deuterated" as used herein may be interpreted as fully deuterated or partially deuterated.

The term "fluorinated" as used herein may be interpreted as fully fluorinated or partially fluorinated.

In Formula 1, b1 to b6 may respectively indicate the numbers of W₁ to W₆, and may each independently be 0, 1, 2, 3, or 4. When b1 is 2 or more, two or more of W₁ may be identical to or different from each other, when b2 is 2 or more, two or more of W₂ may be identical to or different from each other, when b3 is 2 or more, two or more of W₃ may be identical to or different from each other, when b4 is 2 or more, two or more of W₄ may be identical to or different from each other, when b5 is 2 or more, two or more of W₅ may be identical to or different from each other, and when b6 is 2 or more, two or more of W₆ may be identical to or different from each other.

In an embodiment, the iridium-containing organometallic compound may be an organometallic compound represented by Formula 1A or an organometallic compound represented by Formula 1B:

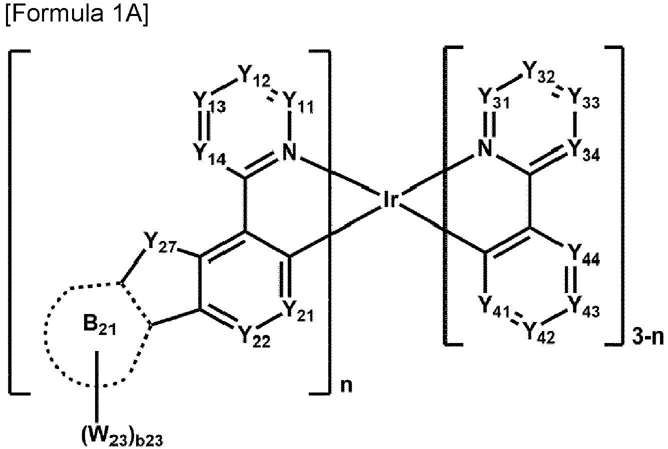

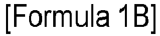

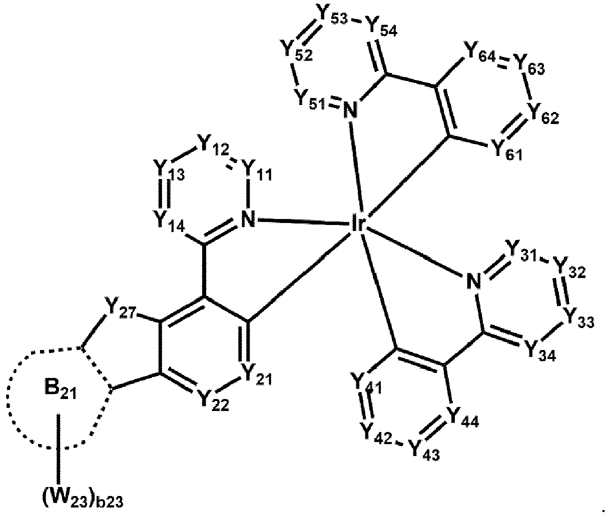

In an embodiment, the iridium-containing organometallic compound may be an organometallic compound represented by Formula 1A-1, or an organometallic compound represented by Formula 1B-1:

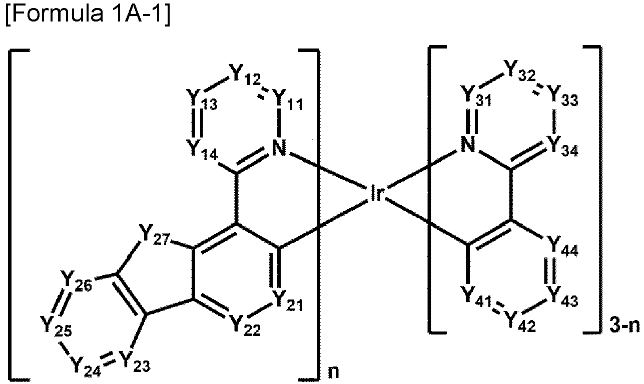

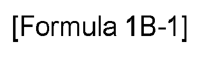

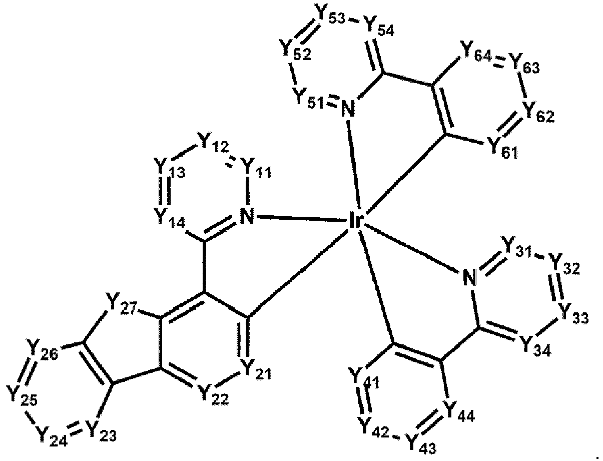

In Formulae 1A, 1B, 1A-1, and 1B-1,
n may be 1 or 2,
ring B₂₁ may be a C₃-C₆₀ carbocyclic group or C₁-C₆₀ heterocyclic group,
Y₁₁ may be C(W₁₁) or N, Y₁₂ may be C(W₁₂) or N, Y₁₃ may be C(W₁₃) or N, Y₁₄ may be C(W₁₄) or N, Y₂₁ may be C(W₂₁) or N, Y₂₂ may be C(W₂₂) or N, Y₂₃ may be C(W₂₃) or N, Y₂₄ may be C(W₂₄) or N, Y₂₅ may be C(W₂₅) or N, Y₂₆ may be C(W₂₆) or N, Y₃₁ may be C(W₃₁) or N, Y₃₂ may be C(W₃₂) or N, Y₃₃ may be C(W₃₃) or N, Y₃₄ may be C(W₃₄) or N, Y₄₁ may be C(W₄₁) or N, Y₄₂ may be C(W₄₂) or N, Y₄₃ may be C(W₄₃) or N, Y₄₄ may be C(W₄₄) or N, Y₅₁ may be C(W₅₁) or N, Y₅₂ may be C(W₅₂) or N, Y₅₃ may be C(W₅₃) or N, Y₅₄ may be C(W₅₄) or N, Y₆₁ may be C(W₆₁) or N, Y₆₂ may be C(W₆₂) or N, Y₆₃ may be C(W₆₃) or N, or Y₆₄ may be C(W₆₄) or N,
Y₂₇ may be O, S, Se, N(W₂₇), C(W₂₇ₐ)(W_{27b}), or C(W₂₇ₐ)(W_{27b}),
W₁₁ to W₁₄ may each independently be the same as described in connection with W₁,
W₂₁ to W₂₇, W₂₇ₐ, and W_{27b} may each independently be the same as described in connection with W₂,
b23 may be an integer from 0 to 20,
W₃₁ to W₃₄ may each independently be the same as described in connection with W₃,
W₄₁ to W₄₄ may each independently be the same as described in connection with W₄,
W₅₁ to W₅₄ may each independently be the same as described in connection with W₅,
W₆₁ to W₆₄ may each independently be the same as described in connection with We,
two or more of W₁₁ to W₁₄ may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
two or more of W₂₁ to W₂₇, and W₂₇ₐ and W_{27b} may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
two or more of W₃₁ to W₃₄ may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
two or more of W₄₁ to W₄₄ may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
two or more of W₅₁ to W₅₄ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and
two or more of W₆₁ to W₆₄ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

Since n in Formula 1A and 1A-1 is 1 or 2, Formulae 1A and 1A-1 may correspond to an organometallic compound in which the third ligand in Formula 1 is the same as the second ligand or the first ligand.

The organometallic compound represented by Formula 1B or Formula 1B-1 may be an organometallic compound having three different bidentate ligands, and may correspond to a compound represented by Formula 1 in which the third ligand is different from each of the first ligand and the second ligand.

In an embodiment, ring B₂₁ in Formulae 1A and 1B may be a benzene group, a naphthalene group, a phenanthrene group, an anthracene group, a pyridine group, a pyrimidine group, a pyrazine group, a pyridazine group, a quinoline group, an isoquinoline group, a quinoxaline group, a quinazoline group, a benzoquinoline group, a benzoisoquinoline group, a benzoquinoxaline group, or a benzoquinazoline group.

According to another embodiment, ring B₂₁ in Formulae 1A and 1B may be a pyridine group, a pyrimidine group, a pyrazine group, a pyridazine group, a quinoline group, an isoquinoline group, a quinoxaline group, a quinazoline group, a benzoquinoline group, a benzoisoquinoline group, a benzo quinoxaline group, or a benzoquinazoline group.

In an embodiment, in Formulae 1A-1 and 1B-1, at least one of Y₂₁ to Y₂₆ may be N.

In an embodiment, in Formulae 1A-1 and 1B-1, at least one of Y₂₃ to Y₂₆ may be N.

In an embodiment, Y₂₆ in Formulae 1A-1 and 1B-1 may be N.

In an embodiment, in Formulae 1A-1 and 1B-1, each of Y₂₁ to Y₂₅ may not be N, and Y₂₆ may be N.

In an embodiment, in Formulae 1A, 1B, 1A-1, and 1B-1, each of Y₁₁ to Y₁₄, Y₂₁, Y₂₂, Y₃₁ to Y₃₄ and Y₄₁ to Y₄₄ may not be N.

In an embodiment, a moiety represented by 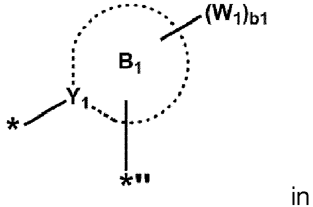 Formula 1-1, a moiety represented by 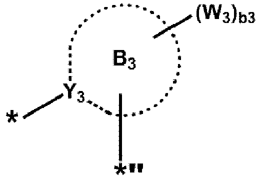 in Formula 1-2, a moiety represented by 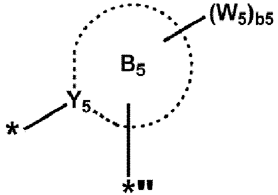 in Formula 1-3, a moiety represented by 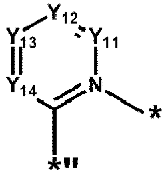 in Formulae 1A, 1B, 1A-1, and 1B-1, a moiety represented by 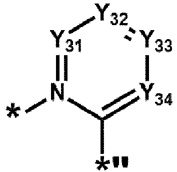 in Formulae 1A, 1B, 1A-1, and 1B-1, and a moiety represented by 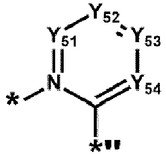 in Formulae 1B and 1B-1 may each independently be represented by one of Formulae BN-1 to BN-16:

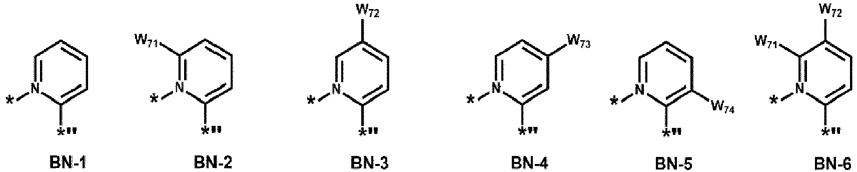

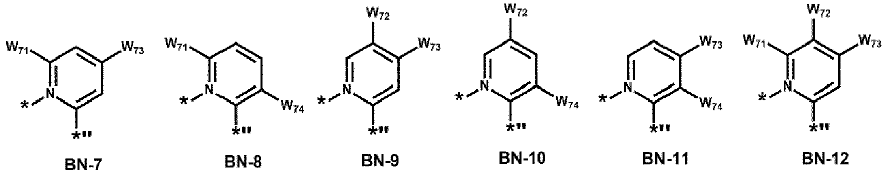

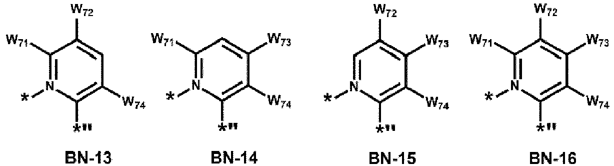

In Formulae BN-1 to BN-16,
W₇₁ to W₇₄ may each independently be the same as described in connection with W₁, W₃, or W₅, except that each of W₇₁ to W₇₄ may each not be hydrogen,
* indicates a binding site to iridium in Formulae 1, 1A, 1B, 1A-1, and 1B-1, and
*" indicates a binding site to a neighboring atom among Formulae 1, 1A, 1B, 1A-1, and 1B-1.

In an embodiment, a moiety represented by 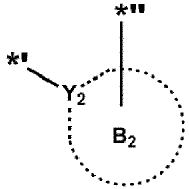 in Formula 1-1, a moiety represented by 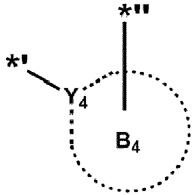 in Formula 1-2, and a moiety represented by 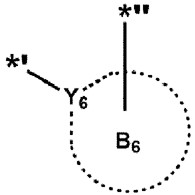 in Formula 1-3 may each independently be a moiety represented by one of Formulae BC-1 to BC-47:

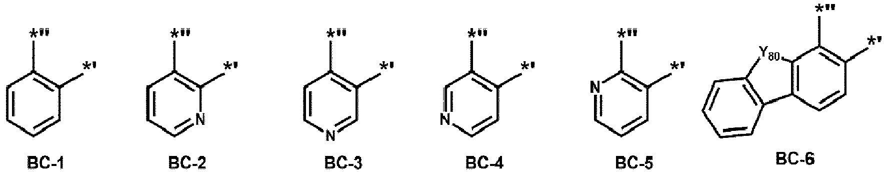

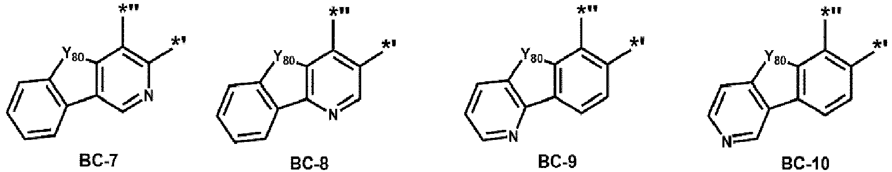

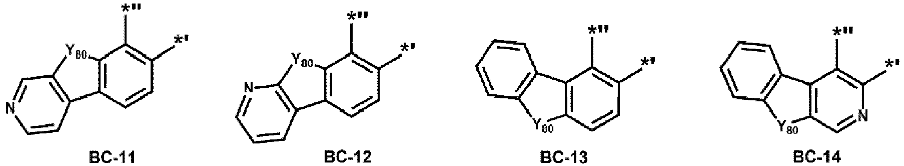

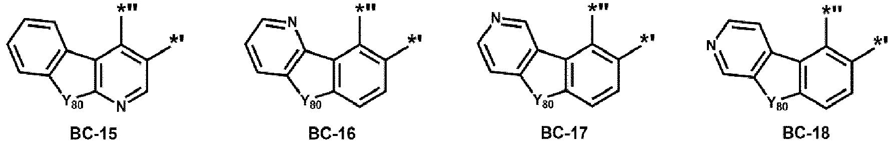

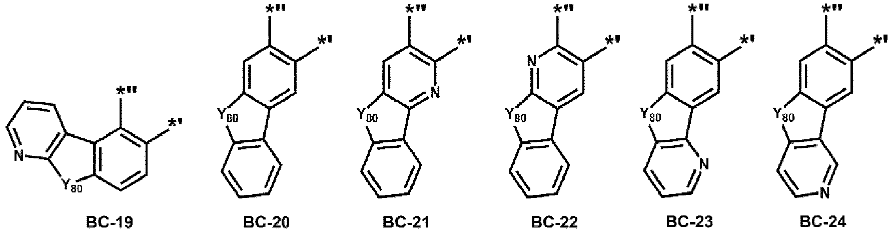

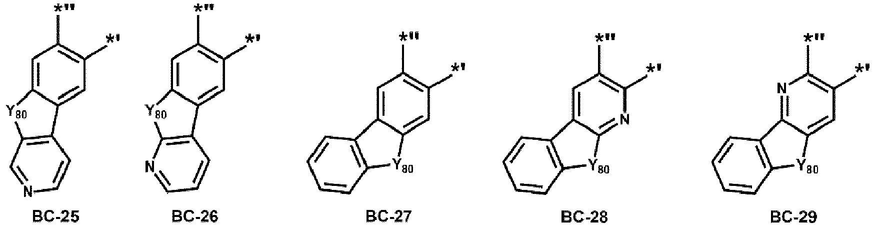

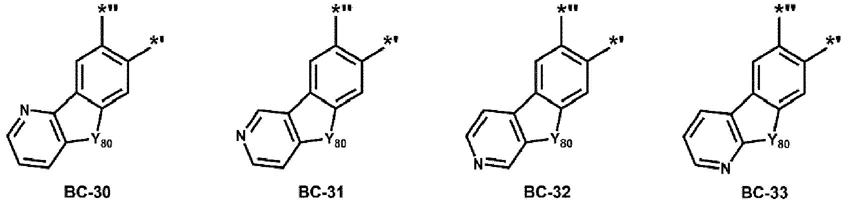

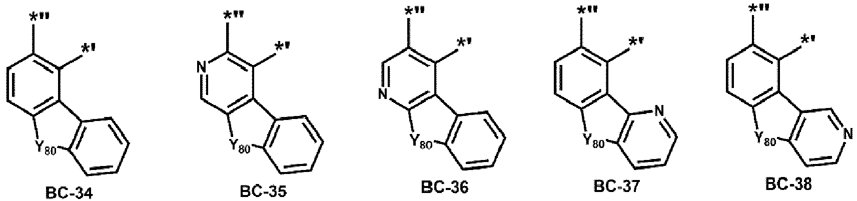

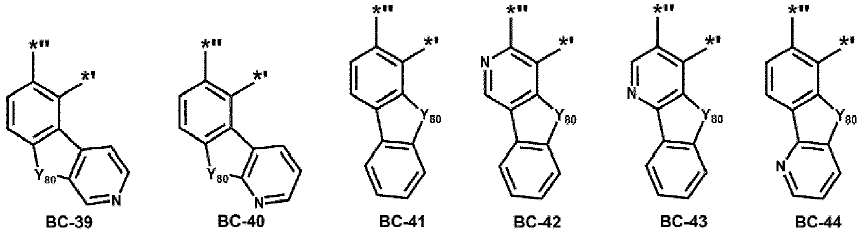

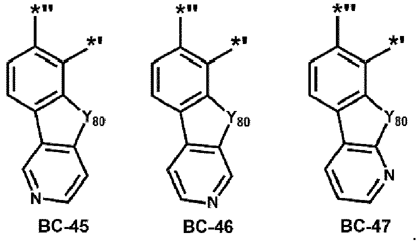

In Formulae BC-1 to BC-47,
Y₈₀ may be O, S, Se, N(W₈₀), C(W₈₀ₐ)(W_{80b}), or Si(W₈₀ₐ)(W_{80b}),
W₈₉, W₈₀ₐ, and W_{80b} may each independently be the same as described in connection with W₂, W₄, or W₆,
*' indicates a binding site to iridium in Formula 1, and
*" indicates a binding site to a neighboring atom in Formula 1.

Formulae BC-1 to BC-47 may be substituted or unsubstituted with W₂, W₄, or W₆ as described above, and may be readily understood with reference to the structures of Formulae 1-1, 1-2, and 1-3.

In an embodiment, a moiety represented by 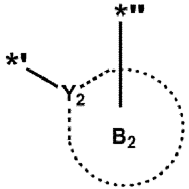 in Formula 1-1 may be a moiety represented by one of Formulae BC-6 to BC-47.

In an embodiment, a moiety represented by 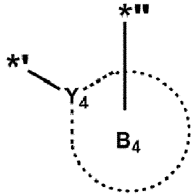 in Formula 1-2 may be a moiety represented by one of Formulae BC-1 to BC-5.

In Formula 2-1, b51 to b53 may respectively indicate numbers of L₅₁ to L₅₃, and may each independently be an integer from 1 to 5. When b51 is 2 or more, two or more of L₅₁ may be identical to or different from each other, when b52 is 2 or more, two or more of L₅₂ may be identical to or different from each other, and when b53 is 2 or more, two or more of L₅₃ may be identical to or different from each other. In an embodiment, b51 to b53 may each independently be 1 or 2.

In Formula 2-1, L₅₁ to L₅₃ may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a oxazole group, a isoxazole group, a thiazole group, an isothiazole group, an oxadiazole group, a thiadiazole group, a benzopyrazole group, a benzimidazole group, a benzoxazole group, a benzothiazole group, a benzooxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxine group, a dibenzooxathiine group, a dibenzooxazine group, a dibenzopyran group, a dibenzodithiine group, a dibenzothiazine group, a dibenzothiopyran group, a dibenzocyclohexadiene group, a dibenzodihydropyridine group, a dibenzodihydropyrazine group, an indolocarbazole group, an indolodibenzofuran group, or an indolodibenzothiophene group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof,
wherein Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In Formula 2-1, X₅₄ may be N or C(R₅₄), X₅₅ may be N or C(R₅₅), X₅₆ may be N or C(R₅₆), and at least two of X₅₄ to X₅₆ may each be N. R₅₄ to R₅₆ are the same as described herein. In an embodiment, two or three of X₅₄ to X₅₆ may be N.

In the specification, R₅₁ to R₅₆, R₇₁ to R₇₆, R₈₁ to R₈₅, R₈₂ₐ, R_{82b}, R₈₃ₐ, R_{83b}, R₈₄ₐ, and R_{84b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ aryl alkyl group unsubstituted or substituted with at least one R₁₀ₐ, a C₂-C₆₀ heteroaryl alkyl group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂). Q₁ to Q₃ and R₁₀ₐ are the same as described in the specification.

For example, R₁ to R₇, R₅ₐ, R_{5b}, R₆ₐ, R_{6b}, R₇ₐ, R_{7b}, R', and R" in Formula 10; W₁ to W₆, W₁₁ to W₁₄, W₂₁ to W₂₇, W₂₇ₐ, W_{27b}, W₃₁ to W₃₄, W₄₁ to W₄₄, W₇₁ to W₇₄, W₈₀, W₈₀ₐ, and W_{80b} in Formulae 1, 1A, 1B, 1A-1, 1B-1, BN-1 to BN-16, and BC-1 to BC-47; R₅₁ to R₅₆, R₇₁ to R₇₆, R₈₁ to R₈₅, R₈₂ₐ, R_{82b}, R₈₃ₐ, R_{83b}, R₈₄ₐ, and R_{84b} in Formulae 2-1 and 3-1 to 3-6; and R₁₀ₐ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂), and
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

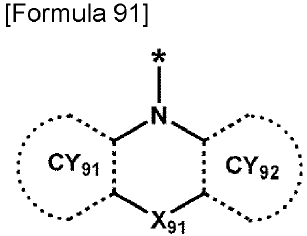

In Formula 91,
ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
X₉₁ may be a single bond, O, S, N(R₉₁), B(R₉₁), C(R₉₁ₐ)(R_{91b}), or Si(R₉₁ₐ)(R_{91b}),
R₉₁, R₉₁ₐ, and R_{91b} may respectively be understood by referring to the descriptions of R₈₂, R₈₂ₐ, and R_{82b} provided herein,
R₁₀ₐ may be understood by referring to the description of R₁₀ₐ provided herein, and
the symbol * may indicate a binding site to an adjacent atom.
In an embodiment, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ,
R₉₁, R₉₁ₐ, and R_{91b} may each independently be:
hydrogen or a C₁-C₁₀ alkyl group; or
a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In an embodiment, R₁ to R₇, R₅ₐ, R_{5b}, R₆ₐ, R_{6b}, R₇ₐ, R_{7b}, R', and R" in Formula 10; W₁ to W₆, W₁₁ to W₁₄, W₂₁ to W₂₇, W₂₇ₐ, W_{27b}, W₃₁ to W₃₄, W₄₁ to W₄₄, W₇₁ to W₇₄, W₈₀, W₈₀ₐ, and W_{80b} in Formulae 1, 1A, 1B, 1A-1, 1B-1, BN-1 to BN-16 and BC-1 to BC-47; R₅₁ to R₅₆, R₇₁ to R₇₆, R₈₁ to R₈₅, R₈₂ₐ, R_{82b}, R₈₃ₐ, R_{83b}, R₈₄ₐ, and R_{84b} in Formulae 2-1 and 3-1 to 3-6; and R₁₀ₐ may each independently be hydrogen, deuterium, -F, a cyano group, a nitro group, -CH₃, -CD₃, -CD₂H, -CDH₂, -CF₃, -CF₂H, -CFH₂, a group represented by one of Formulae 9-1 to 9-19, a group represented by one of Formulae 10-1 to 10-246, -C(Q₁)(Q₂)(Q₃), -Si(Q₁)(Q₂)(Q₃), or -P(=O)(Q₁)(Q₂)(wherein Q₁ to Q₃ are the same as described herein except that each of R₁₀ₐ and W₇₁ to W₇₄ may not be hydrogen).

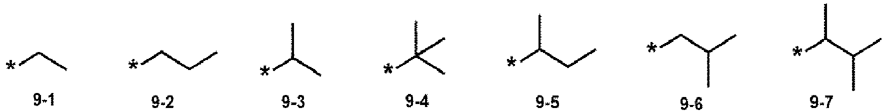

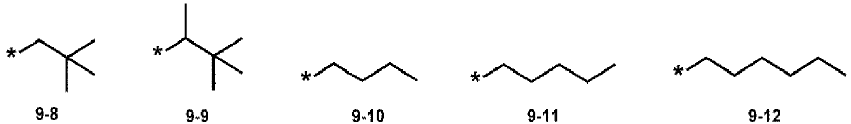

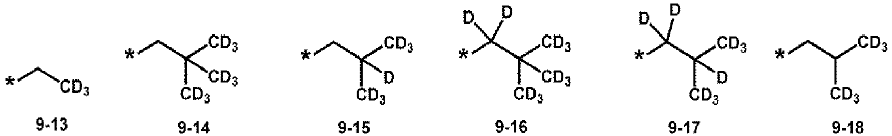

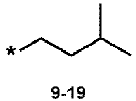

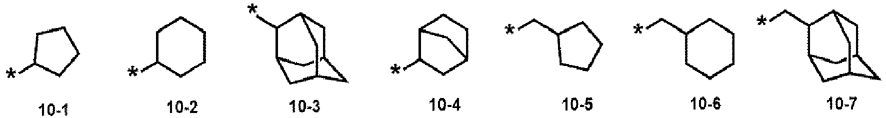

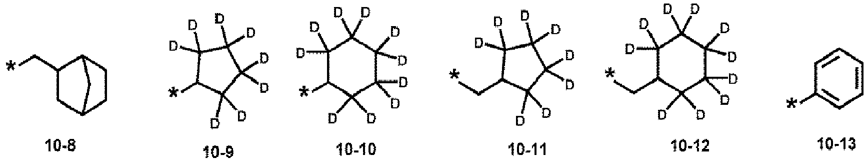

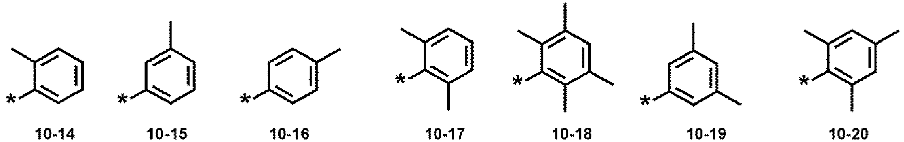

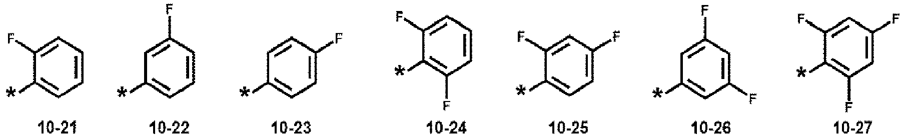

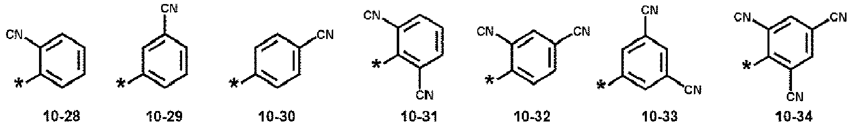

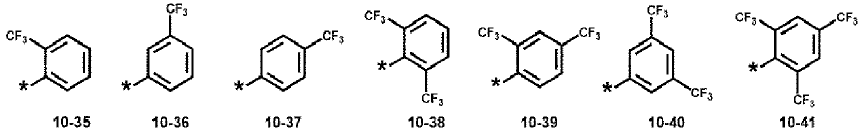

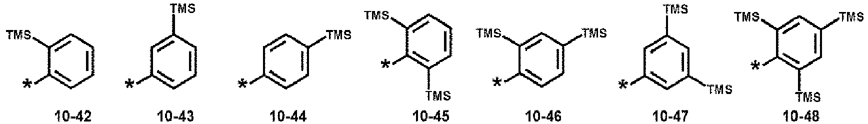

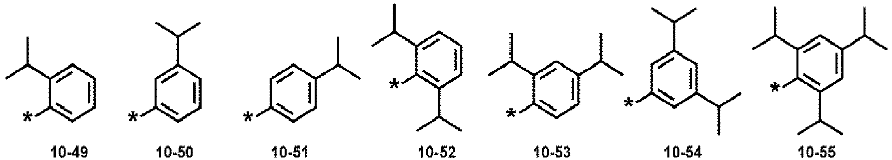

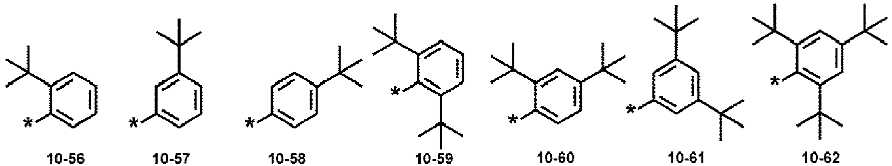

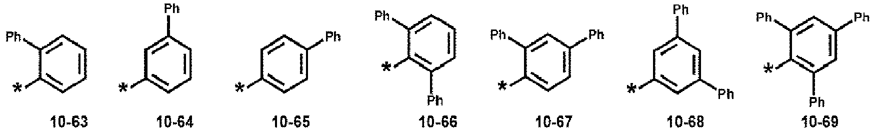

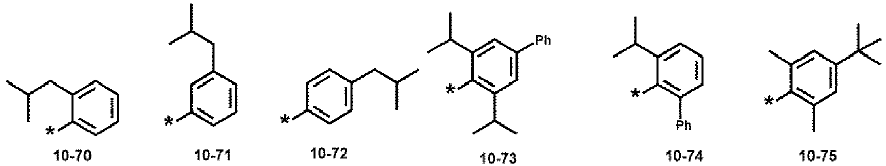

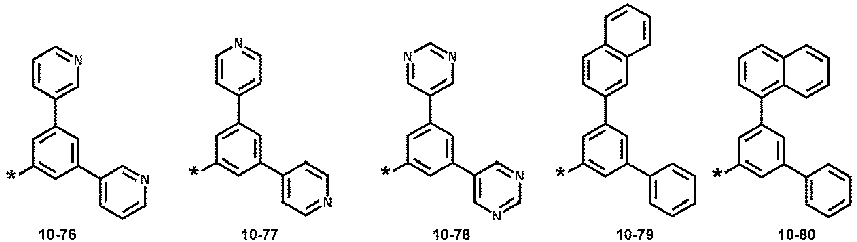

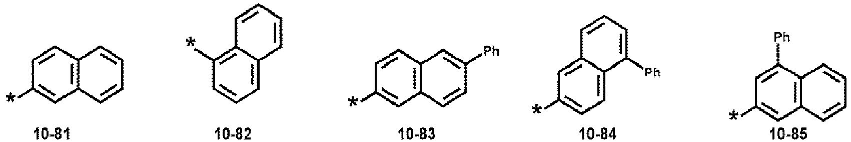

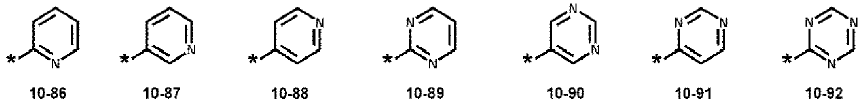

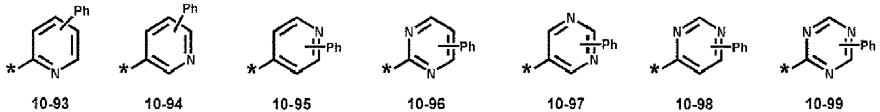

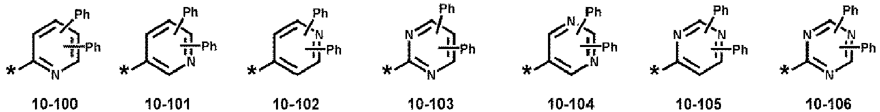

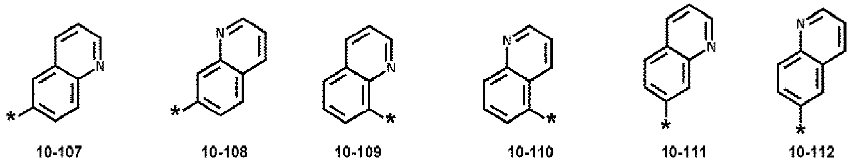

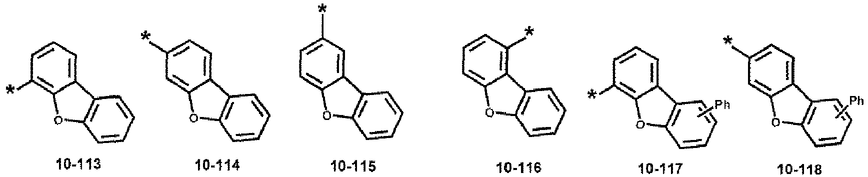

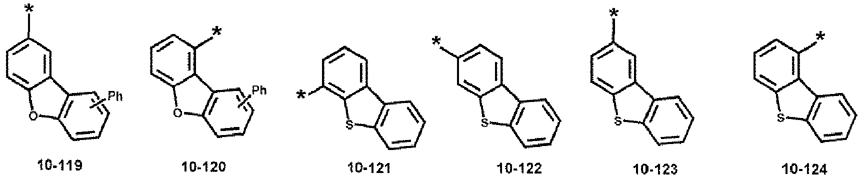

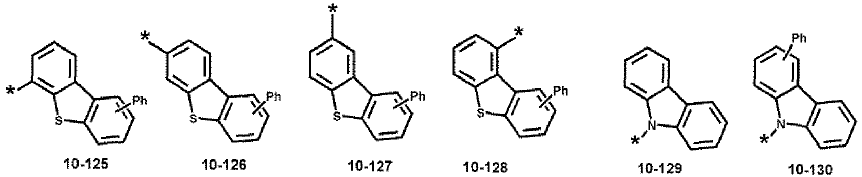

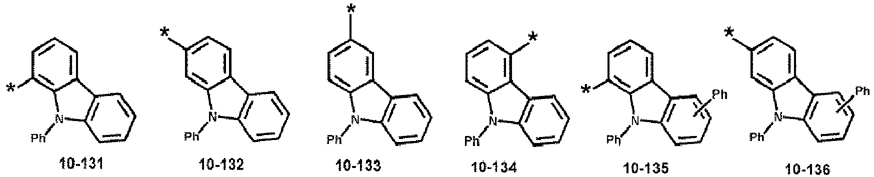

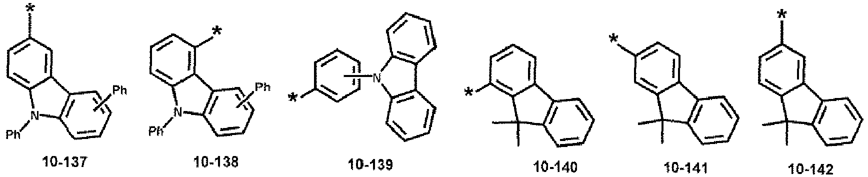

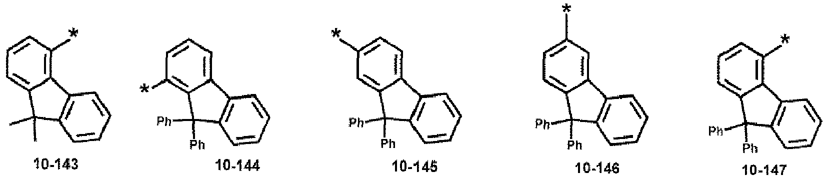

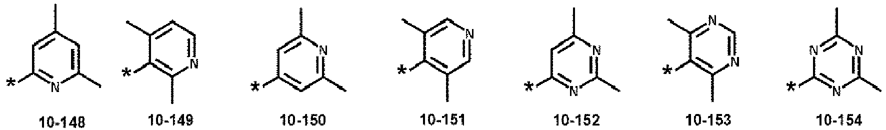

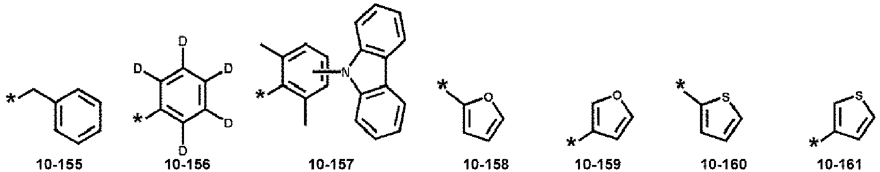

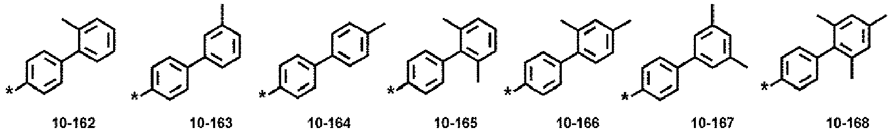

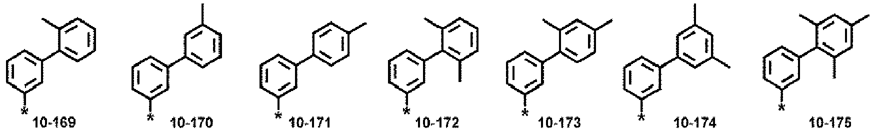

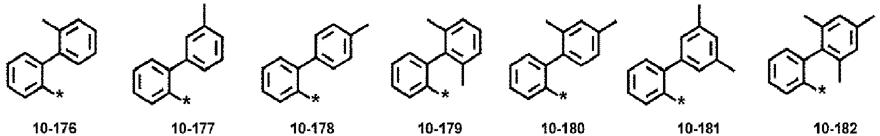

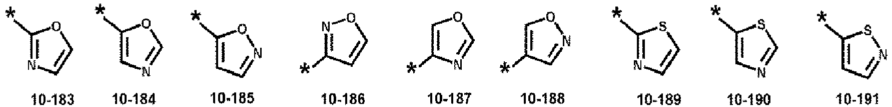

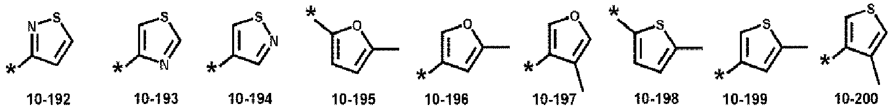

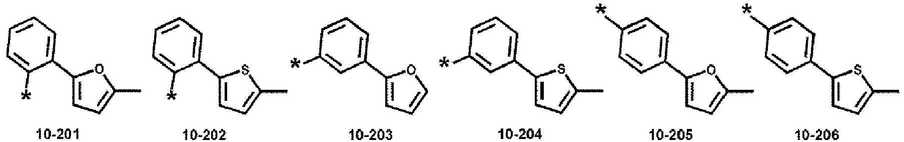

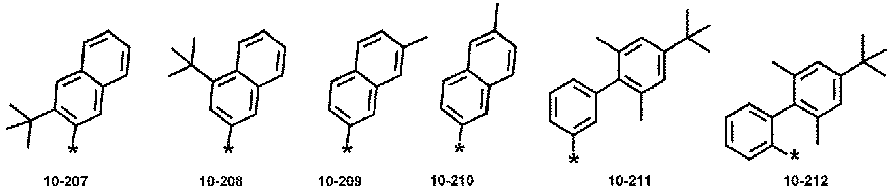

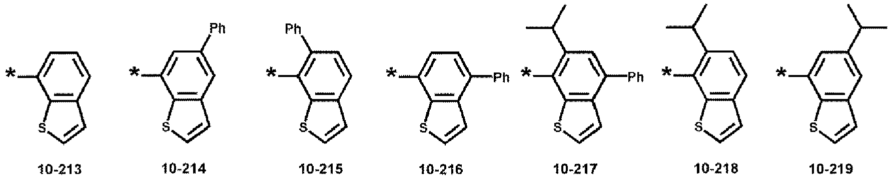

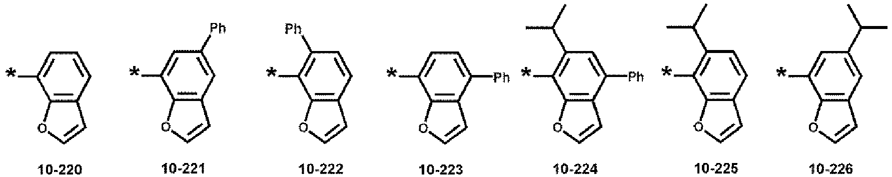

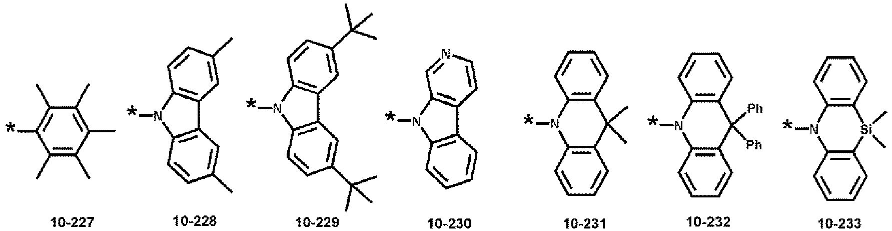

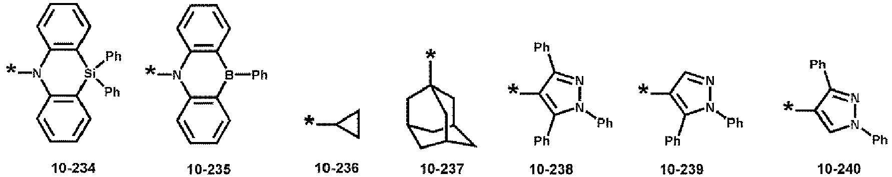

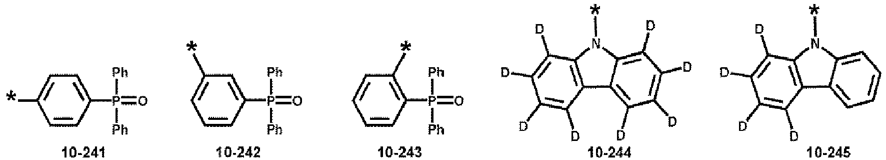

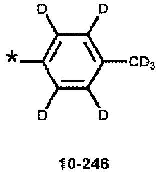

In Formulae 9-1 to 9-19 and 10-1 to 10-246, * indicates a binding site to an adjacent atom, "Ph" represents a phenyl group, and "TMS" represents a trimethylsilyl group.

In Formulae 3-1 to 3-5, a71 to a74 may respectively indicate numbers of R₇₁ to R₇₄, and a71 to a74 may each independently be an integer from 0 to 20. When a71 is 2 or more, two or more of R₇₁ may be identical to or different from each other, when a72 is 2 or more, two or more of R₇₂ may be identical to or different from each other, when a73 is 2 or more, two or more of R₇₃ may be identical to or different from each other, and when a74 is 2 or more, two or more of R₇₄ may be identical to or different from each other. In an embodiment, a71 to a74 may each independently be an integer from 0 to 8. In Formula 3-6, a75 and a76 may respectively indicate the number of R₇₅ and the number of R₇₆, and a75 and a76 may each independently be an integer from 0 to 4.

In Formula 1, two or more of W₁ in the number of b1 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ; two or more of W₂ in the number of b2 may optionally be bonded to each other to form a C₃-C₆₀ carbocyclic group unsubstituted or substituted with at least one R10a or a C₁-C₆₀ heterocyclic group unsubstituted or substituted with at least one R₁₀ₐ; two or more of W₃ in the number of b3 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ; two or more of W₄ in the number of b4 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ; two or more of W₅ in the number of b5 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ; and two or more of W₆ in the number of b6 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

In Formulae 3-1 to 3-6, L₈₁ to L₈₅ may each independently be:
a single bond;
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), or any combination thereof,
wherein Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

### [Examples of compounds]

In an embodiment, the first emitter may be one of Compounds GD01 to GD25:

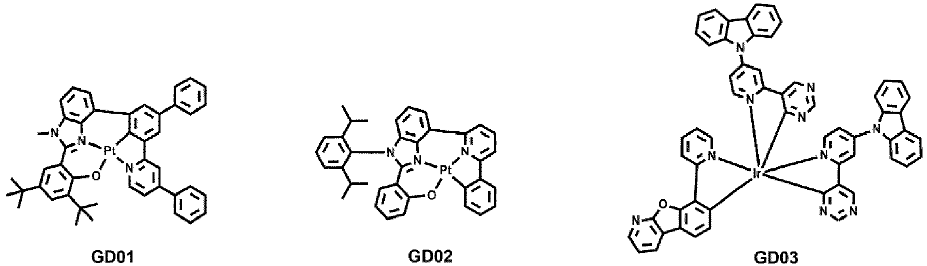

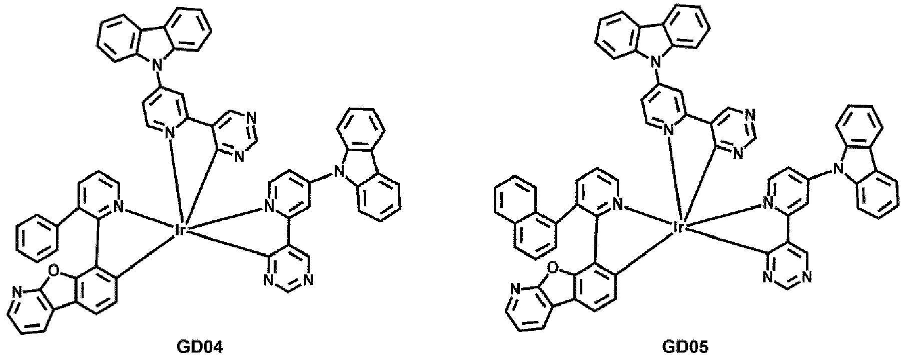

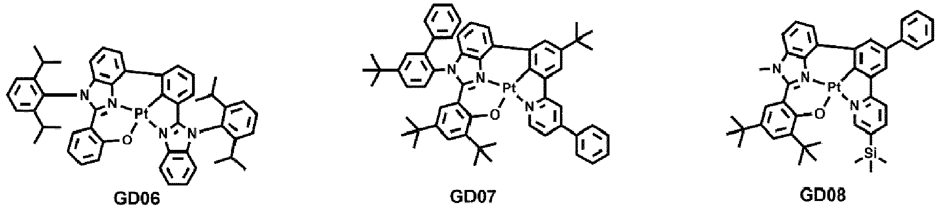

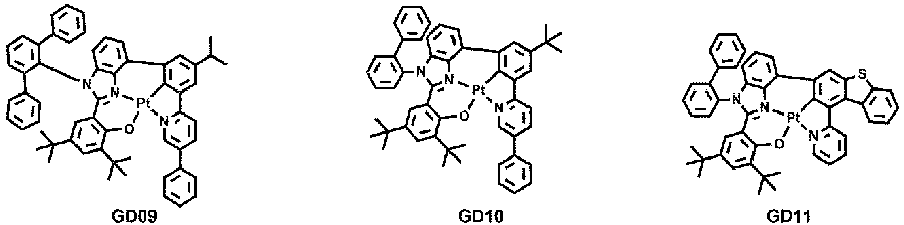

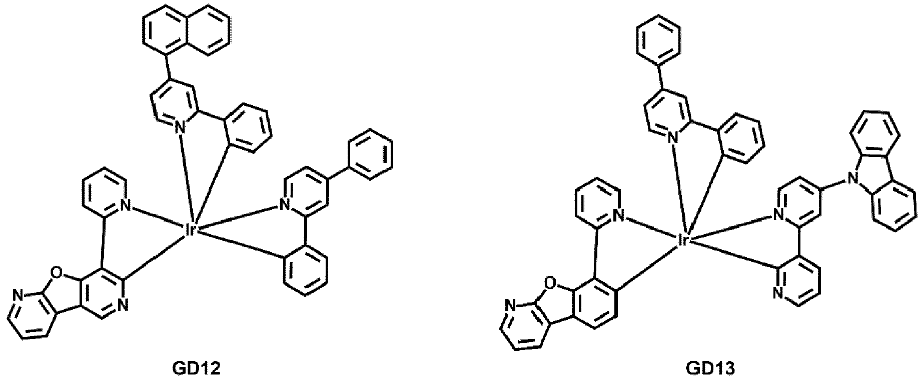

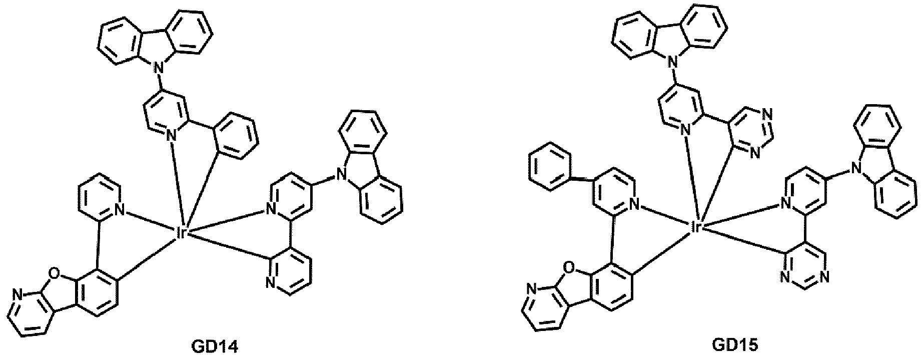

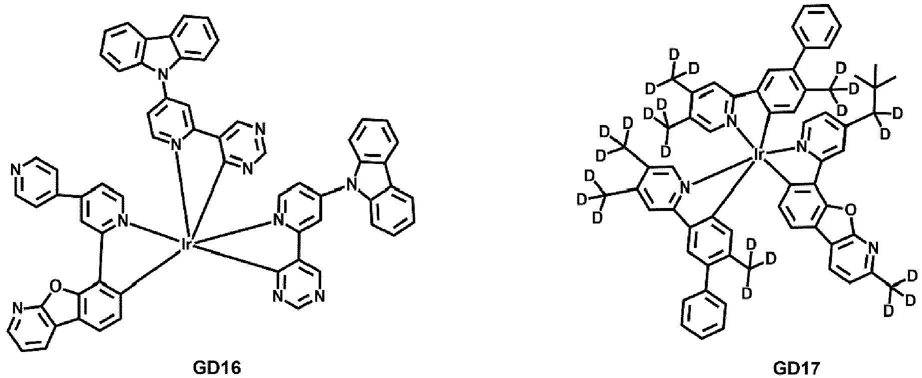

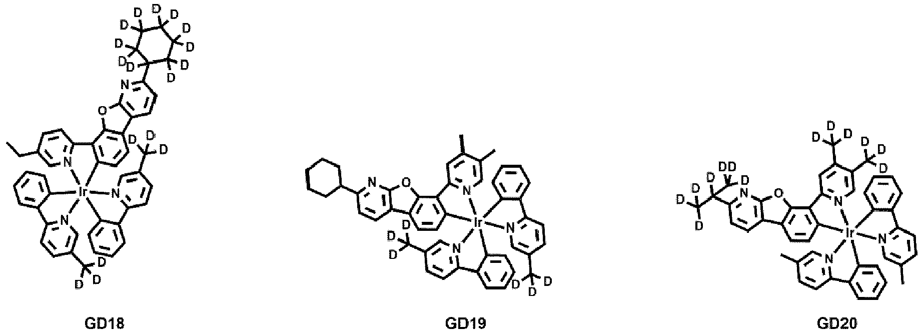

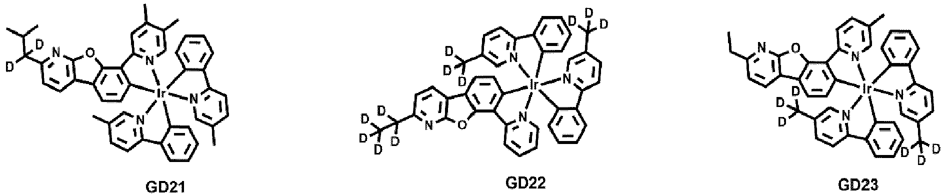

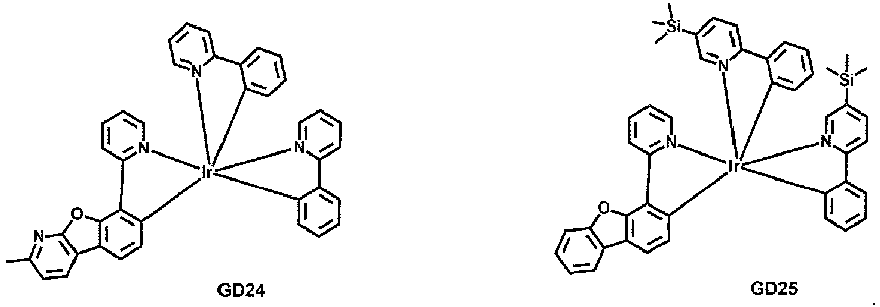

In an embodiment, the first host may be one of Host1 to Host4:

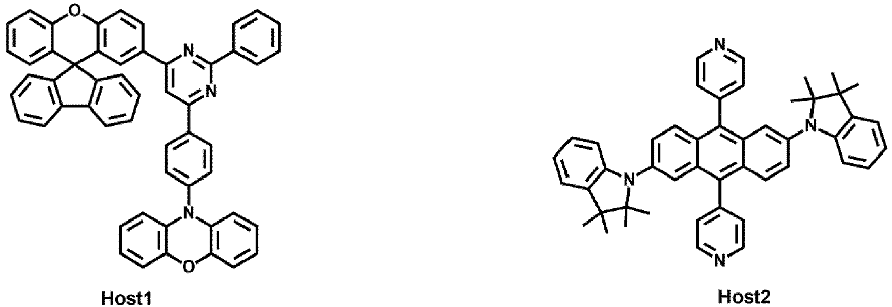

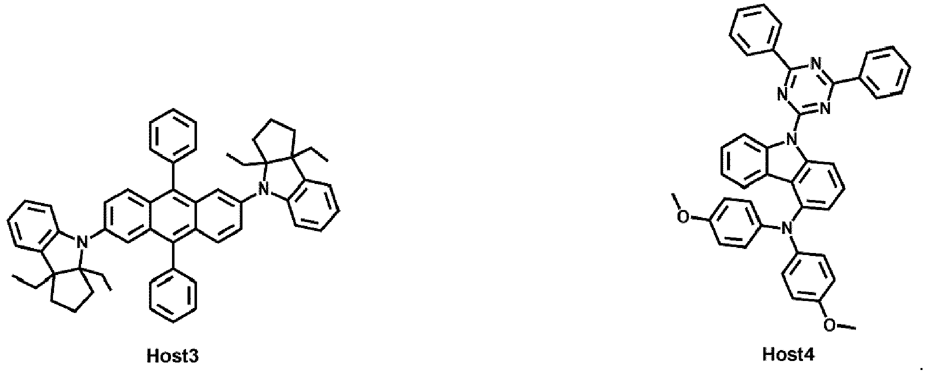

In an embodiment, the first material may be one of Compounds GI01 to GI09:

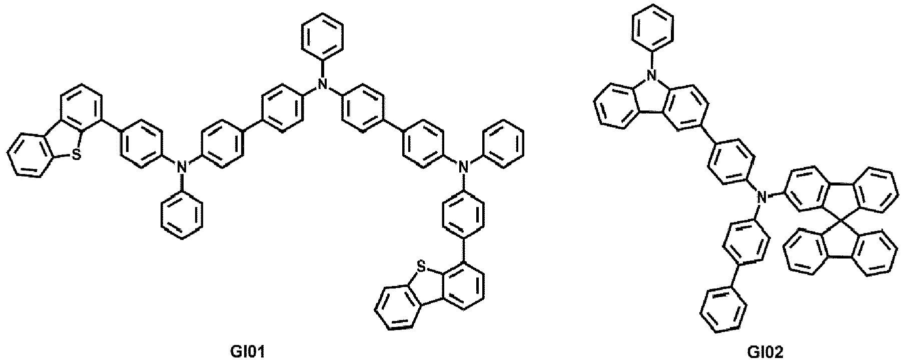

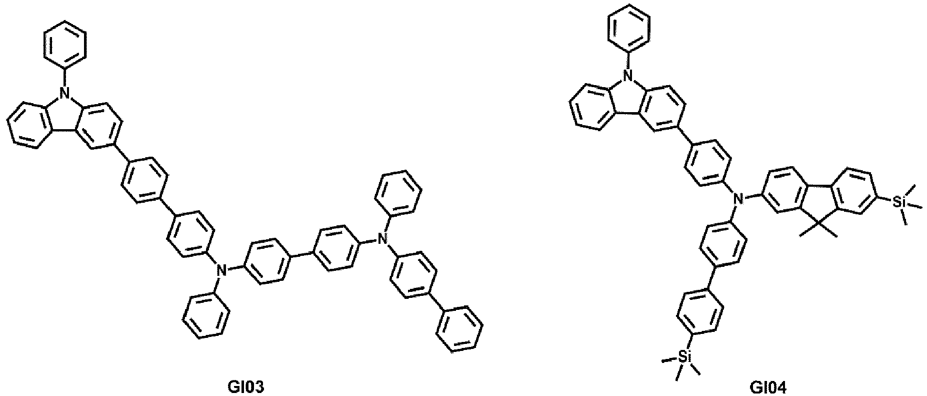

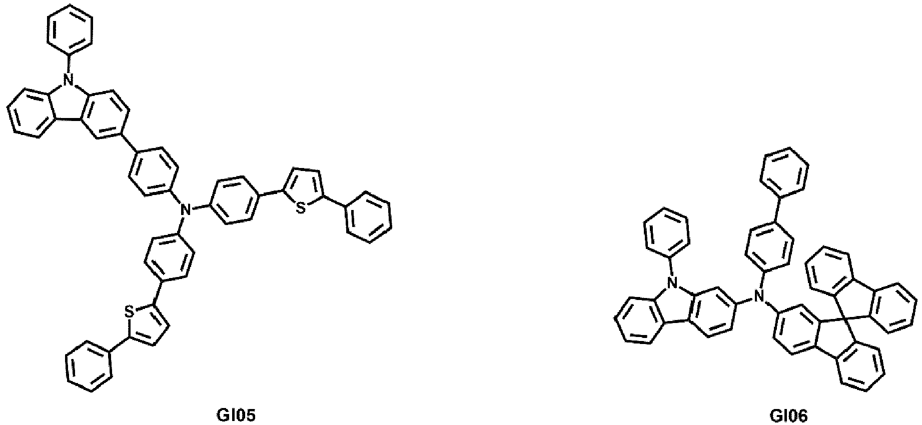

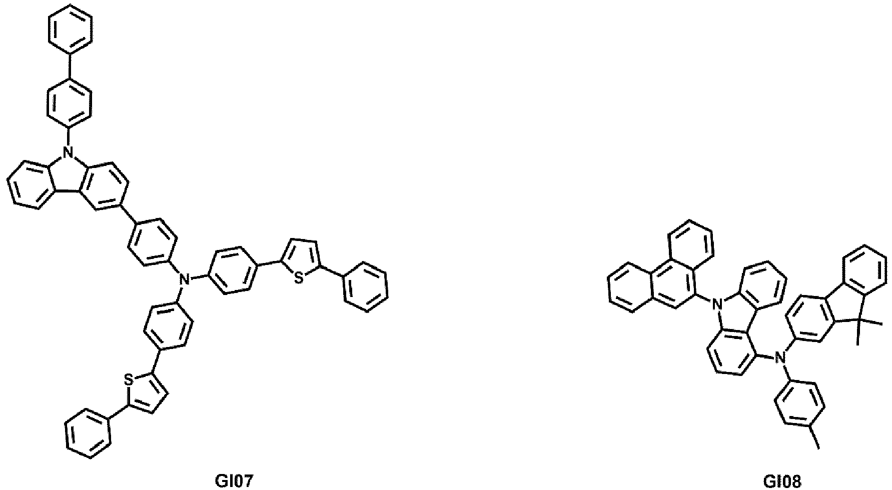

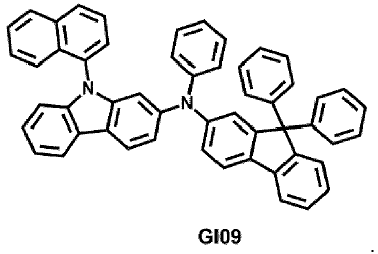

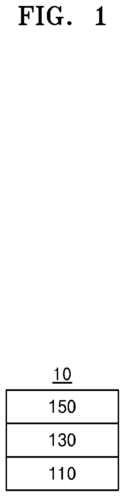

### [Description of FIG. 1]

FIG. 1 is a schematic cross-sectional view of a light-emitting device 10 according to an embodiment. The light-emitting device 10 may include a first electrode 110, an interlayer 130, and a second electrode 150.

Hereinafter, the structure of the light-emitting device 10 according to an embodiment and a method of manufacturing the light-emitting device 10 will be described with reference to FIG. 1.

### [First electrode 110]

In FIG. 1, a substrate may be further included under the first electrode 110 or on the second electrode 150. The substrate may be a glass substrate or a plastic substrate. In embodiments, the substrate may be a flexible substrate, and may include a plastic material with excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a structure consisting of a single layer or a structure including multiple layers. For example, the first electrode 110 may have a three-layered structure of ITO/Ag/ITO.

### [Interlayer 130]

The interlayer 130 may be located on the first electrode 110. The interlayer 130 may include an emission layer 135.

The interlayer 130 may further include a hole transport region 131 between the first electrode 110 and the emission layer 135, and an electron transport region between the emission layer 135 and the second electrode 150.

The interlayer 130 may further include, in addition to various organic materials, a metal-containing compound such as an organometallic compound, an inorganic material such as quantum dots, or the like.

In an embodiment, the interlayer 130 may include two or more emitting units stacked between the first electrode 110 and the second electrode 150, and at least one charge generation layer between two neighboring emitting units. When the interlayer 130 includes the two or more emitting units and the at least one charge generation layer as described above, the light-emitting device 10 may be a tandem light-emitting device.

### [Hole transport region 131 in interlayer 130]

The hole transport region 131 may have a structure consisting of a layer consisting of a single material, a structure consisting of a layer including different materials, or a structure including multiple layers including different materials.

The hole transport region 131 may include a first layer as described in the specification. The hole transport region 131 may optionally include, in addition to the first layer, at least one of a second layer and a third layer.

When the hole transport region 131 includes a third layer, a second layer, and a first layer, the third layer, the second layer, and the first layer may be sequentially stacked on the first electrode 110. The first layer may directly contact the emission layer 135.

The hole transport region 131 may further include, in addition to the first layer, a hole injection layer, a hole transport layer, an emission auxiliary layer, an electron-blocking layer, or any combination thereof.

The hole transport region 131 may include a compound represented by Formula 201, a compound represented by Formula 202, or any combination thereof:

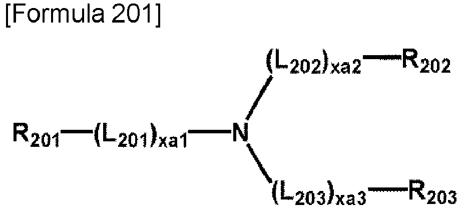

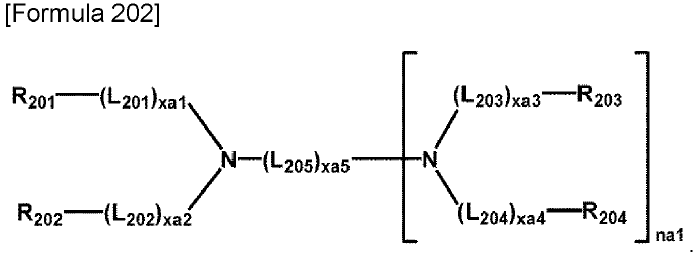

In Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ, or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ polycyclic group (for example, a carbazole group or the like) unsubstituted or substituted with at least one R₁₀ₐ (for example, see Compound HT16),
R₂₀₃ and R₂₀₄ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

In embodiments, the first material, the second material, and the third material described in the specification may each be a compound that satisfies conditions as described in the specification (for example, the highest occupied molecular orbital (HOMO) energy level conditions, etc.) among the compounds represented by Formula 201 and the compounds represented by Formula 202.

In embodiments, the compound represented by Formula 201 and the compound represented by Formula 202 may each independently include at least one of groups represented by Formulae CY201 to CY217.

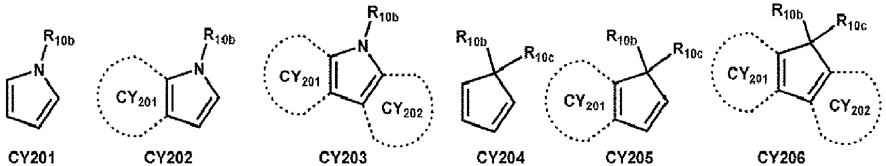

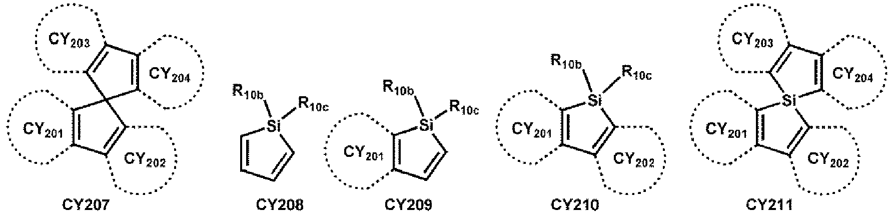

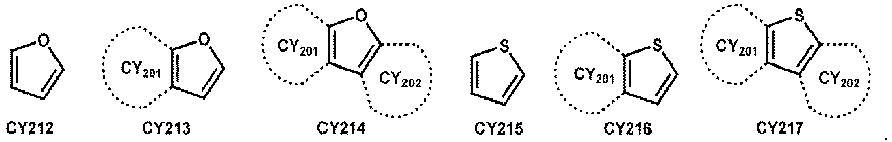

In Formulae CY201 to CY217, R_{10b} and R_{10c} in Formulae CY201 to CY217 may each independently be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In embodiments, in Formulae CY201 to CY217, ring CY₂₀₁ to ring CY₂₀₄ may each independently be a benzene group, a naphthalene group, a phenanthrene group, or an anthracene group.

In embodiments, the compound represented by Formula 201 and the compound represented by Formula 202 may each independently include at least one of groups represented by Formulae CY201 to CY203.

In embodiments, the compound represented by Formula 201 may include at least one of groups represented by Formulae CY201 to CY203 and at least one of the groups represented by Formulae CY204 to CY217.

In embodiments, in Formula 201, xa1 may be 1, R₂₀₁ may be a group represented by one of Formulae CY201 to CY203, xa2 may be 0, and R₂₀₂ may be a group represented by one of Formulae CY204 to CY207.

In embodiments, the compound represented by Formula 201 and the compound represented by Formula 202 may each not include a group represented by one of Formulae CY201 to CY203.

In embodiments, the compound represented by Formula 201 and the compound represented by Formula 202 may each not include a group represented by one of Formulae CY201 to CY203, and may each independently include at least one of groups represented by Formulae CY204 to CY217.

In embodiments, the compound represented by Formula 201 and the compound represented by Formula 202 may each not include a group represented by one of Formulae CY201 to CY217.

A thickness of the hole transport region 131 may be in a range of about 50 Å to about 10,000 Å. For example, the thickness of the hole transport region 131 may be in a range of about 100 Å to about 4,000 Å. A thickness of the third layer may be in a range of about 20 Å to about 7,000 Å, a thickness of the second layer may be in a range of about 20 Å to about 4,000 Å, and a thickness of the first layer may be in a range of about 10 Å to about 4,000 Å. When the thickness of each of the hole transport region 131, the third layer, the second layer, and the first layer satisfies these ranges, satisfactory hole transport characteristics may be obtained without a substantial increase in driving voltage.

Compounds that may be included in the hole transport region 131, for example, examples of compounds that may be included in each of the first layer, the second layer, and the third layer may include Compounds HT01 to HT10, G'01 to G'10, and GI01 to GI09.

### [p-dopant]

The hole transport region 131 may further include, in addition to these materials, a charge-generation material for the improvement of conductive properties. The charge-generation material may be uniformly or non-uniformly dispersed in the hole transport region 131 (for example, in the form of a single layer consisting of a charge-generation material).

The charge-generation material may be, for example, a p-dopant.

In an embodiment, a lowest unoccupied molecular orbital (LUMO) energy level of the p-dopant may be less than or equal to -3.5 eV.

In embodiments, the p-dopant may include a quinone derivative, a cyano group-containing compound, a compound including element EL1 and element EL2, or any combination thereof.

Examples of the quinone derivative may include TCNQ, F4-TCNQ, etc.

Examples of the cyano group-containing compound may include HAT-CN (or HAT), a compound represented by Formula 221, and the like:

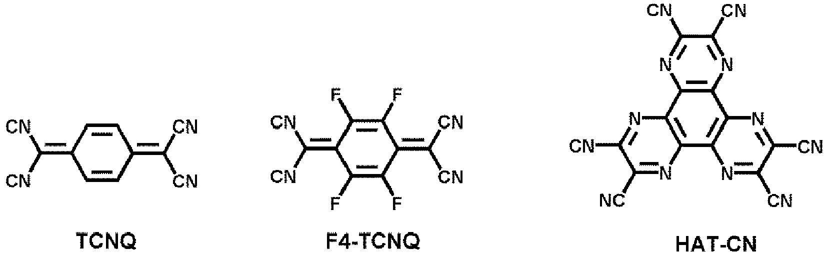

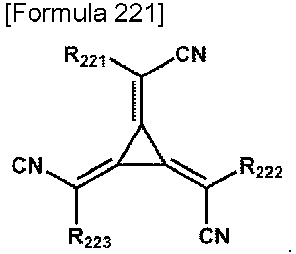

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with a cyano group; -F; -Cl; -Br; -I; a C₁-C₂₀ alkyl group substituted with a cyano group, -F, -Cl, -Br, -I, or any combination thereof; or any combination thereof.

In the compound including element EL1 and element EL2, element EL1 may be metal, metalloid, or any combination thereof, and element EL2 may be non-metal, metalloid, or any combination thereof.

Examples of a metal may include an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of a metalloid may include silicon (Si), antimony (Sb), and tellurium (Te).

Examples of a non-metal may include oxygen (O) and a halogen (for example, F, Cl, Br, I, etc.).

Examples of a compound including element EL1 and element EL2 may include a metal oxide, a metal halide (for example, a metal fluoride, a metal chloride, a metal bromide, or a metal iodide), a metalloid halide (for example, a metalloid fluoride, a metalloid chloride, a metalloid bromide, or a metalloid iodide), a metal telluride, or any combination thereof.

Examples of a metal oxide may include tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoOs, Mo₂O₅, etc.), and rhenium oxide (for example, ReOs, etc.).

Examples of a metal halide may include an alkali metal halide, an alkaline earth metal halide, a transition metal halide, a post-transition metal halide, and a lanthanide metal halide.

Examples of an alkali metal halide may include LiF, NaF, KF, RbF, CsF, LiCl, NaCl, KCl, RbCl, CsCl, LiBr, NaBr, KBr, RbBr, CsBr, Lil, Nal, KI, Rbl, and Csl.

Examples of an alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and BaI₂.

Examples of a transition metal halide may include a titanium halide (for example, TiF₄, TiCl₄, TiBr₄, TiI₄, etc.), a zirconium halide (for example, ZrF₄, ZrCl₄, ZrBr₄, ZrI₄, etc.), a hafnium halide (for example, HfF₄, HfCl₄, HfBr₄, HfI₄, etc.), a vanadium halide (for example, VF₃, VCl₃, VBr₃, VI₃, etc.), a niobium halide (for example, NbFs, NbCl₃, NbBr₃, NbI₃, etc.), a tantalum halide (for example, TaF₃, TaCl₃, TaBr₃, TaI₃, etc.), a chromium halide (for example, CrFs, CrCls, CrBr₃, CrI₃, etc.), a molybdenum halide (for example, MoF₃, MoCl₃, MoBrs, MoI₃, etc.), a tungsten halide (for example, WF₃, WCl₃, WBrs, WI₃, etc.), a manganese halide (for example, MnF₂, MnCl₂, MnBr₂, MnI₂, etc.), a technetium halide (for example, TcF₂, TcCl₂, TcBr₂, TcI₂, etc.), a rhenium halide (for example, ReF₂, ReCl₂, ReBr₂, ReI₂, etc.), an iron halide (for example, FeF₂, FeCl₂, FeBr₂, FeI₂, etc.), a ruthenium halide (for example, RuF₂, RuCl₂, RuBr₂, RuI₂, etc.), an osmium halide (for example, OsF₂, OsCl₂, OsBr₂, OsI₂, etc.), a cobalt halide (for example, CoF₂, CoCl₂, CoBr₂, CoI₂, etc.), a rhodium halide (for example, RhF₂, RhCl₂, RhBr₂, RhI₂, etc.), an iridium halide (for example, IrF₂, IrCl₂, IrBr₂, IrI₂, etc.), a nickel halide (for example, NiF₂, NiCl₂, NiBr₂, NiI₂, etc.), a palladium halide (for example, PdF₂, PdCl₂, PdBr₂, PdI₂, etc.), a platinum halide (for example, PtF₂, PtCl₂, PtBr₂, PtI₂, etc.), a copper halide (for example, CuF, CuCl, CuBr, Cul, etc.), a silver halide (for example, AgF, AgCl, AgBr, Agl, etc.), and a gold halide (for example, AuF, AuCl, AuBr, Aul, etc.).

Examples of a post-transition metal halide may include a zinc halide (for example, ZnF₂, ZnCl₂, ZnBr₂, ZnI₂, etc.), an indium halide (for example, InI₃, etc.), and a tin halide (for example, SnI₂, etc.).

Examples of a lanthanide metal halide may include YbF, YbF₂, YbF₃, SmF₃, YbCl, YbCl₂, YbCl₃ SmCl₃, YbBr, YbBr₂, YbBr₃, SmBr₃, Ybl, YbI₂, YbI₃, SmI₃, and the like.

An example of a metalloid halide may include an antimony halide (for example, SbCls, etc.).

Examples of a metal telluride may include an alkali metal telluride (for example, Li₂Te, Na₂Te, K2Te, Rb₂Te, Cs₂Te, etc.), an alkaline earth metal telluride (for example, BeTe, MgTe, CaTe, SrTe, BaTe, etc.), a transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), a post-transition metal telluride (for example, ZnTe, etc.), and a lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### [Emission layer 135 in interlayer 130]

When the light-emitting device 10 is a full-color light-emitting device, the emission layer 135 may be patterned into a red emission layer, a green emission layer, and/or a blue emission layer, according to a subpixel. In embodiments, the emission layer may have a stacked structure of two or more layers of a red emission layer, a green emission layer, and a blue emission layer, in which the two or more layers may contact each other or may be separated from each other to emit white light. In embodiments, the emission layer 135 may include two or more materials of a red light-emitting material, a green light-emitting material, and a blue light-emitting material, in which the two or more materials are mixed with each other in a single layer to emit white light.

In an embodiment, the emission layer 135 may further include a host, an auxiliary dopant, a sensitizer, delayed fluorescence material, or any combination thereof, in addition to the first emitter and the first host as described in the specification.

An amount of the first emitter in the emission layer 135 may be in a range of about 0.01 parts by weight to about 15 parts by weight, per 100 parts by weight of the emission layer 135. When the amount of the first emitter satisfies these ranges, excellent luminescence efficiency may be achieved without a substantial increase in driving voltage.

A thickness of the emission layer 135 may be in a range of about 100 Å to about 1,000 Å. For example, the thickness of the emission layer 135 may be in a range of about 200 Å to about 600 Å. When the thickness of the emission layer 135 is within these ranges, excellent light-emission characteristics may be obtained without a substantial increase in driving voltage.

The descriptions of the first emitter and the first host are the same as described in the specification.

### [Fluorescent dopant]

The emission layer 135 may further include a fluorescent dopant in addition to the first emitter and the first host as described in the specification.

The fluorescent dopant may include an arylamine compound, a styrylamine compound, a boron-containing compound, or any combination thereof.

For example, the fluorescent dopant may include a compound represented by Formula 501:

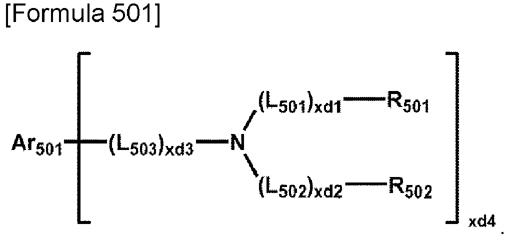

In Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In an embodiment, in Formula 501, Ar₅₀₁ may be a condensed cyclic group (for example, an anthracene group, a chrysene group, or a pyrene group) in which three or more monocyclic groups are condensed each other.

In embodiments, in Formula 501, xd4 may be 2.

In an embodiment, the fluorescent dopant may include: one of Compounds FD1 to FD36; DPVBi; DPAVBi; or any combination thereof:

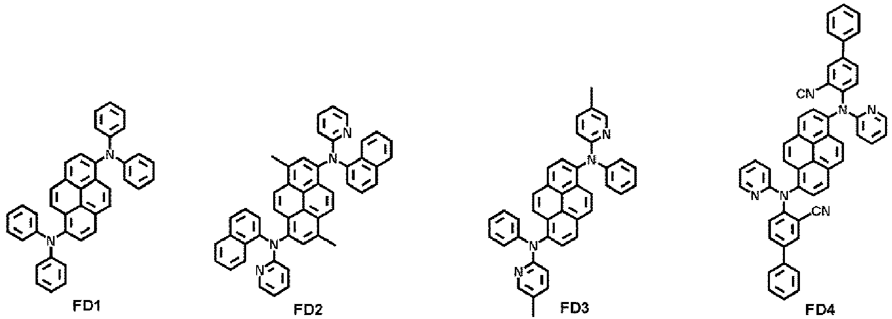

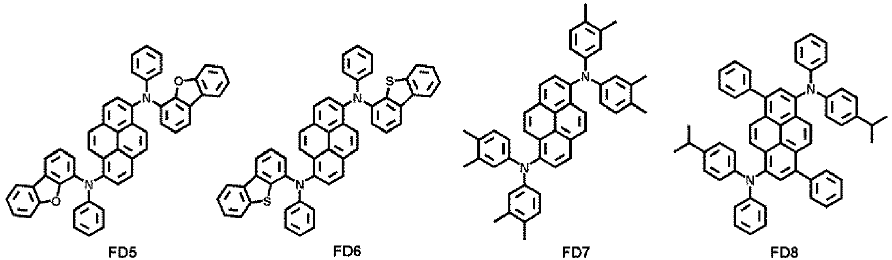

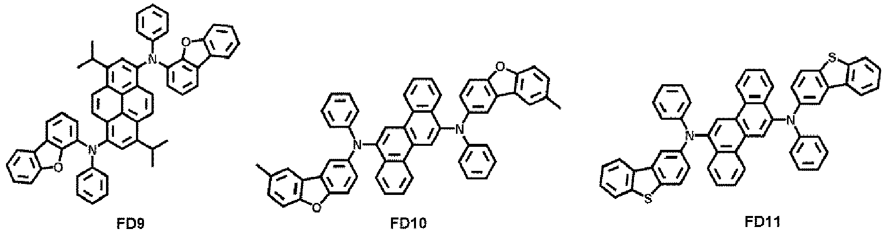

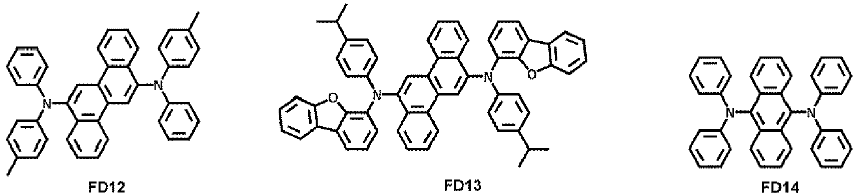

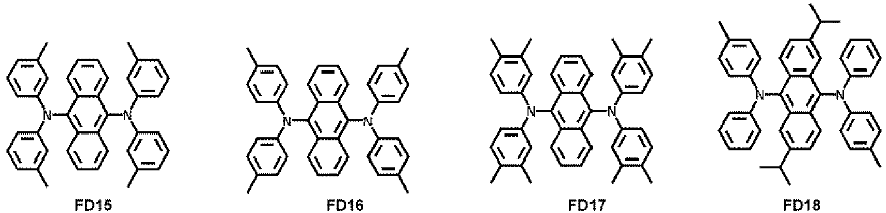

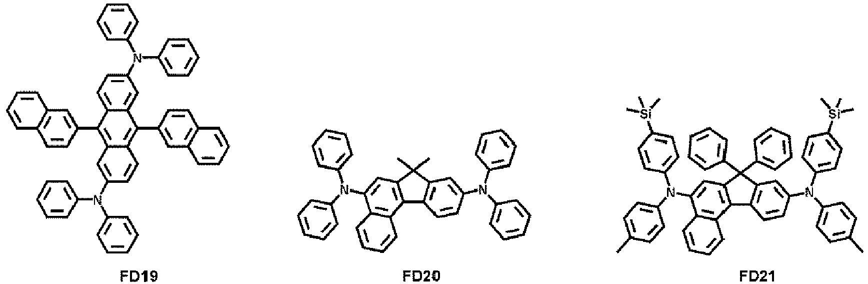

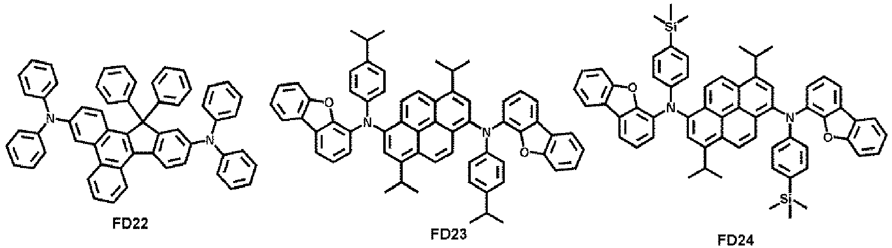

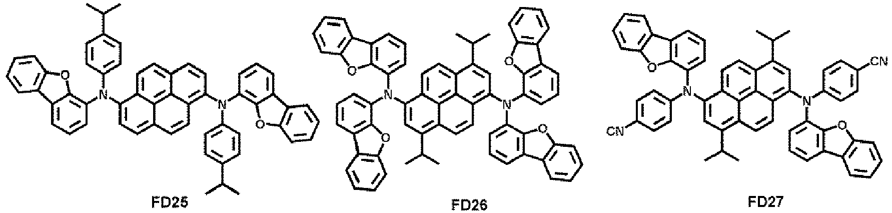

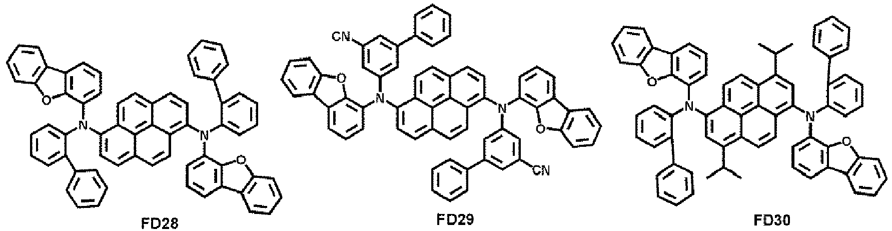

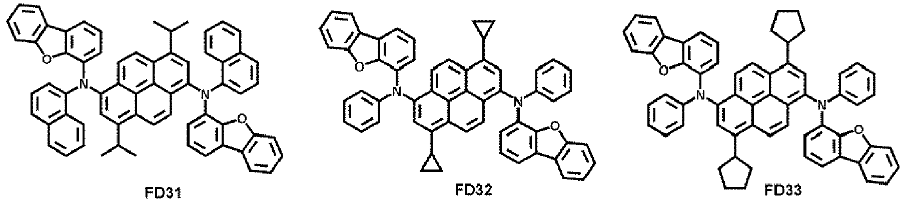

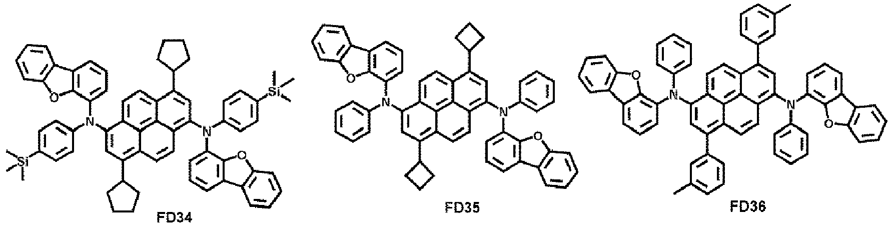

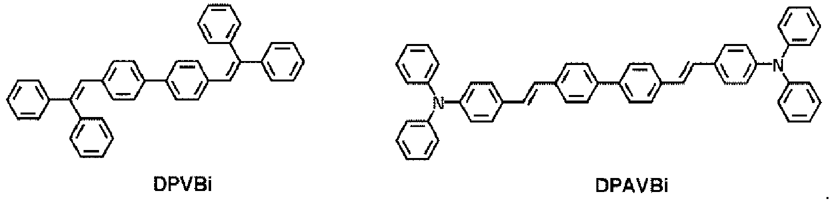

### [Delayed fluorescence material]

The emission layer 135 may further include a delayed fluorescence material in addition to the first emitter and the first host.

In the specification, the delayed fluorescence material may be selected from compounds capable of emitting delayed fluorescence based on a delayed fluorescence emission mechanism.

The delayed fluorescence material included in the emission layer 135 may serve as a host or as a dopant, depending on the types of other materials included in the emission layer 135.

In embodiments, a difference between the triplet energy level (eV) of the delayed fluorescence material and the singlet energy level (eV) of the delayed fluorescence material may be in a range of about 0 eV to about 0.5 eV. When the difference between a triplet energy level (eV) of the delayed fluorescence material and a singlet energy level (eV) of the delayed fluorescence material satisfies the above-described range, up-conversion from the triplet state to the singlet state of the delayed fluorescence materials may effectively occur, and thus, the luminescence efficiency of the light-emitting device 10 may be improved.

In embodiments, the delayed fluorescence material may include: a material including at least one electron donor (for example, a π electron-rich C₃-C₆₀ cyclic group, such as a carbazole group) and at least one electron acceptor (for example, a sulfoxide group, a cyano group, or a π electron-deficient nitrogen-containing C₁-C₆₀ cyclic group); or a material including a C₈-C₆₀ polycyclic group in which two or more cyclic groups are condensed while sharing boron (B).

Examples of a delayed fluorescence material may include at least one of Compounds DF1 to DF14:

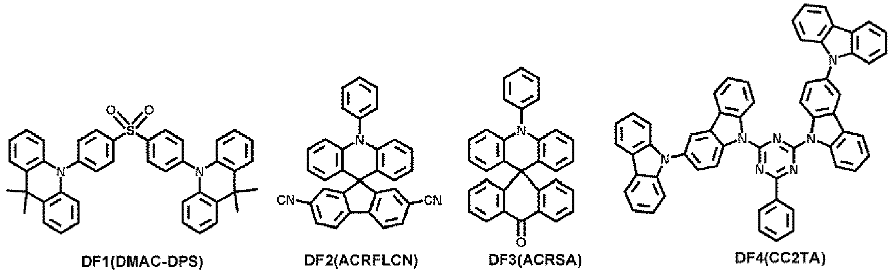

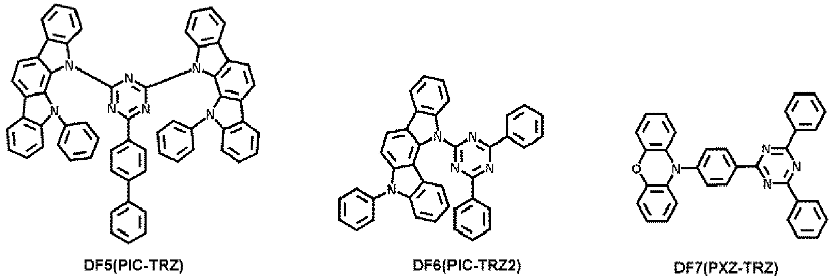

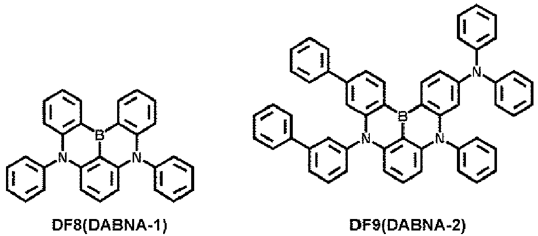

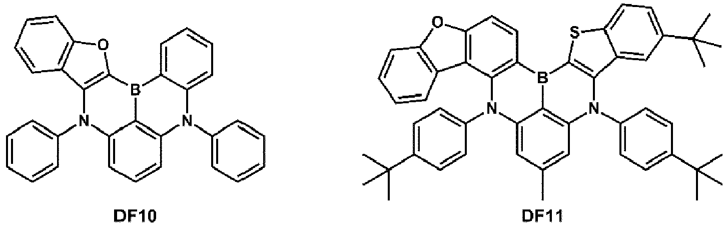

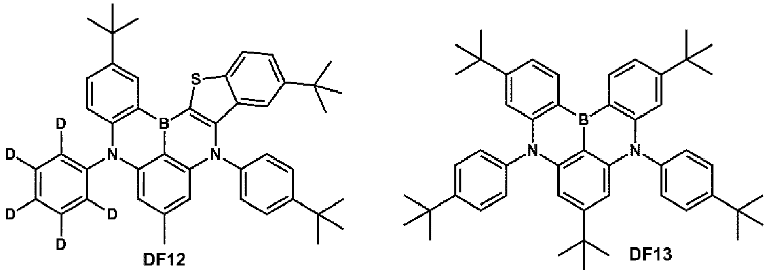

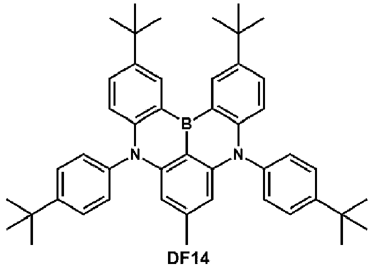

### [Electron transport region in interlayer 130]

The electron transport region may have a structure consisting of a layer consisting of a single material, a structure consisting of a layer including different materials, or a structure including multiple layers including different materials.

The electron-transporting region may include a buffer layer, a hole-blocking layer, an electron control layer, an electron-transporting layer, an electron injection layer, or any combination thereof.

In embodiments, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, wherein the constituting layers of each structure may be stacked from an emission layer in its respective stated order, but the structure of the electron transport region is not limited thereto.

In an embodiment, the electron transport region may include a buffer layer and an electron transport layer, the buffer layer may be disposed between the emission layer 135 and the second electrode 150, and the electron transport layer may be disposed between the buffer layer and the second electrode 150. For example, the light-emitting device may have a structure in which the buffer layer and the electron transport layer are sequentially stacked from the emission layer 135.

In an embodiment, a LUMO energy level of a buffer layer material included in the buffer layer may be in a range of about -2.50 eV to about -2.10 eV. For example, the LUMO energy level of a buffer layer material included in the buffer layer may be in a range of about -2.40 eV to about -2.20 eV.

In an embodiment, an electron mobility of a buffer layer material included in the buffer layer may be in a range of about 4.38 × 10⁻⁵cm²/Vs to about 7.00 × 10⁻³cm²/Vs. For example, the electron mobility of a buffer layer material included in the buffer layer may be in a range of about 5.00 × 10⁻⁴cm²/Vs to about 4.58 × 10⁻⁴cm²/Vs.

In an embodiment, a LUMO energy level of an electron transport layer material included in the electron transport layer may be in a range of about -2.50 eV to about - 2.10 eV. For example, the LUMO energy level of an electron transport layer material included in the electron transport layer may be in a range of about -2.40 eV to about - 2.20 eV.

In an embodiment, an electron mobility of an electron transport layer material included in the electron transport layer may be in a range of about 6.95 × 10⁻⁵ cm²/Vs to about 1.39 × 10⁻³ cm²/Vs. For example, the electron mobility of an electron transport layer material included in the electron transport layer may be in a range of about 9.00 × 10⁻⁴ cm²/Vs to about 1.20 × 10^{- 3} cm²/Vs.

In an embodiment, an absolute value of a LUMO energy level of a buffer layer material may be greater than an absolute value of a LUMO energy level of the first host.

In an embodiment, an absolute value of the difference between a LUMO energy level of the first host and a LUMO energy level of a buffer layer material may be in a range of about 0 eV to about 0.60 eV. For example, the absolute value of the difference between a LUMO energy level of the first host and a LUMO energy level of a buffer layer material may be in a range of about 0 eV to about 0.54 eV.

In an embodiment, an absolute value of a LUMO energy level of an electron transport layer material may be greater than an absolute value of a LUMO energy level of a buffer layer material.

In an embodiment, an absolute value of a LUMO energy level of an electron transport layer material may be greater than an absolute value of a LUMO energy level of a buffer layer material.

In an embodiment, an absolute value of the difference between a LUMO energy level of a buffer layer material and a LUMO energy level of an electron transport layer material may be in a range of about 0 eV to about 0.30 eV.

In an embodiment, the electron transport region (for example, a buffer layer, a hole-blocking layer, an electron control layer, or an electron transport layer in the electron transport region) may include a metal-free compound including at least one π electron-deficient nitrogen-containing C₁-C₆₀ cyclic group.

In an embodiment, the electron transport region may include a compound represented by Formula 601:

[Formula 601] [Ar₆₀₁]ₓₑ₁₁-[(L₆₀₁)ₓₑ₁-R₆₀₁]ₓₑ₂₁

In Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each independently be the same as described herein with respect to Q₁,
xe21 may be 1, 2, 3, 4, or 5, and
at least one of Ar₆₀₁, L₆₀₁ and r₆₀₁ may each independently be a π electron-deficient nitrogen-containing C₁-C₆₀ cyclic group that is unsubstituted or substituted with R₁₀ₐ (for example, a pyridine group, a pyrimidine group, a pyrazine group, a pyridazine group, a triazine group, a quinoline group, a isoquinoline group, an oxadiazole group, a thiadiazole group, a imidazole group, a benzimidazole group, a quinoxaline group, a quinazoline group, etc., each unsubstituted or substituted with R₁₀ₐ).

In an embodiment, in Formula 601, when xe11 is 2 or more, two or more of Ar₆₀₁ may be linked to each other via a single bond.

In an embodiment, in Formula 601, Ar₆₀₁ may be a substituted or unsubstituted anthracene group.

In an embodiment, the electron transport region may include a buffer layer and an electron transport layer, sequentially stacked from the emission layer 135, and each of a buffer layer material and an electron transport layer material may be a compound represented by Formula 601 that satisfies the conditions (for example, LUMO energy level, etc.) as described in the specification from among the compounds represented by Formula 601.

In an embodiment, the electron transport region may include a compound represented by Formula 601-1:

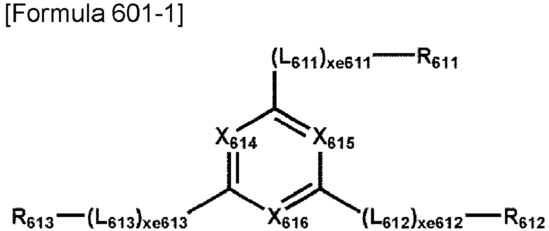

In Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may each be N,
L₆₁₁ to L₆₁₃ may each independently be the same as described herein with respect to L₆₀₁,
xe611 to xe613 may each independently be the same as described herein with respect to xe1,
R₆₁₁ to R₆₁₃ may each independently be the same as described herein with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

In an embodiment, in Formulae 601 and 601-1, xe1 and xe611 to xe613 may each independently be 0, 1, or 2.

In an embodiment, the electron transport region may include a buffer layer, and a buffer layer material may be selected from BF01 to BF10:

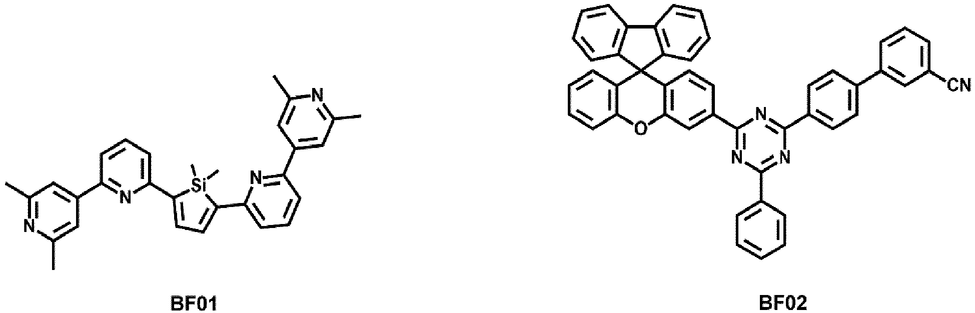

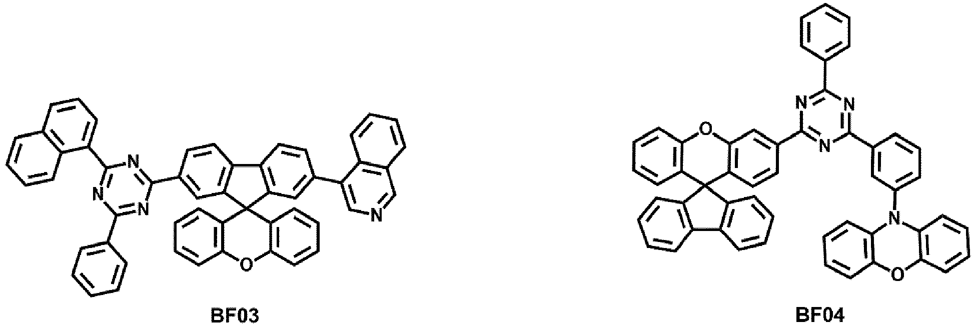

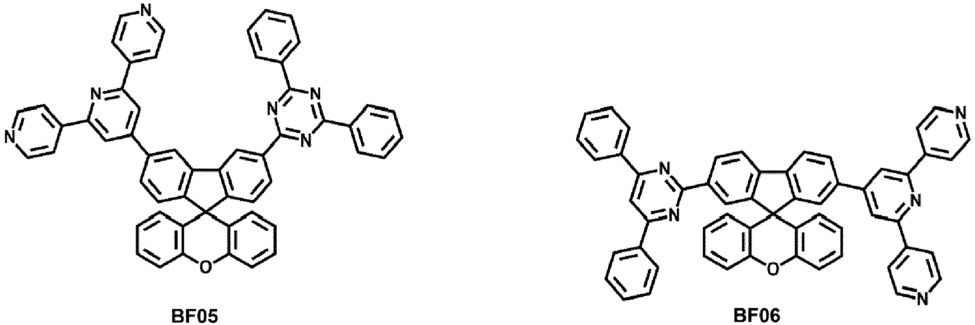

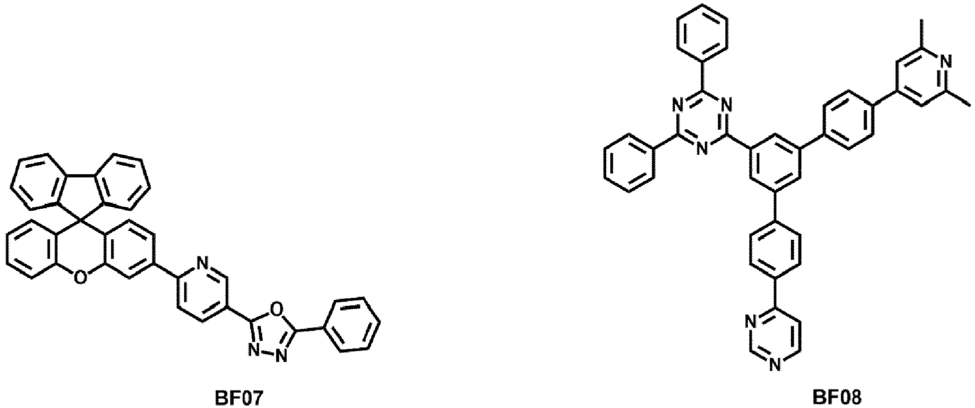

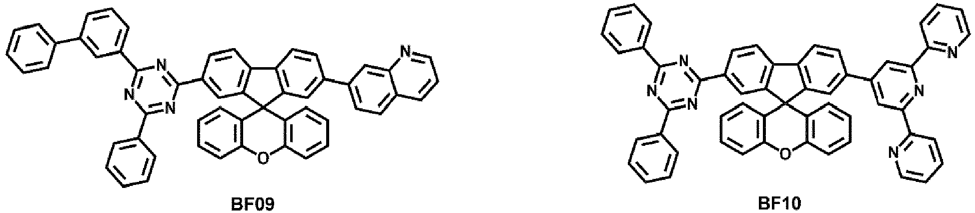

In an embodiment, the electron transport region may include an electron transport layer, and an electron transport layer material may be selected from ET01 to ET10:

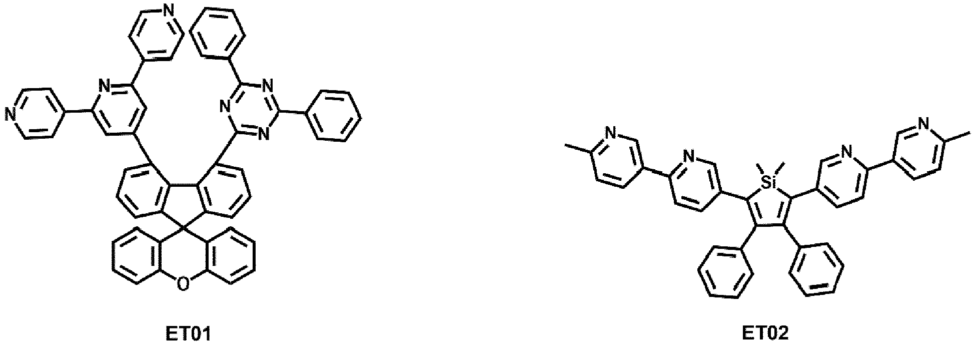

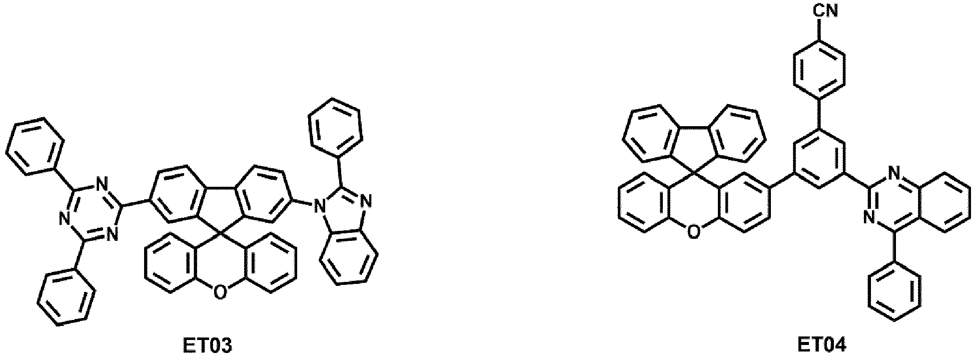

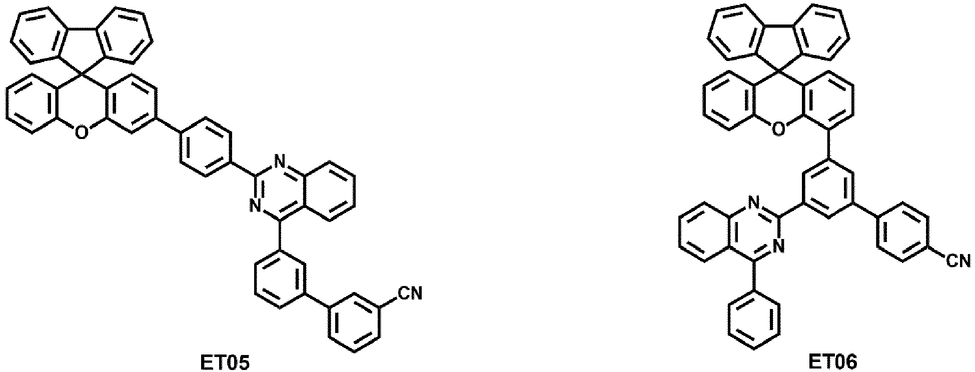

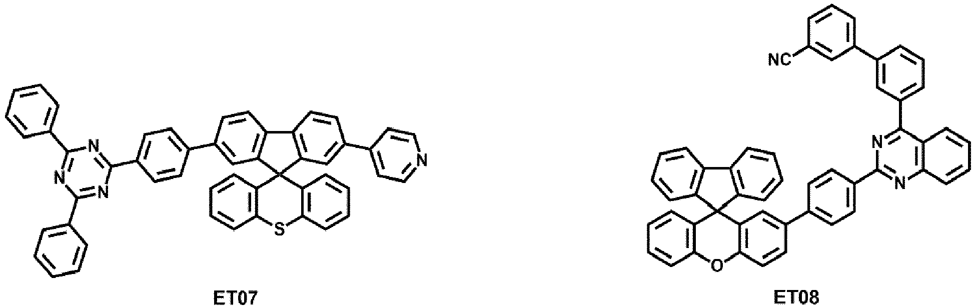

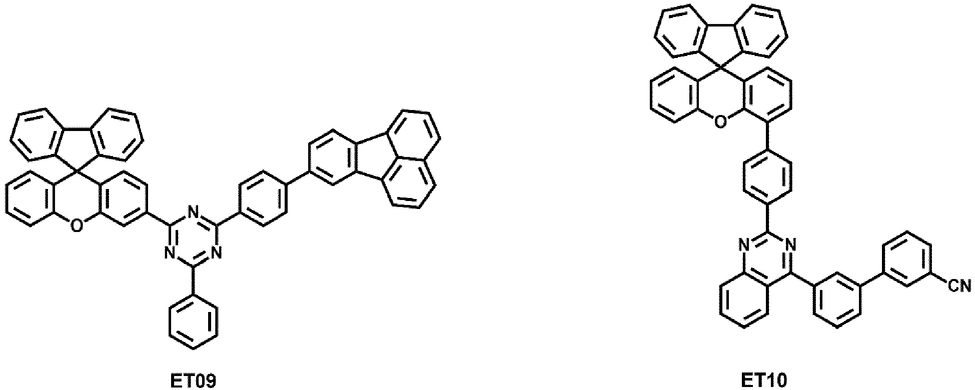

A thickness of the electron transport region may be in a range of about 100 Å to about 5,000 Å. For example, the thickness of the electron transport region may be in a range of about 160 Å to about 4,000 Å. When the electron transport region includes a buffer layer, a hole-blocking layer, an electron control layer, an electron transport layer, or any combination thereof, a thickness of the buffer layer, the hole-blocking layer, or the electron control layer may be in a range of about 20 Å to about 1,000 Å, and a thickness of the electron transport layer may be in a range of about 100 Å to about 1,000 Å. For example, the thickness of the buffer layer, the hole blocking layer, or the electron control layer may each independently be in a range of about 30 Å to about 300 Å. For example, the thickness of the electron transport layer may be in a range of about 150 Å to about 500 Å. When the thickness of the buffer layer, the hole-blocking layer, the electron control layer, the electron transport layer, and/or the electron transport layer are within these ranges, satisfactory electron transporting characteristics may be obtained without a substantial increase in driving voltage.

The electron transport region (for example, an electron transport layer in the electron transport region) may further include, in addition to the materials described above, a metal-containing material.

The metal-containing material may include an alkali metal complex, an alkaline earth metal complex, or any combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or with the metal ion of the alkaline earth-metal complex may each independently include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, the metal-containing material may include a Li complex. The Li complex may include, for example, Compound ET-D1 (LiQ) or Compound ET-D2:

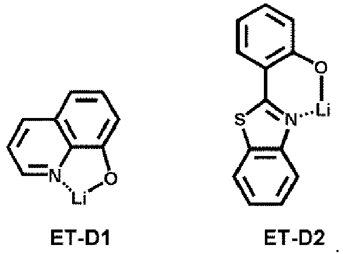

The electron transport region may include an electron injection layer that facilitates the injection of electrons from the second electrode 150. The electron injection layer may directly contact the second electrode 150.

The electron injection layer may have a structure consisting of a layer consisting of a single material, a structure consisting of a layer including different materials, or a including multiple layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides, halides (for example, fluorides, chlorides, bromides, or iodides), or tellurides of the alkali metal, the alkaline earth metal, and the rare earth metal, or any combination thereof.

The alkali metal-containing compound may include: alkali metal oxides, such as Li₂O, Cs₂O, or K₂O; alkali metal halides, such as LiF, NaF, CsF, KF, Lil, Nal, Csl, KI, or Rbl; or any combination thereof. The alkaline earth metal-containing compound may include an alkaline earth metal compound, such as BaO, SrO, CaO, BaₓSr₁₋ₓO (wherein x is a real number satisfying the condition of 0<x<1), BaₓCa₁₋ₓO (wherein x is a real number satisfying the condition of 0<x<1), or the like. The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In embodiments, the rare earth metal-containing compound may include a lanthanide metal telluride. Examples of a lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include: an alkali metal ion, an alkaline earth metal ion, or a rare earth metal ion; and a ligand bonded to the metal ion (for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof).

The electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In embodiments, the electron injection layer may further include an organic material (for example, a compound represented by Formula 601).

In embodiments, the electron injection layer may consist of: an alkali metal-containing compound (for example, an alkali metal halide); or the electron injection layer may consist of an alkali metal-containing compound (for example, an alkali metal halide), and an alkali metal, an alkaline earth metal, a rare earth metal, or any combination thereof. For example, the electron injection layer may be a KI:Yb co-deposited layer, an RbI:Yb co-deposited layer, a LiF:Yb co-deposited layer, or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be uniformly or non-uniformly dispersed in a matrix including the organic material.

A thickness of the electron injection layer may be in a range of about 1 Å to about 100 Å. For example, the thickness of the electron injection layer may be in a range of about 3 Å to about 90 Å. When the thickness of the electron injection layer is within the ranges described above, satisfactory electron injection characteristics may be obtained without a substantial increase in driving voltage.

### [Second electrode 150]

The second electrode 150 may be on the interlayer 130 having a structure as described above. The second electrode 150 may be a cathode, which is an electron injection electrode. A material for forming the second electrode 150 may be a material having a low work function, such as a metal, an alloy, an electrically conductive compound, or any combination thereof.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure or a multilayered structure.

### [Capping layer]

The light-emitting device 10 may include a first capping layer outside the first electrode 110, and/or a second capping layer outside the second electrode 150. For example, the light-emitting device 10 may have a structure in which the first capping layer, the first electrode 110, the interlayer 130, and the second electrode 150 are stacked in this stated order, a structure in which the first electrode 110, the interlayer 130, the second electrode 150, and the second capping layer are stacked in this stated order, or a structure in which the first capping layer, the first electrode 110, the interlayer 130, the second electrode 150, and the second capping layer are stacked in this stated order.

Light generated in an emission layer 135 in the interlayer 130 of the light-emitting device 10 may be extracted toward the outside through the first electrode 110 which may be a semi-transmissive electrode or a transmissive electrode, and through the first capping layer. Light generated in an emission layer 135 in the interlayer 130 of the light-emitting device 10 may be extracted toward the outside through the second electrode 150, which may be a semi-transmissive electrode or a transmissive electrode, and through the second capping layer.

The first capping layer and the second capping layer may each increase external emission efficiency according to the principle of constructive interference. Accordingly, the light extraction efficiency of the light-emitting device 10 is increased, so that the luminescence efficiency of the light-emitting device 10 may be improved.

In an embodiment, at least one of the first capping layer and the second capping layer may each independently include a material having a refractive index greater than or equal to about 1.6 with respect to a wavelength of about 589 nm. For example, at least one of the first capping layer and the second capping layer may each independently include a material having a refractive index greater than or equal to about 1.8 with respect to a wavelength of about 589 nm. For example, at least one of the first capping layer and the second capping layer may each independently include a material having a refractive index greater than or equal to about 2.0 with respect to a wavelength of about 589 nm.

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include carbocyclic compounds, heterocyclic compounds, amine group-containing compounds, porphine derivatives, phthalocyanine derivatives, naphthalocyanine derivatives, alkali metal complexes, alkaline earth metal complexes, or any combination thereof. In an embodiment, the carbocyclic compound, the heterocyclic compound, and the amine group-containing compound may be optionally substituted with a substituent including O, N, S, Se, Si, F, Cl, Br, I, or any combination thereof.

In embodiments, at least one of the first capping layer and the second capping layer may each independently include an amine group-containing compound.

For example, at least one of the first capping layer and the second capping layer may each independently include a compound represented by Formula 201, a compound represented by Formula 202, or any combination thereof.

In embodiments, at least one of the first capping layer and the second capping layer may each independently include one of Compounds HT28 to HT33, one of Compounds CP1 to CP8, β-NPB, or any combination thereof:

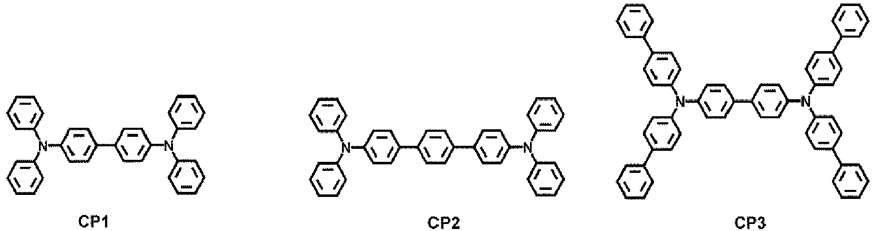

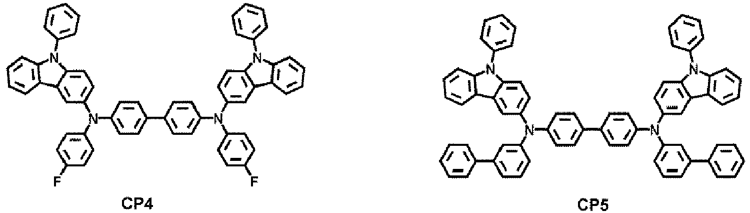

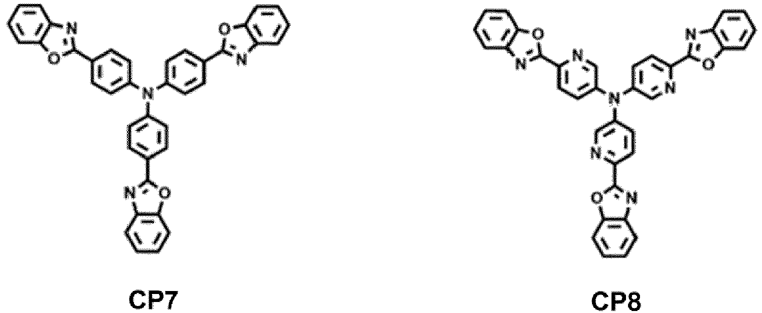

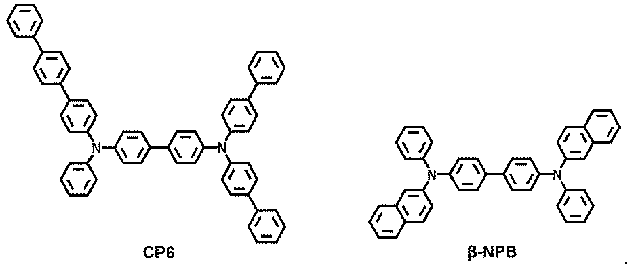

### [Electronic device]

The light-emitting device may be included in various electronic devices. In an embodiment, the electronic device including the light-emitting device may be a light-emitting device, an authentication device, or the like.

The electronic device (for example, a light-emitting device) may further include, in addition to the light-emitting device, a color filter, a color conversion layer, or a color filter and a color conversion layer. The color filter and/or the color conversion layer may be located in at least one direction in which light emitted from the light-emitting device travels. For example, the light emitted from the light-emitting device may be blue light, green light, or white light. For details on the light-emitting device, related description provided above may be referred to. In embodiments, the color conversion layer may include a quantum dot.

The electronic device may include a first substrate. The first substrate may include subpixels, the color filter may include multiple color filter areas respectively corresponding to the subpixels, and the color conversion layer may include multiple color conversion areas respectively corresponding to the subpixels.

A pixel-defining film may be located between the subpixels to define each subpixel.

The color filter may further include color filter areas and light-shielding patterns located between the color filter areas, and the color conversion layer may further include color conversion areas and light-shielding patterns located between the color conversion areas.

The color filter areas (or the color conversion areas) may include a first area emitting first color light, a second area emitting second color light, and/or a third area emitting third color light, wherein the first color light, the second color light, and/or the third color light may have different maximum emission wavelengths from one another. For example, the first color light may be red light, the second color light may be green light, and the third color light may be blue light. For example, the color filter areas (or the color conversion areas) may include quantum dots. For example, the first area may include a red quantum dot, the second area may include a green quantum dot, and the third area may not include a quantum dot. For details on the quantum dot, related descriptions provided herein may be referred to. The first area, the second area, and/or the third area may each include a scatterer.

In an embodiment, the light-emitting device may emit first light, the first area may absorb the first light to emit first-first color light, the second area may absorb the first light to emit second-first color light, and the third area may absorb the first light to emit third-first color light. In this regard, the first-first color light, the second-first color light, and the third-first color light may have different maximum emission wavelengths from one another. For example, the first light may be blue light, the first-first color light may be red light, the second-first color light may be green light, and the third-first color light may be blue light.

The electronic device may further include a thin-film transistor, in addition to the light-emitting device as described above. The thin-film transistor may include a source electrode, a drain electrode, and an active layer, wherein any one of the source electrode and the drain electrode may be electrically connected to any one of the first electrode and the second electrode of the light-emitting device.

The thin-film transistor may further include a gate electrode, a gate insulating film, or the like.

The active layer may include crystalline silicon, amorphous silicon, an organic semiconductor, an oxide semiconductor, or the like.

The electronic device may further include a sealing portion for sealing the light-emitting device. The sealing portion may be located between the color filter and/or the color conversion layer and the light-emitting device. The sealing portion may allow light from the light-emitting device to be extracted to the outside, and may simultaneously prevent ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic device may be flexible.

Various functional layers may be further included on the sealing portion, in addition to the color filter and/or the color conversion layer, according to the use of the electronic device. Examples of the functional layers may include a touch screen layer, a polarizing layer, and the like. The touch screen layer may be a pressure-sensitive touch screen layer, a capacitive touch screen layer, or an infrared touch screen layer. The authentication apparatus may be, for example, a biometric authentication apparatus that authenticates an individual by using biometric information of a living body (for example, fingertips, pupils, etc.).

The authentication apparatus may further include, in addition to the light-emitting device as described above, a biometric information collector.

The electronic device may be applied to various displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, various measuring instruments, meters (for example, meters for a vehicle, an aircraft, and a vessel), projectors, and the like.

### [Electronic apparatus]

The light-emitting device may be included in various electronic apparatuses.

In an embodiment, an electronic apparatus including the light-emitting device may be a flat panel display, a curved display, a computer monitor, a medical monitor, a television, a billboard, a light for indoor light, an outdoor light, a signal light, a head-up display, a fully transparent display, a partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual reality display, and augmented reality display, a vehicle, a video wall including multiple displays tiled together, a theater screen, a stadium screen, a phototherapy device, or a signboard.

The light-emitting device may have excellent effects in terms of luminescence efficiency long lifespan, and thus the electronic apparatus including the light-emitting device may have characteristics, such as high luminance, high resolution, and low power consumption.

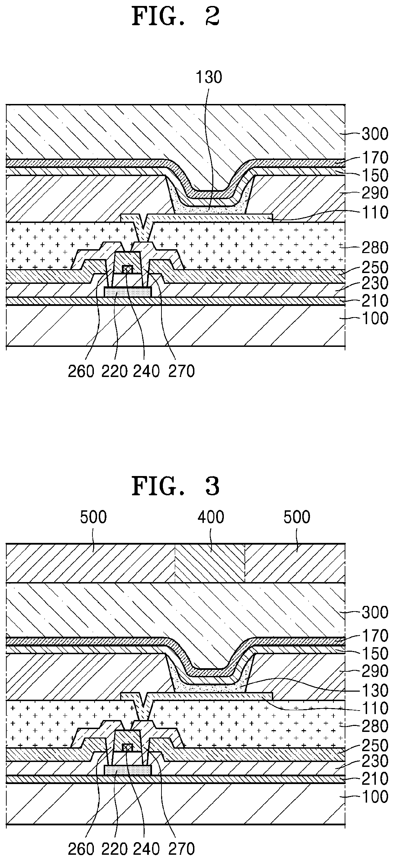

### [Description of FIGS. 2 and 3]

FIG. 2 is a schematic cross-sectional view of an electronic apparatus according to an embodiment.

The electronic apparatus (e.g., a light-emitting apparatus) of FIG. 2 may include a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be located on the substrate 100. The buffer layer 210 may prevent penetration of impurities through the substrate 100 and may provide a flat surface on the substrate 100.

A TFT may be located on the buffer layer 210. The TFT may include an active layer 220, a gate electrode 240, a source electrode 260, and a drain electrode 270.

The active layer 220 may include an inorganic semiconductor such as silicon or polysilicon, an organic semiconductor, or an oxide semiconductor, and may include a source region, a drain region, and a channel region.

A gate insulating film 230 for insulating the active layer 220 from the gate electrode 240 may be located on the active layer 220, and the gate electrode 240 may be located on the gate insulating film 230.

An interlayer insulating film 250 may be located on the gate electrode 240. The interlayer insulating film 250 may be located between the gate electrode 240 and the source electrode 260 to insulate the gate electrode 240 from the source electrode 260 and between the gate electrode 240 and the drain electrode 270, to insulate the gate electrode 240 from the drain electrode 270.

The source electrode 260 and the drain electrode 270 may be located on the interlayer insulating film 250. The interlayer insulating film 250 and the gate insulating film 230 may be formed to expose a source region and a drain region of the active layer 220, and the source electrode 260 and the drain electrode 270 may respectively contact the exposed portions of the source region and the drain region of the active layer 220.

The TFT may be electrically connected to a light-emitting device to drive the light-emitting device, and may be covered and protected by a passivation layer 280. The passivation layer 280 may include an inorganic insulating film, an organic insulating film, or any combination thereof. A light-emitting device is provided on the passivation layer 280. The light-emitting device may include a first electrode 110, an interlayer 130, and a second electrode 150.

The first electrode 110 may be located on the passivation layer 280. The passivation layer 280 may expose a portion of the drain electrode 270, not fully covering the drain electrode 270, and the first electrode 110 may be electrically connected to the exposed portion of the drain electrode 270.

A pixel defining layer 290 including an insulating material may be located on the first electrode 110. The pixel defining layer 290 may expose a portion of the first electrode 110, and an interlayer 130 may be formed in the exposed portion of the first electrode 110. The pixel defining layer 290 may be a polyimide or polyacrylic organic film. Although not shown in FIG. 2, at least some layers of the interlayer 130 may extend beyond the upper portion of the pixel defining layer 290 to be provided in the form of a common layer.

A second electrode 150 may be located on the interlayer 130, and a second capping layer 170 may be further included on the second electrode 150. The second capping layer 170 may be formed to cover the second electrode 150.

The encapsulation portion 300 may be located on the second capping layer 170. The encapsulation portion 300 may be located on a light-emitting device to protect the light-emitting device from moisture and/or oxygen. The encapsulation portion 300 may include: an inorganic film including silicon nitride (SiNₓ), silicon oxide (SiOₓ), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, or the like), an epoxy-based resin (for example, aliphatic glycidyl ether (AGE), or the like), or any combination thereof; or any combination of the inorganic film and the organic film.

FIG. 3 is a schematic cross-sectional view of an electronic apparatus according to an embodiment.

The electronic apparatus (e.g., a light-emitting apparatus) of FIG. 3 may differ from the electronic apparatus of FIG. 2, at least in that a light-shielding pattern 500 and a functional region 400 are further included on the encapsulation portion 300. The functional region 400 may be a color filter area, a color conversion area, or a combination of the color filter area and the color conversion area. In an embodiment, the light-emitting device included in the electronic apparatus of FIG. 3 may be a tandem light-emitting device.

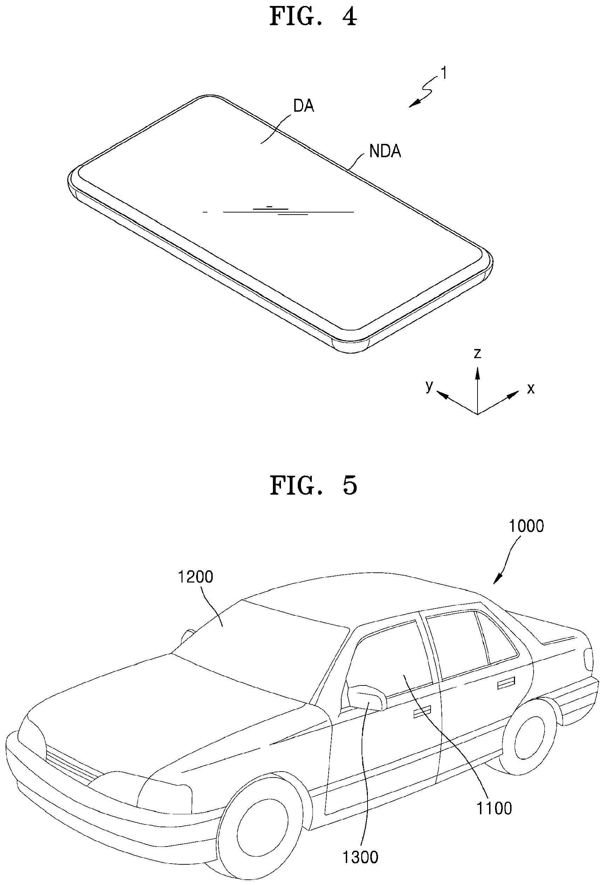

### [Description of FIG. 4]

FIG. 4 is a schematic perspective view of electronic apparatus 1 including a light-emitting device according to an embodiment. The electronic apparatus 1 may display a moving image or still image, and may be not only a portable electronic apparatus, such as a mobile phone, a smartphone, a tablet personal computer (PC), a mobile communication terminal, an electronic notebook, an electronic book, a portable multimedia player (PMP), a navigation, or an ultra mobile PC (UMPC), but may also be various products, such as a television, a laptop computer, a monitor, a billboards or an Internet of things (IOT). The electronic apparatus 1 may be such a product above or a part thereof. In an embodiment, the electronic apparatus 1 may be a wearable device, such as a smart watch, a watch phone, a glasses-type display, or a head mounted display (HMD), or a part of the wearable device. However, embodiments are not limited thereto.

For example, the electronic apparatus 1 may be a center information display (CID) on an instrument panel and a center fascia or dashboard of a vehicle, a room mirror display instead of a side mirror of a vehicle, an entertainment display for the rear seat of a car or a display placed on the back of the front seat, head up display (HUD) installed in front of a vehicle or projected on a front window glass, or a computer generated hologram augmented reality head up display (CGH AR HUD). FIG. 4 illustrates an embodiment in which the electronic apparatus 1 is a smartphone, for convenience of explanation.

The electronic apparatus 1 may include a display area DA and a non-display area NDA outside the display area DA. A display device may implement an image through a two-dimensional array of pixels that are arranged in the display area DA.

The non-display area NDA is an area that does not display an image, and may surround the display area DA. In an embodiment, in the non-display area NDA, a driver for providing electrical signals or power to display devices arranged on the display area DA may be arranged. In an embodiment, in the non-display area NDA, a pad, which is an area to which an electronic element or a printing circuit board may be electrically connected, may be arranged.

In the electronic apparatus 1, a length in an x-axis direction and a length in a y-axis direction may be different from each other. For example, as shown in FIG. 4, the length in the x-axis direction may be shorter than the length in the y-axis direction. In embodiments, the length in the x-axis direction may be the same as the length in the y-axis direction. In other embodiments, the length in the x-axis direction may be longer than the length in the y-axis direction.

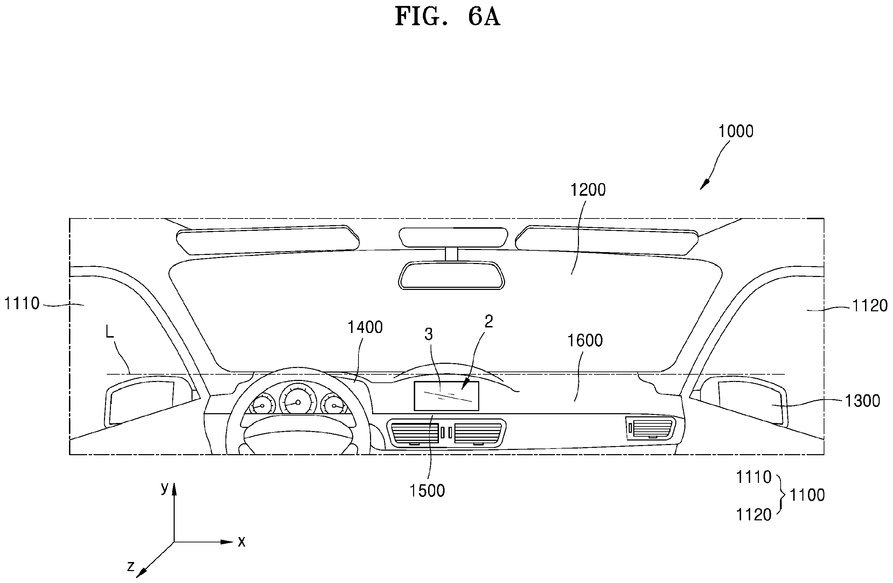

### [Descriptions of FIGS. 5 and 6A to 6C]

FIG. 5 is a schematic perspective view of an exterior of a vehicle 1000 as an electronic apparatus including a light-emitting device according to an embodiment.

FIGS. 6A to 6C are each a schematic diagram illustrating an interior of a vehicle 1000 according to embodiments.

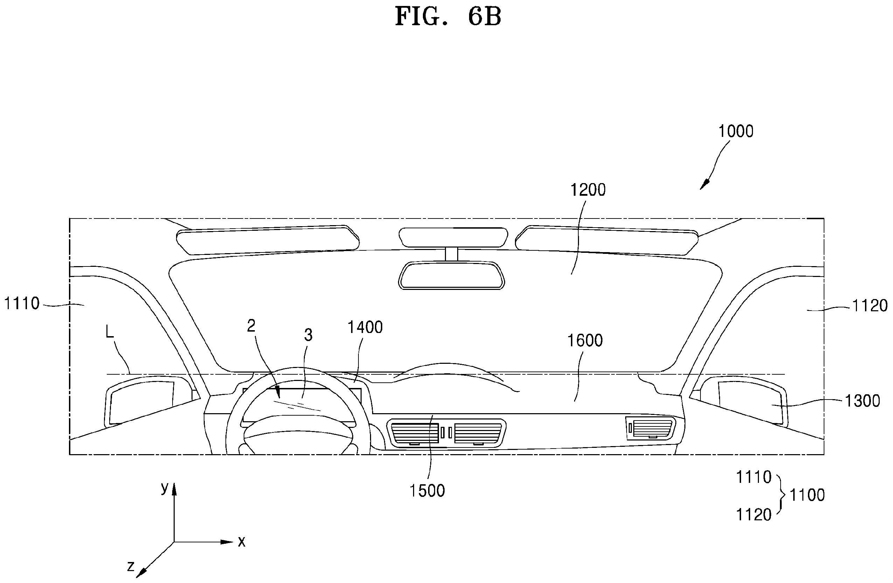

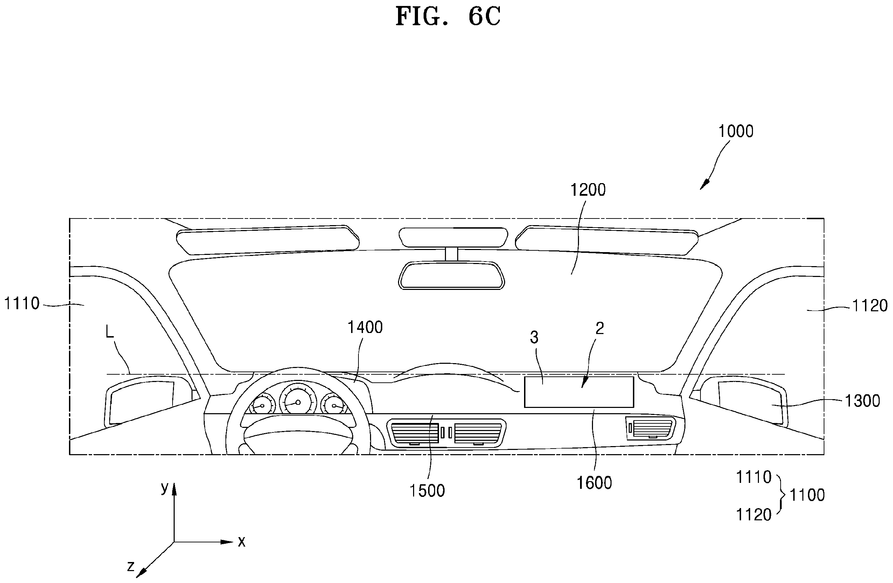

Referring to FIGS. 5, 6A, 6B, and 6C, the vehicle 1000 may refer to various apparatuses for moving a subject object to be transported, such as a person, an object, or an animal, from a departure point to a destination. Examples of the vehicle 1000 may include a vehicle traveling on a road or track, a vessel moving over a sea or river, an airplane flying in the sky using the action of air, and the like.

The vehicle 1000 may travel on a road or a track. The vehicle 1000 may move in a direction according to the rotation of at least one wheel. Examples of the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis that is a portion excluding the body in which mechanical apparatuses necessary for driving are installed. The exterior of the vehicle body may include a front panel, a bonnet, a roof panel, a rear panel, a trunk, a filler provided at a boundary between doors, and the like. The chassis of the vehicle 1000 may include a power generating device, a power transmitting device, a driving device, a steering device, a braking device, a suspension device, a transmission device, a fuel device, front, rear, left, and right wheels, and the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a filler arranged between the side window glass 1100 and the front window glass 1200.

The side window glass 1100 may be installed on the side of the vehicle 1000. In an embodiment, the side window glass 1100 may be installed in a door of the vehicle 1000. Multiple side window glasses 1100 may be provided and may face each other. In an embodiment, the side window glass 1100 may include a first side window glass 1110 and a second side window glass 1120. In an embodiment, the first side window glass 1110 may be arranged adjacent to the cluster 1400, and the second side window glass 1120 may be arranged adjacent to the passenger seat dashboard 1600.

In an embodiment, the side window glasses 1100 may be spaced apart from each other in an x-direction or in a -x-direction. For example, the first side window glass 1110 and the second side window glass 1120 may be spaced apart from each other in the x direction or in the -x direction. In other words, an imaginary straight line L connecting the side window glasses 1100 may extend in the x-direction or in the -x-direction. For example, an imaginary straight line L connecting the first side window glass 1110 and the second side window glass 1120 to each other may extend in the x direction or the in -x direction.

The front window glass 1200 may be installed on the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In one embodiment, multiple side mirrors 1300 may be provided. One of the side mirrors 1300 may be arranged outside the first side window glass 1110. Another one of the side mirrors 1300 may be arranged outside the second side window glass 1120.

The cluster 1400 may be arranged in front of a steering wheel. The cluster 1400 may include a tachometer, a speedometer, a coolant thermometer, a fuel gauge, a turn signal indicator, a high beam indicator, a warning lamp, a seat belt warning lamp, an odometer, a hodometer, an automatic shift selector indicator lamp, a door open warning lamp, an engine oil warning lamp, and/or a low fuel warning light.

The center fascia 1500 may include a control panel on which buttons for adjusting an audio device, an air conditioning device, and a seat heater are disposed. The center fascia 1500 may be arranged on a side of the cluster 1400.

A passenger seat dashboard 1600 may be spaced apart from the cluster 1400 with the center fascia 1500 arranged therebetween. In an embodiment, the cluster 1400 may be arranged to correspond to a driver seat (not shown), and the passenger seat dashboard 1600 may be disposed to correspond to a passenger seat (not shown). In an embodiment, the cluster 1400 may be adjacent to the first side window glass 1110, and the passenger seat dashboard 1600 may be adjacent to the second side window glass 1120.

In an embodiment, the display device 2 may include a display panel 3, and the display panel 3 may display an image. The display device 2 may be arranged inside the vehicle 1000. In an embodiment, the display device 2 may be arranged between the side window glasses 1100 facing each other. The display device 2 may be arranged in at least one of the cluster 1400, the center fascia 1500, and the passenger seat dashboard 1600.

The display device 2 may include an organic light-emitting display device, an inorganic electroluminescent (EL) display device, a quantum dot display device, or the like. Hereinafter, as the display device 2 according to an embodiment, an organic light-emitting display device display including the light-emitting device will be described as an example, but various types of display devices as described herein may be used as embodiments.

Referring to FIG. 6A, the display device 2 may be arranged in the center fascia 1500. In an embodiment, the display device 2 may display navigation information. In an embodiment, the display device 2 may display information regarding audio settings, video settings, or vehicle settings.

Referring to FIG. 6B, the display device 2 may be arranged in the cluster 1400. When the display device 2 is arranged in the cluster 1400, the cluster 1400 may display driving information and the like through the display device 2. For example, the cluster 1400 may digitally implement driving information. The digital cluster 1400 may digitally display vehicle information and driving information as images. For example, a needle and a gauge of a tachometer and various warning lights or icons may be displayed by a digital signal.

Referring to FIG. 6C, the display device 2 may be arranged in the dashboard 1600 of the passenger seat. The display device 2 may be embedded in the passenger seat dashboard 1600 or arranged on the passenger seat dashboard 1600. In an embodiment, the display device 2 arranged on the dashboard 1600 for the passenger seat may display an image related to information displayed on the cluster 1400 and/or information displayed on the center fascia 1500. In embodiments, the display device 2 arranged on the passenger seat dashboard 1600 may display information that is different from information displayed on the cluster 1400 and/or information displayed on the center fascia 1500.

### [Manufacturing method]

Respective layers included in the hole transport region 131, the emission layer 135, and respective layers included in the electron transport region may be formed in a selected region by using one or more suitable methods selected from vacuum deposition, spin coating, casting, Langmuir-Blodgett (LB) deposition, ink-jet printing, laser-printing, and laser-induced thermal imaging.

When layers constituting the hole transport region 131, an emission layer 135, and layers constituting the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### [Definitions of Terms]

The term "C₃-C₆₀ carbocyclic group" as used herein may be a cyclic group consisting of carbon atoms as the only ring-forming atoms and having three to sixty carbon atoms, and the term "C₁-C₆₀ heterocyclic group" as used herein may be a cyclic group that has one to sixty carbon atoms and further has, in addition to a carbon atom, at least one heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, a C₁-C₆₀ heterocyclic group has 3 to 61 ring-forming atoms.

The "cyclic group" as used herein may be a C₃-C₆₀ carbocyclic group or a C₁-C₆₀ heterocyclic group.

The term "π electron-rich C₃-C₆₀ cyclic group" as used herein may be a cyclic group that has three to sixty carbon atoms and may not include *-N=*' as a ring-forming moiety, and the term "π electron-deficient nitrogen-containing C₁-C₆₀ cyclic group" as used herein may be a heterocyclic group that has one to sixty carbon atoms and may include *-N=*' as a ring-forming moiety.

In an embodiment,
a C₃-C₆₀ carbocyclic group may be a T1 group or a group in which two or more T1 groups are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
a C₁-C₆₀ heterocyclic group may be a T2 group, a group in which two or more T2 groups are condensed with each other, or a group in which at least one T2 group and at least one T1 group are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
a π electron-rich C₃-C₆₀ cyclic group may be a T1 group, a group in which two or more T1 groups are condensed with each other, a T3 group, a group in which two or more T3 groups are condensed with each other, or a group in which at least one T3 group and at least one T1 group are condensed with each other (for example, a C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
a π electron-deficient nitrogen-containing C₁-C₆₀ cyclic group may be a T4 group, a group in which two or more T4 groups are condensed with each other, a group in which at least one T4 group and at least one T1 group are condensed with each other, a group in which at least one T4 group and at least one T3 group are condensed with each other, or a group in which at least one T4 group, at least one T1 group, and at least one T3 group are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
wherein the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the T3 group may be a furan group, a thiophene group, a 1H-pyrrole group, a silole group, or a borole group, and
the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms " cyclic group", "C₃-C₆₀ carbocyclic group", "C₁-C₆₀ heterocyclic group", "π electron-rich C₃-C₆₀ cyclic group", or "π electron-deficient nitrogen-containing C₁-C₆₀ cyclic group" as used herein may each be a group condensed to any cyclic group, a monovalent group, or a polyvalent group (for example, a divalent group, a trivalent group, a tetravalent group, etc.) according to the structure of a formula for which the corresponding term is used. For example, the "benzene group" may be a benzo group, a phenyl group, a phenylene group, or the like, which may be readily understood by one of ordinary skill in the art according to the structure of a formula including the "benzene group."

Examples of a monovalent C₃-C₆₀ carbocyclic group and a monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of a divalent C₃-C₆₀ carbocyclic group and a divalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as used herein may be a linear or branched aliphatic hydrocarbon monovalent group that has one to sixty carbon atoms, and specific examples thereof may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein may be a divalent group having a same structure as the C₁-C₆₀ alkyl group.

The term "C₂-C₆₀ alkenyl group" as used herein may be a monovalent hydrocarbon group having at least one carbon-carbon double bond in the middle or at a terminus of a C₂-C₆₀ alkyl group, and examples thereof may include an ethenyl group, a propenyl group, and a butenyl group. The term "C₂-C₆₀ alkenylene group" as used herein may be a divalent group having a same structure as the C₂-C₆₀ alkenyl group.

The term "C₂-C₆₀ alkynyl group" as used herein may be a monovalent hydrocarbon group having at least one carbon-carbon triple bond in the middle or at a terminus of a C₂-C₆₀ alkyl group, and examples thereof may include an ethynyl group and a propynyl group. The term "C₂-C₆₀ alkynylene group" as used herein may be a divalent group having a same structure as the C₂-C₆₀ alkynyl group.

The term "C₁-C₆₀ alkoxy group" as used herein may be a monovalent group represented by -O(A₁₀₁) (wherein A₁₀₁ may be a C₁-C₆₀ alkyl group), and examples thereof may include a methoxy group, an ethoxy group, and an isopropyloxy group.

The term "C₃-C₁₀ cycloalkyl group" as used herein may be a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group" as used herein may be a divalent group having a same structure as the C₃-C₁₀ cycloalkyl group.

The term "C₁-C₁₀ heterocycloalkyl group" as used herein may be a monovalent cyclic group of 1 to 10 carbon atoms, further including, in addition to carbon atoms, at least one heteroatom, as ring-forming atoms, and examples thereof may include a 1,2,3,4-oxatriazolidinyl group, a tetrahydrofuranyl group, and a tetrahydrothiophenyl group. The term "C₁-C₁₀ heterocycloalkylene group" as used herein may be a divalent group having a same structure as the C₁-C₁₀ heterocycloalkyl group.

The term "C₃-C₁₀ cycloalkenyl group" as used herein may be a monovalent cyclic group that has three to ten carbon atoms and at least one carbon-carbon double bond in the ring thereof and no aromaticity, and examples thereof may include a cyclopentenyl group, a cyclohexenyl group, and a cycloheptenyl group. The term "C₃-C₁₀ cycloalkenylene group" as used herein may be a divalent group having a same structure as the C₃-C₁₀ cycloalkenyl group.

The term "C₁-C₁₀ heterocycloalkenyl group" as used herein may be a monovalent cyclic group of 1 to 10 carbon atoms, further including, in addition to carbon atoms, at least one heteroatom, as ring-forming atoms, and having at least one carbon-carbon double bond in the cyclic structure thereof. Examples of a C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein may be a divalent group having a same structure as the C₁-C₁₀ heterocycloalkenyl group.

The term "C₆-C₆₀ aryl group" as used herein may be a monovalent group having a carbocyclic aromatic system of 6 to 60 carbon atoms, and the term "C₆-C₆₀ arylene group" as used herein may be a divalent group having a carbocyclic aromatic system of 6 to 60 carbon atoms. Examples of a C₆-C₆₀ aryl group may include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the respective rings may be condensed with each other.

The term "C₁-C₆₀ heteroaryl group" as used herein may be a monovalent group having a heterocyclic aromatic system of 1 to 60 carbon atoms, further including, in addition to carbon atoms, at least one heteroatom, as ring-forming atoms. The term "C₁-C₆₀ heteroarylene group" as used herein may be a divalent group having a heterocyclic aromatic system of 1 to 60 carbon atoms, further including, in addition to carbon atoms, at least one heteroatom, as ring-forming atoms. Examples of a C₁-C₆₀ heteroaryl group may include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the respective rings may be condensed with each other.

The term "monovalent non-aromatic condensed polycyclic group" as used herein may be a monovalent group (for example, having 8 to 60 carbon atoms) having two or more rings condensed to each other, only carbon atoms as ring-forming atoms, and no aromaticity in its entire molecular structure. Examples of a monovalent non-aromatic condensed polycyclic group may include an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as used herein may be a divalent group having a same structure as the monovalent non-aromatic condensed polycyclic group.

The term "monovalent non-aromatic condensed heteropolycyclic group" as used herein may be a monovalent group (for example, having 1 to 60 carbon atoms) having two or more rings condensed to each other, further including, in addition to carbon atoms, at least one heteroatom, as ring-forming atoms, and having no aromaticity in its entire molecular structure. Examples of a monovalent non-aromatic condensed heteropolycyclic group may include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein may be a divalent group having a same structure as the monovalent non-aromatic condensed heteropolycyclic group.

The term "C₆-C₆₀ aryloxy group" as used herein may be a group represented by -O(A₁₀₂) (wherein A₁₀₂ may be a C₆-C₆₀ aryl group), and the term "C₆-C₆₀ arylthio group" as used herein may be a group represented by -S(A₁₀₃) (wherein A₁₀₃ may be C₆-C₆₀ aryl group).

The term "C₇-C₆₀ aryl alkyl group" used herein may be a group represented by -(A₁₀₄)(A₁₀₅) (wherein A₁₀₄ may be a C₁-C₅₄ alkylene group, and A₁₀₅ may be a C₆-C₅₉ aryl group), and the term C₂-C₆₀ heteroaryl alkyl group" used herein may be a group represented by -(A₁₀₆)(A₁₀₇) (wherein A₁₀₆ may be a C₁-C₅₉ alkylene group, and A₁₀₇ may be a C₁-C₅₉ heteroaryl group).

In the specification, the group "R₁₀ₐ" may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

In the specification, Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

The term "heteroatom" as used herein may be any atom other than a carbon atom or a hydrogen atom. Examples of a heteroatom may include O, S, N, P, Si, B, Ge, Se, and any combinations thereof.

The term "third-row transition metal" used herein may be hafnium (Hf), tantalum (Ta), tungsten (W), rhenium (Re), osmium (Os), iridium (Ir), platinum (Pt), gold (Au), or the like.

The term "Ph" as used herein refers to a phenyl group, the term "Me" as used herein refers to a methyl group, the term "Et" as used herein refers to an ethyl group, the terms "ter-Bu" or "Bu^{t}" as used herein each refer to a tert-butyl group, and the term "OMe" as used herein refers to a methoxy group.

The term "biphenyl group" as used herein may be a " phenyl group substituted with a phenyl group." For example, the "biphenyl group" may be a substituted phenyl group having a C₆-C₆₀ aryl group as a substituent.

The term "terphenyl group" as used herein may be a " phenyl group substituted with a biphenyl group". For example, the "terphenyl group" may be a substituted phenyl group having, as a substituent, a C₆-C₆₀ aryl group substituted with a C₆-C₆₀ aryl group.

The symbols *, *', and *" as used herein, unless defined otherwise, each refer to a binding site to a neighboring atom in a corresponding formula or moiety.

Hereinafter, a light-emitting device according to embodiments will be described in detail with reference to the Examples.

### [Examples]

### Evaluation Example 1

According to the method shown in Table 1, the HOMO energy level, LUMO energy level, hole mobility, electron mobility, and/or triplet (T₁) energy of each of the compounds listed in Tables 2 to 8 were evaluated, and results obtained therefrom are shown in Tables 2 to 8.

**[Table 1]**

| | |
|---|---|
| HOMO energy level evaluation method | By using cyclic voltammetry (CV) (electrolyte: 0.1 M Bu₄NPF₆ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and from the oxidation onset of the graph, the HOMO energy level of each compound was calculated. |
| LUMO energy level evaluation method | By using cyclic voltammetry (CV) (electrolyte: 0.1 M Bu₄NPF₆ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and from the reduction onset of the graph, the LUMO energy level of each compound was calculated. |
| Method of evaluating hole mobility and electron mobility | The evaluation was performed using the space-charge-limited current (SCLC) method described in "Hole mobility of N,N'-bis(naphtanlen-1-yl)-N,N'-bis(phenyl)benzidine investigated by using space-charge-limited currents, 'Appl. Phys. Lett. 90, 203512 (2007)." |
| Triplet (T₁) energy | A mixture of 2-methyl-THF(2-MeTHF) and each compound (each compound was dissolved to a concentration of 10 mM in 3 mL of 2-MeTHF) was put into a quartz cell, which was placed in a cryostat containing liquid nitrogen (77 K)(Oxford, DN). The phosphorescent spectrum thereof was measured using a luminescence measuring instrument (PTI, Quanta Master 400), and the triplet energy level was measured from the peak wavelength of the phosphorescent spectrum. |

**[Table 2]**

| Third material | HOMO Energy level (eV) | LUMO Energy level (eV) | Hole mobility (cm²/Vs) | Electron mobility (cm²/Vs) |
|---|---|---|---|---|
| HT01 | -4.68 | -1.20 | 7.64 × 10⁻⁵ | 8.10 × 10⁻⁷ |
| HT02 | -4.69 | -1.22 | 2.40 × 10⁻⁴ | 7.86 × 10⁻⁶ |
| HT03 | -4.69 | -1.21 | 4.24 × 10⁻⁴ | 2.41 × 10⁻⁵ |
| HT04 | -4.69 | -1.10 | 1.14 × 10⁻⁴ | 1.38 × 10⁻⁶ |
| HT05 | -4.70 | -1.15 | 6.79 × 10⁻⁴ | 5.47 × 10⁻⁵ |
| HT06 | -4.70 | -1.03 | 2.14 × 10⁻⁴ | 3.73 × 10⁻⁶ |
| HT07 | -4.70 | -1.13 | 1.61 × 10⁻⁴ | 3.00 × 10⁻⁶ |
| HT08 | -4.71 | -1.19 | 8.27 × 10⁻⁴ | 7.97 × 10⁻⁵ |
| HT09 | -4.71 | -1.28 | 2.47 × 10⁻⁴ | 1.01 × 10⁻⁵ |
| HT10 | -4.72 | -1.11 | 4.74 × 10⁻⁴ | 2.11 × 10⁻⁵ |
| R-HT1 | -5.30 | -1.36 | 2.22 × 10⁻⁵ | 2.65 × 10⁻⁸ |
| HAT | -9.05 | -4.81 | 1.33 × 10⁻³ | 7.02 × 10⁻³ |
| 2-TNATA | -4.65 | -1.30 | 1.22 × 10⁻⁴ | 2.23 × 10⁻⁵ |
| NPB | -5.00 | -1.42 | 5.32 × 10⁻³ | 1.35 × 10⁻³ |

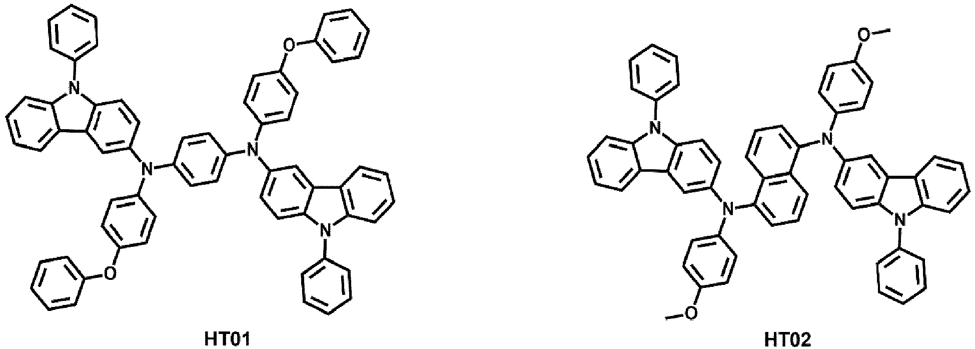

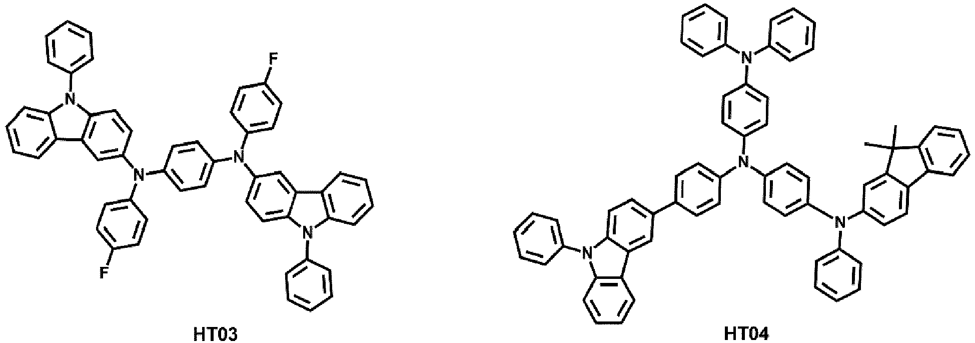

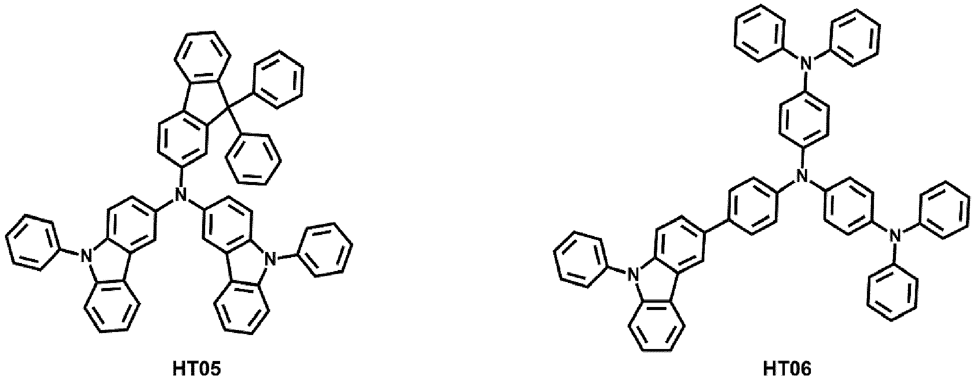

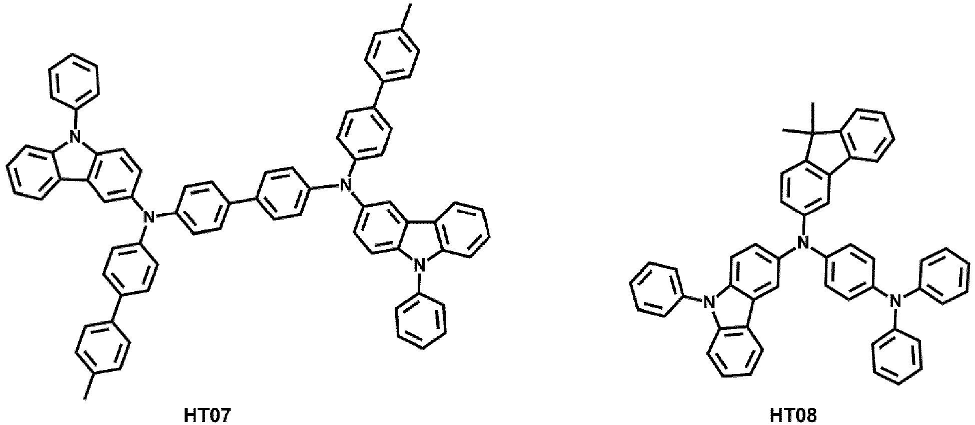

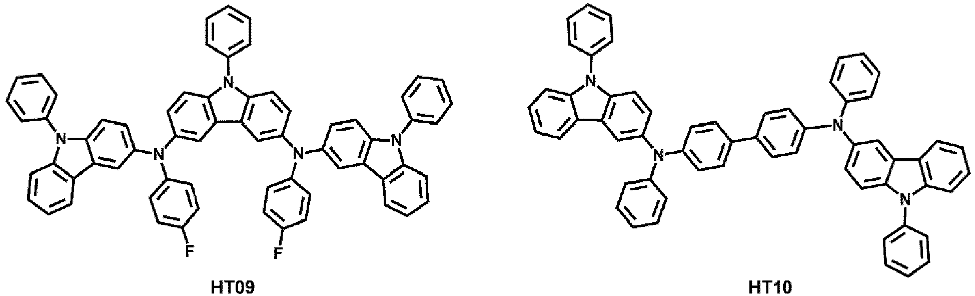

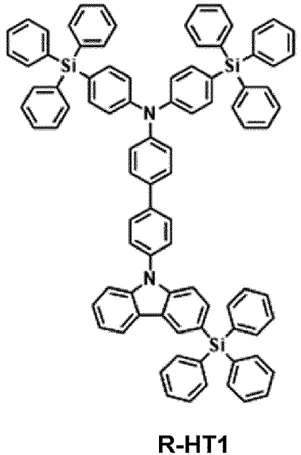

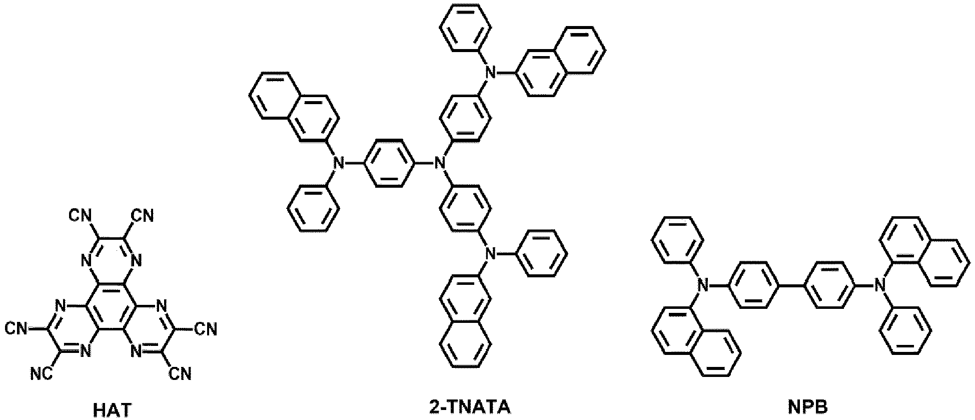

**[Table 3]**

| Second material | HOMO energy level (eV) | LUMO energy level (eV) | Hole mobility (cm²/Vs) | Electron mobility (cm²/Vs) |
|---|---|---|---|---|
| G'01 | -4.81 | -1.01 | 6.81 × 10⁻⁴ | 2.93 × 10⁻⁵ |
| G'02 | -4.81 | -1.19 | 7.54 × 10⁻⁴ | 4.77 × 10⁻⁵ |
| G'03 | -4.81 | -1.29 | 3.12 × 10⁻⁴ | 1.16 × 10⁻⁵ |
| G'04 | -4.81 | -1.27 | 2.31 × 10⁻⁴ | 6.94 × 10⁻⁶ |
| G'05 | -5.08 | -1.51 | 3.97 × 10⁻⁴ | 2.29 × 10⁻⁵ |
| G'06 | -5.08 | -1.51 | 9.86 × 10⁻⁴ | 1.43 × 10⁻⁴ |
| G'07 | -5.08 | -1.36 | 1.13 × 10⁻³ | 9.51 × 10⁻⁵ |
| G'08 | -5.08 | -1.51 | 2.68 × 10⁻⁴ | 1.00 × 10⁻⁵ |
| G'09 | -5.08 | -1.47 | 9.71 × 10⁻⁴ | 9.58 × 10⁻⁵ |
| G'10 | -5.08 | -1.36 | 9.23 × 10⁻⁴ | 5.59 × 10⁻⁵ |
| R-G'1 | -5.30 | -1.36 | 2.22 × 10⁻⁵ | 2.65 × 10⁻⁸ |
| NPB | -5.00 | -1.42 | 5.32 × 10⁻³ | 1.35 × 10⁻³ |
| R-G'2 | -5.06 | -1.20 | 3.44 × 10⁻³ | 4.41 × 10⁻³ |

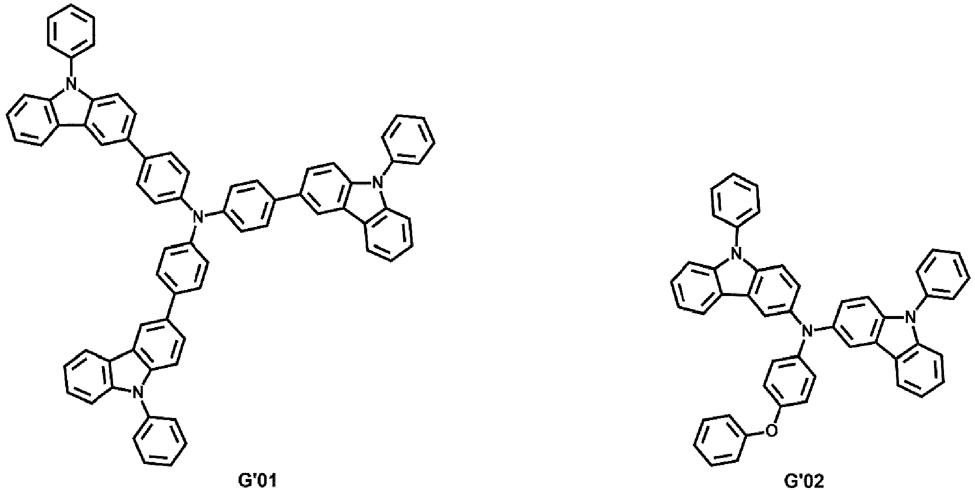

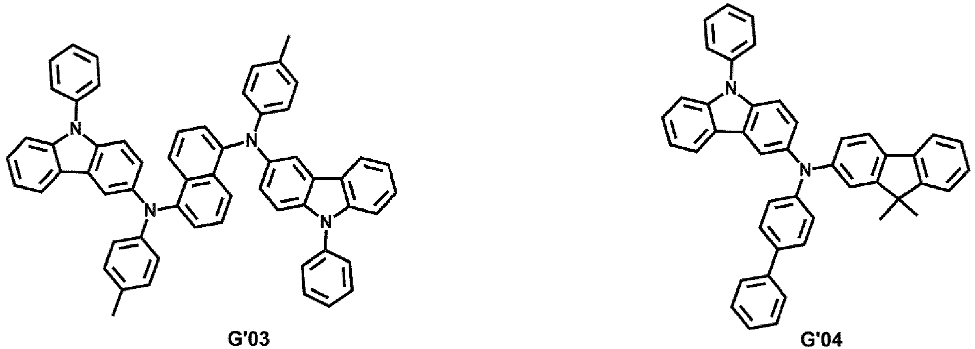

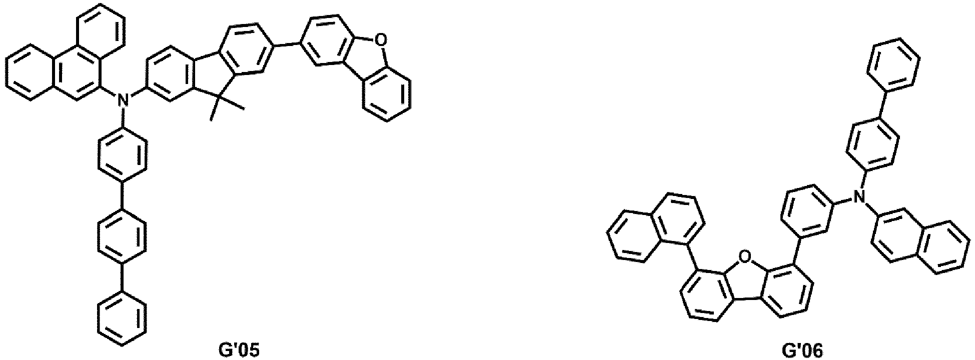

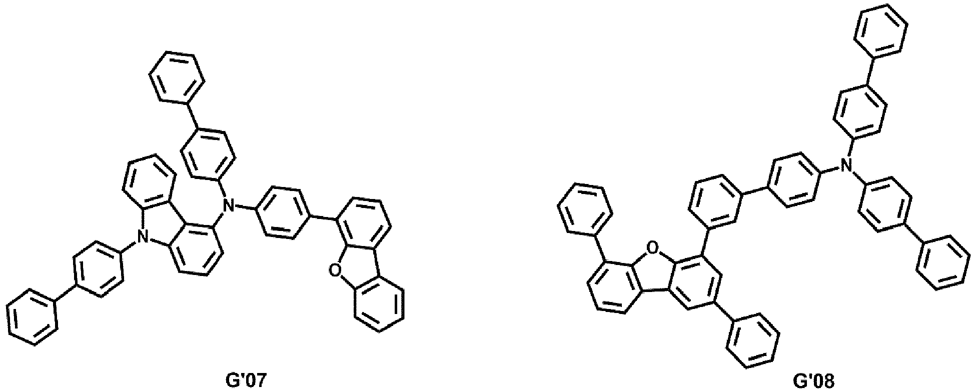

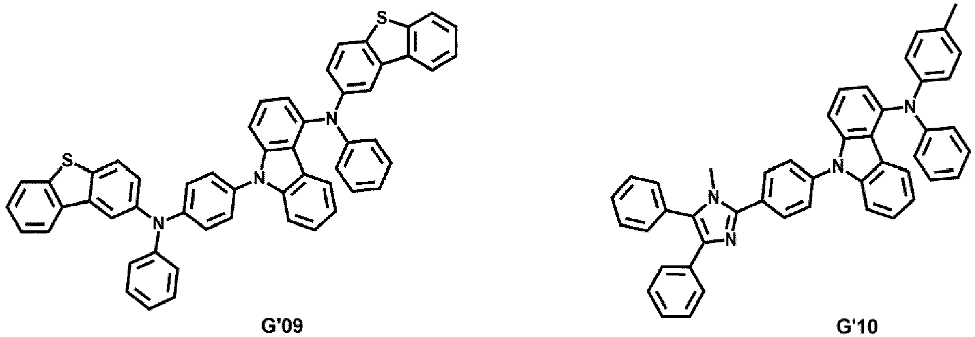

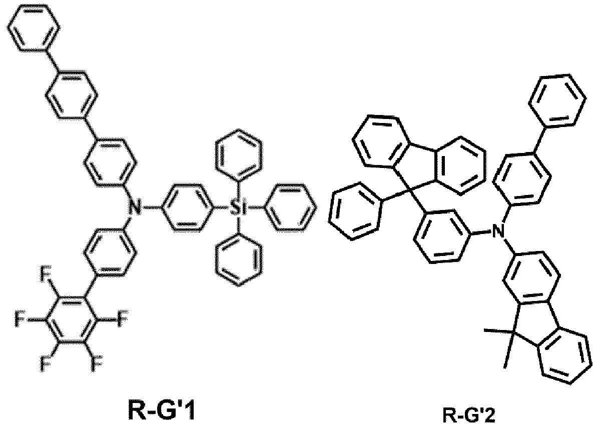

**[Table 4]**

| First material | HOMO Energy level (eV) | LUMO Energy level (eV) | Hole mobility (cm²/Vs) | Electron mobility (cm²/Vs) |
|---|---|---|---|---|
| GI01 | -4.94 | -1.33 | 1.41 × 10⁻⁴ | 2.45 × 10⁻⁶ |
| GI02 | -4.94 | -1.18 | 6.77 × 10⁻⁴ | 3.18 × 10⁻⁵ |
| GI03 | -4.94 | -1.24 | 1.58 × 10⁻⁴ | 2.36 × 10⁻⁶ |
| GI04 | -4.94 | -1.25 | 1.34 × 10⁻⁴ | 1.45 × 10⁻⁶ |
| GI05 | -4.94 | -1.64 | 4.46 × 10⁻⁴ | 5.87 × 10⁻⁵ |
| GI06 | -4.94 | -1.20 | 1.49 × 10⁻³ | 1.64 × 10⁻⁴ |
| GI07 | -4.94 | -1.63 | 1.73 × 10⁻⁴ | 8.20 × 10⁻⁶ |
| GI08 | -4.94 | -1.65 | 9.69 × 10⁻⁴ | 2.24 × 10⁻⁴ |
| GI09 | -4.94 | -1.59 | 1.06 × 10⁻³ | 2.36 × 10⁻⁴ |
| R-GI1 | -5.52 | -1.73 | 6.52 × 10⁻³ | 4.79 × 10⁻³ |
| R-GI2 | -4.98 | -1.30 | 5.23 × 10⁻³ | 2.17 × 10⁻² |
| R-GI3 | -5.14 | -1.26 | 3.56 × 10⁻³ | 5.15 × 10⁻³ |

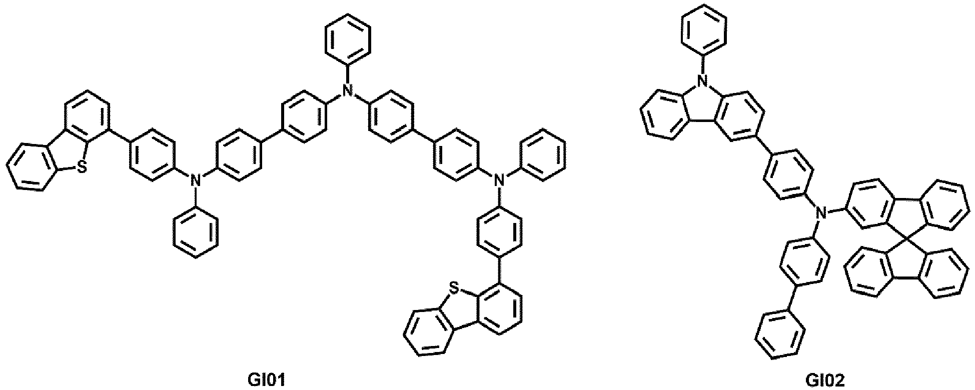

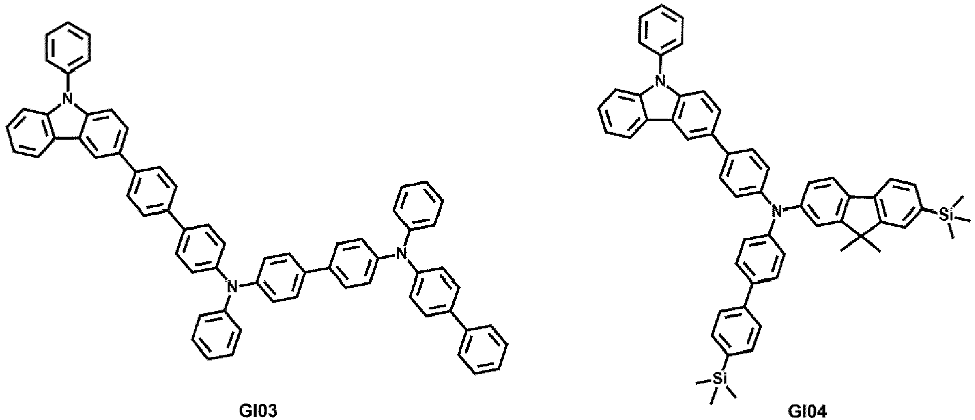

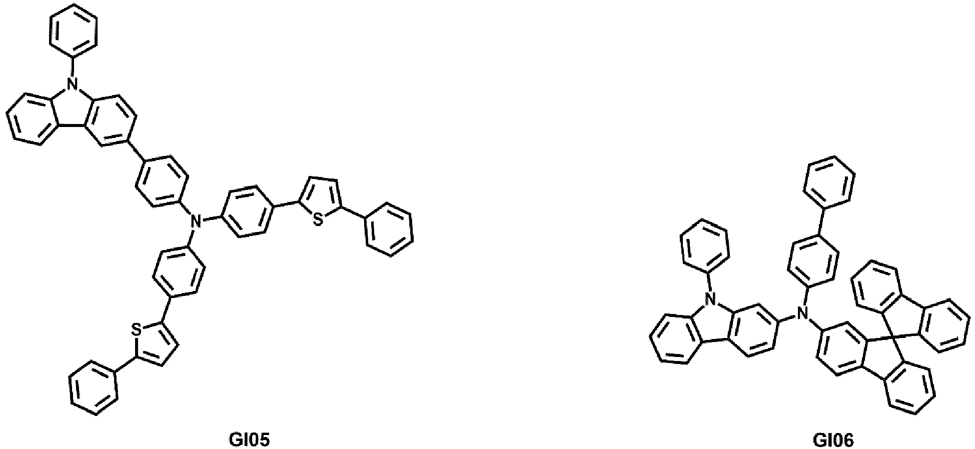

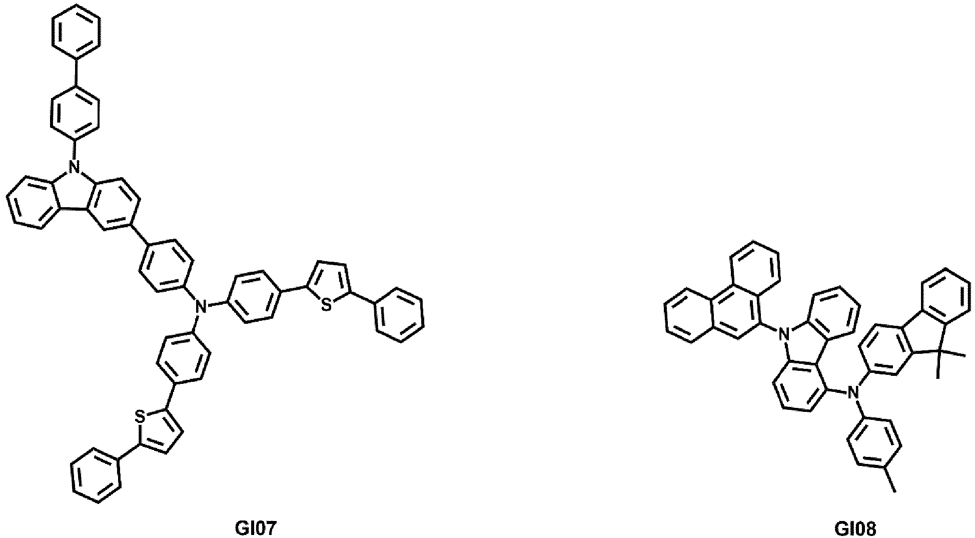

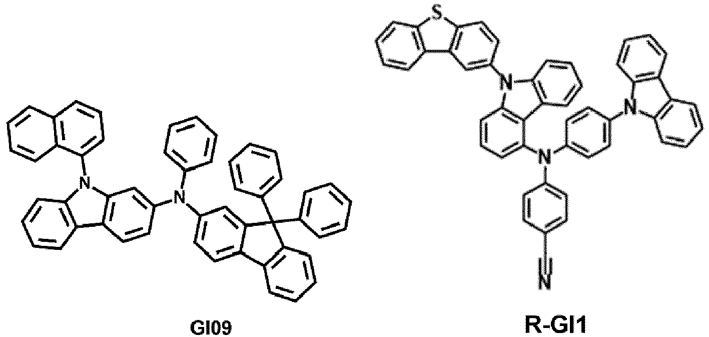

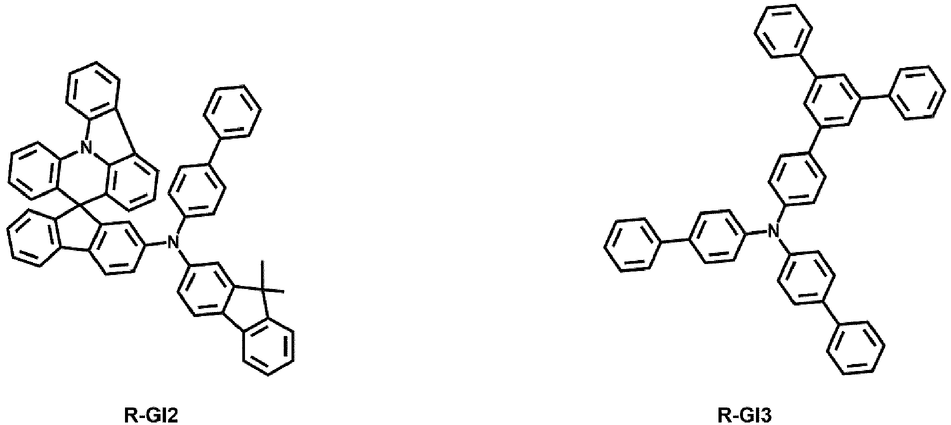

**[Table 5]**

| First host | HOMO Energy level (eV) | LUMO Energy level (eV) | Hole mobility (cm²/Vs) | Electron mobility (cm²/Vs) |
|---|---|---|---|---|
| Host1 | -4.97 | -2.04 | 2.42 × 10⁻³ | 4.37 × 10⁻⁵ |
| Host2 | -4.84 | -2.08 | 2.33 × 10⁻³ | 5.24 × 10⁻⁵ |
| Host3 | -4.88 | -2.05 | 5.83 × 10⁻⁴ | 2.95 × 10⁻⁶ |
| Host4 | -4.89 | -2.12 | 2.43 × 10⁻³ | 5.47 × 10⁻⁵ |
| R-Host1 | -5.14 | -1.34 | 4.53 × 10⁻⁵ | 2.50 × 10⁻⁷ |
| R-Host2 | -5.36 | -2.27 | 1.77 × 10⁻⁴ | 5.53 × 10⁻⁴ |
| R-Host3 | -5.23 | -1.25 | 1.03 × 10⁻³ | 7.01 × 10⁻⁵ |
| CBP | -5.59 | -1.53 | 1.03 × 10⁻³ | 2.34 × 10⁻⁵ |

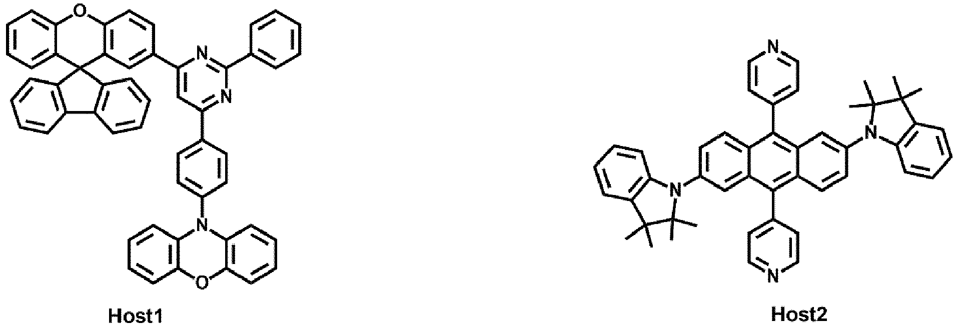

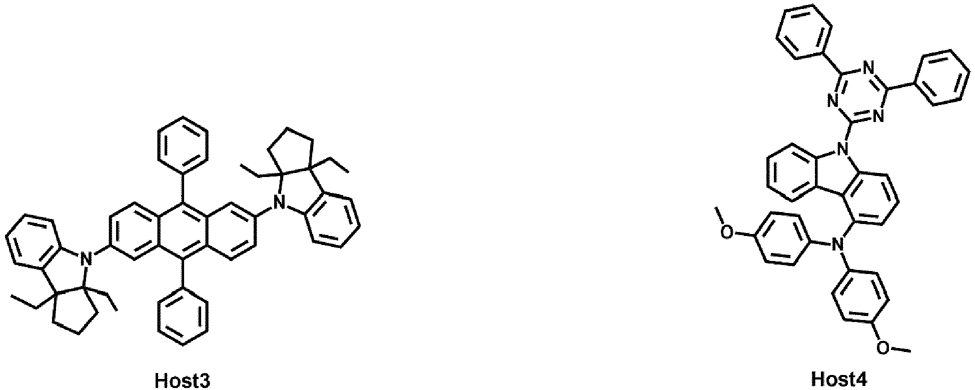

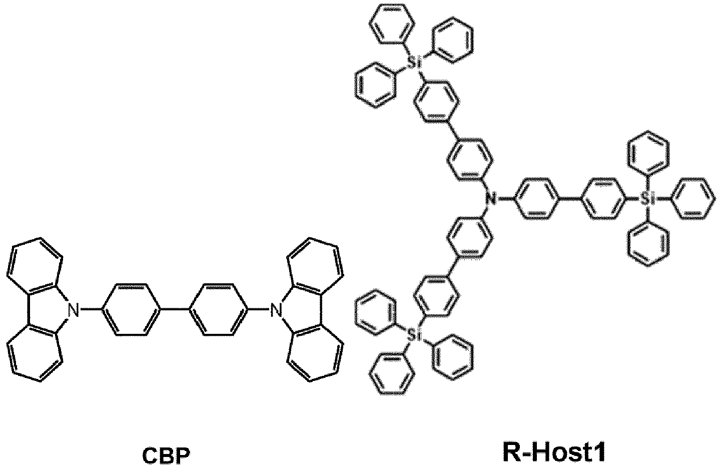

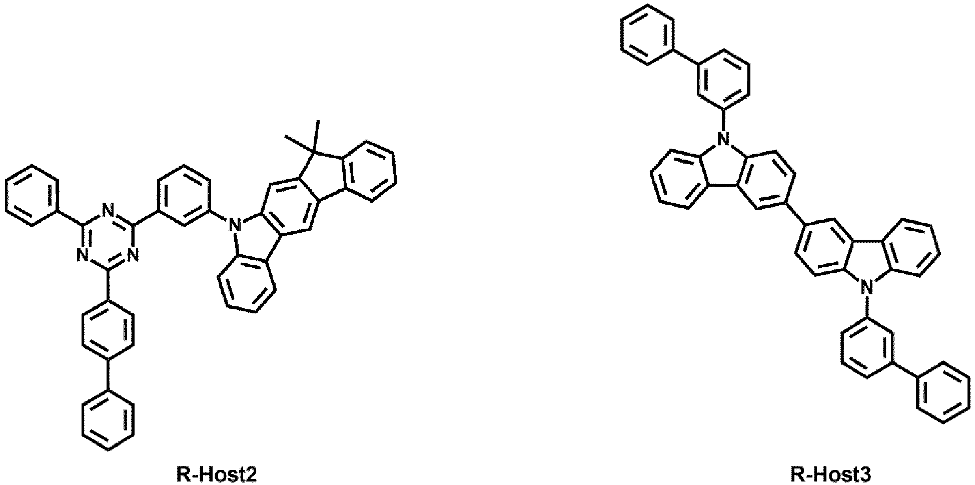

**[Table 6]**

| First emitter | HOMO Energy level (eV) | LUMO Energy level (eV) | T₁ energy (eV) |
|---|---|---|---|
| GD01 | -4.98 | -2.03 | 2.38 |
| GD02 | -5.20 | -2.10 | 2.23 |
| GD03 | -5.45 | -2.09 | 2.47 |
| GD04 | -5.36 | -2.11 | 2.35 |
| GD05 | -5.35 | -2.11 | 2.35 |
| R-GD1 (Ir(ppy)3) | -4.93 | -1.52 | 2.34 |
| GD24 | -4.95 | -1.60 | 2.33 |
| GD25 | -4.89 | -1.59 | 2.30 |

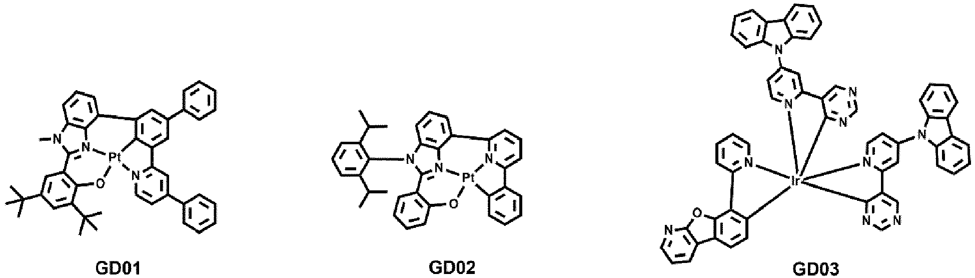

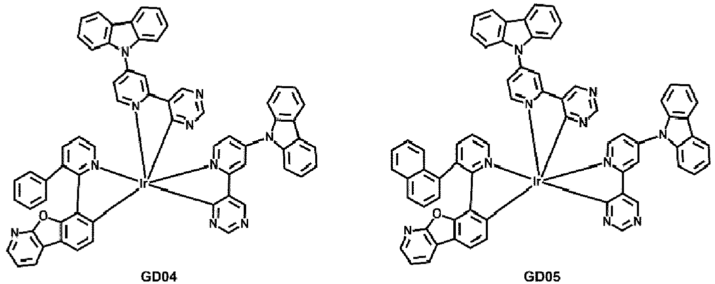

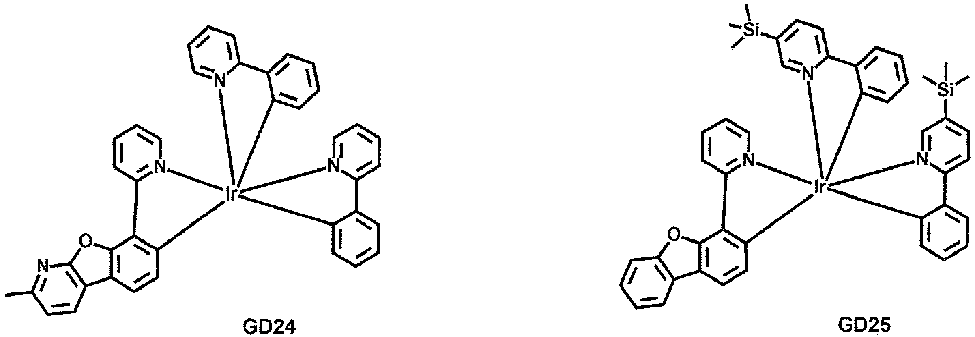

**[Table 7]**

| Material for buffer layer | HOMO Energy level (eV) | LUMO Energy level (eV) | Hole mobility (cm²/Vs) | Electron mobility (cm²/Vs) |
|---|---|---|---|---|
| BF01 | -5.75 | -2.38 | 3.46 × 10⁻³ | 1.78 × 10⁻³ |
| BF02 | -6.07 | -2.36 | 6.11 × 10⁻³ | 3.54 × 10⁻³ |
| BF03 | -6.01 | -2.24 | 3.06 × 10⁻³ | 7.73 × 10⁻⁴ |
| BF04 | -4.87 | -2.24 | 1.43 × 10⁻³ | 2.83 × 10⁻³ |
| BF05 | -6.17 | -2.24 | 3.22 × 10⁻³ | 1.04 × 10⁻³ |
| BF06 | -6.07 | -2.24 | 2.91 × 10⁻³ | 5.37 × 10⁻⁴ |
| BF07 | -5.98 | -2.24 | 7.11 × 10⁻³ | 4.33 × 10⁻³ |
| BF08 | -6.36 | -2.24 | 3.96 × 10⁻³ | 4.32 × 10⁻⁴ |
| BF09 | -5.94 | -2.24 | 1.91 × 10⁻³ | 3.03 × 10⁻⁴ |
| BF10 | -5.93 | -2.24 | 1.97 × 10⁻³ | 3.27 × 10⁻⁴ |
| R-BF1 | -5.36 | -1.93 | 3.61 × 10⁻⁴ | 2.34 × 10⁻⁵ |
| R-BF2 | -5.69 | -2.02 | 1.35 × 10⁻¹ | 1.12 × 10⁻² |
| BAlq | -5.17 | -2.25 | 4.42 × 10⁻⁷ | 2.57 × 10⁻⁵ |

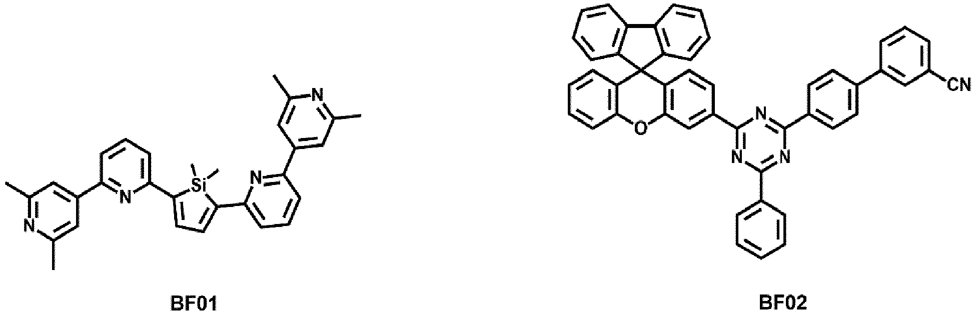

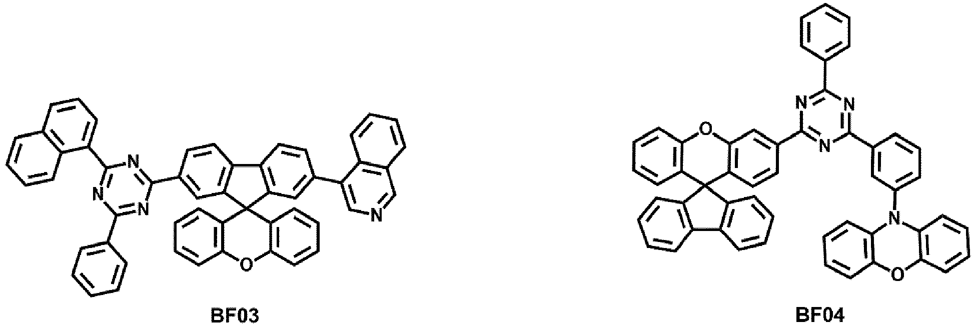

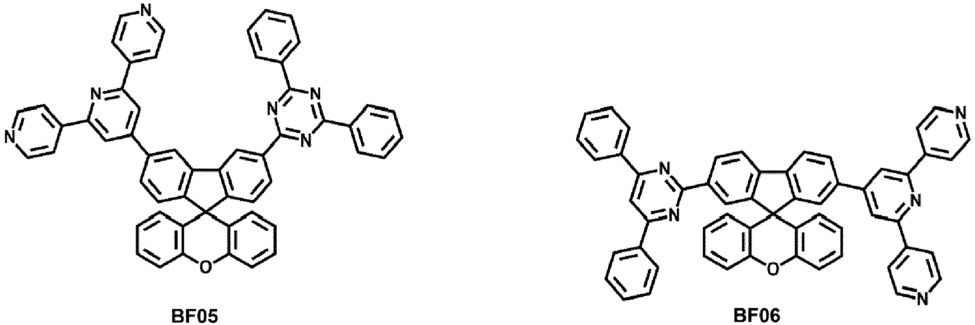

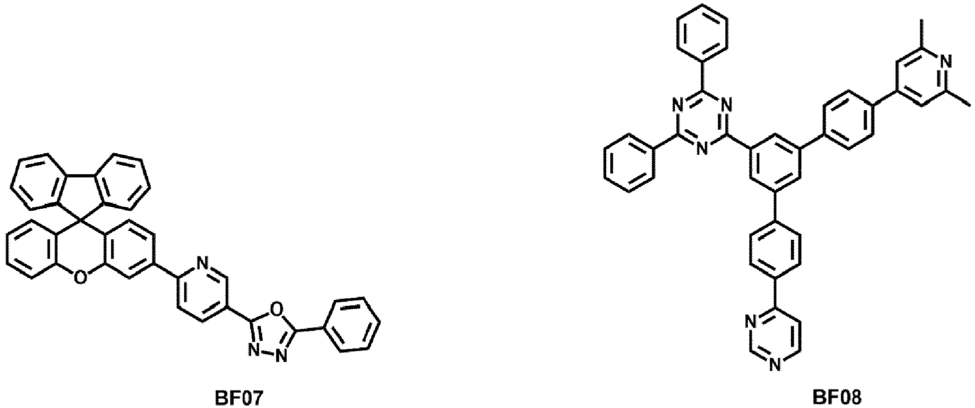

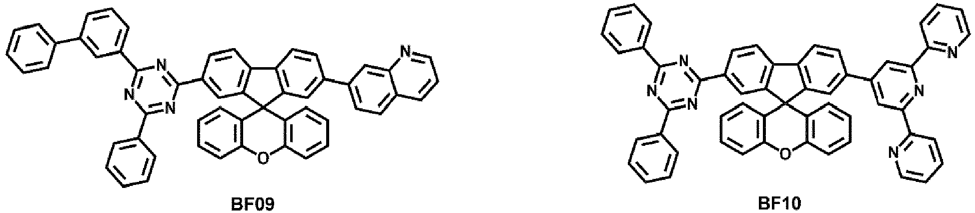

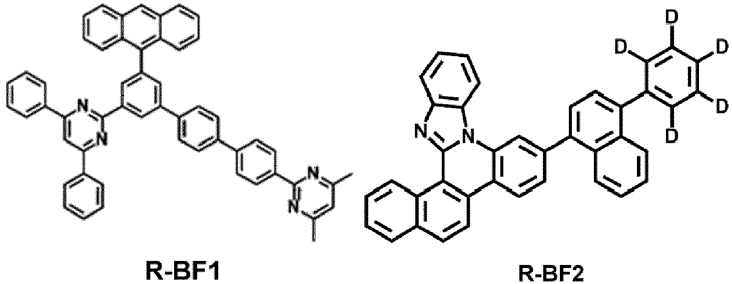

**[Table 8]**

| Material for electron transport layer | HOMO energy level (eV) | LUMO energy level (eV) | Hole mobility (cm²/Vs) | Electron mobility (cm²/Vs) |
|---|---|---|---|---|
| ET01 | -6.14 | -2.35 | 2.86 × 10⁻³ | 7.58 × 10⁻⁴ |
| ET02 | -5.72 | -2.34 | 8.46 × 10⁻⁴ | 1.16 × 10⁻⁴ |
| ET03 | -5.92 | -2.35 | 2.74 × 10⁻³ | 7.98 × 10⁻⁴ |
| ET04 | -5.85 | -2.32 | 2.43 × 10⁻³ | 1.17 × 10⁻³ |
| ET05 | -5.90 | -2.31 | 2.08 × 10⁻³ | 7.05 × 10⁻⁴ |
| ET06 | -5.95 | -2.30 | 2.72 × 10⁻³ | 1.02 × 10⁻³ |
| ET07 | -5.87 | -2.29 | 2.22 × 10⁻³ | 1.12 × 10⁻³ |
| ET08 | -5.75 | -2.28 | 2.09 × 10⁻³ | 9.94 × 10⁻⁴ |
| ET09 | -5.95 | -2.28 | 3.27 × 10⁻³ | 1.35 × 10⁻³ |
| ET10 | -5.86 | -2.28 | 2.39 × 10⁻³ | 8.64 × 10⁻⁴ |
| R-ET1 | -6.18 | -1.70 | 3.00 × 10⁻³ | 6.68 × 10⁻⁵ |
| R-ET2 | -6.62 | -2.44 | 3.47 × 10⁻⁴ | 6.83 × 10⁻⁴ |
| BeBq₂ | -5.28 | -1.98 | 3.62 × 10⁻³ | 1.77 × 10⁻⁵ |

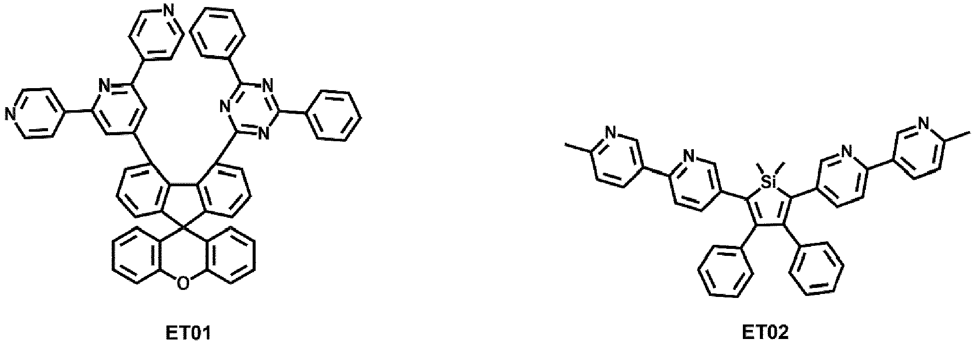

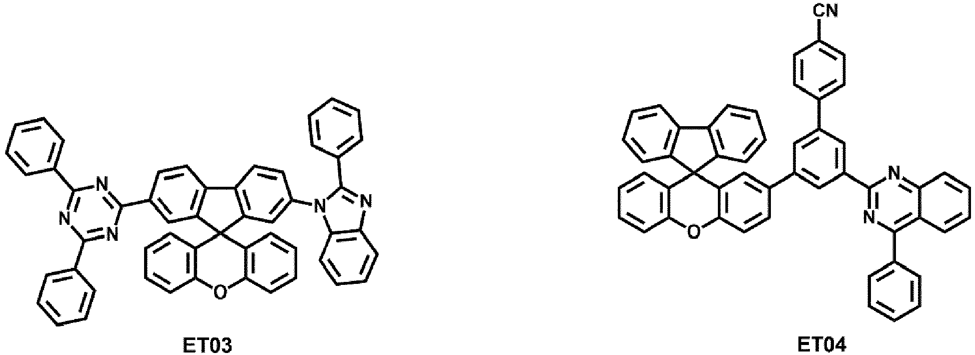

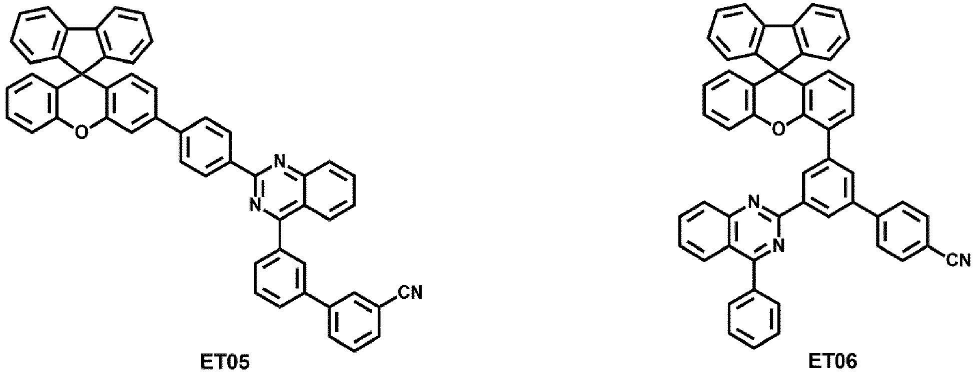

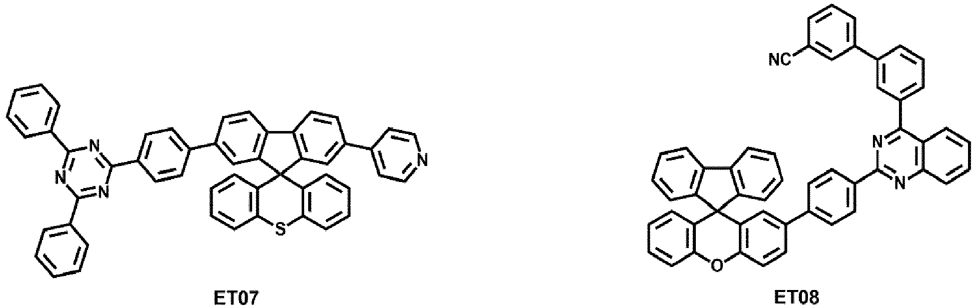

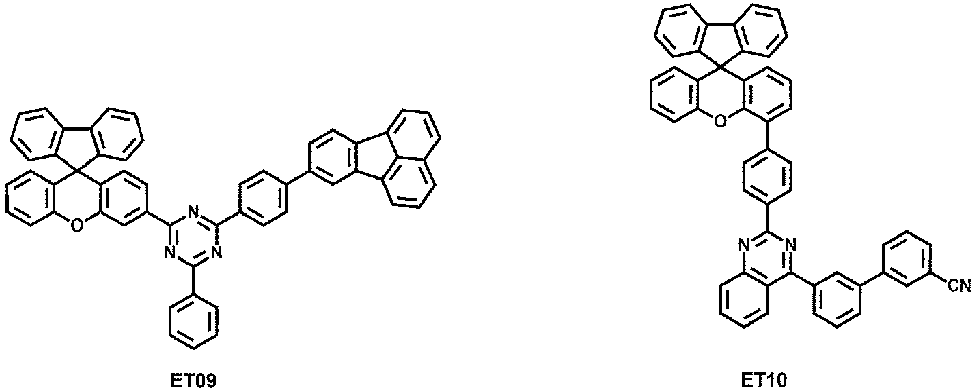

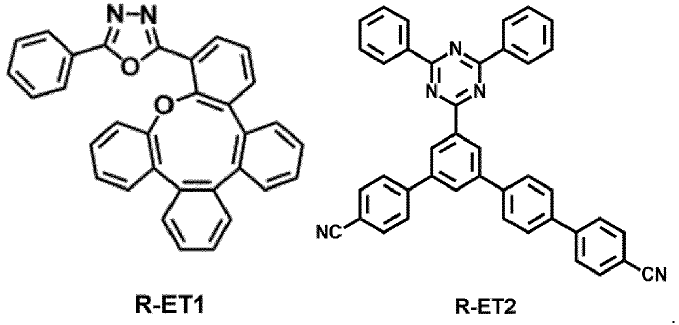

### Evaluation Example 2

PMMA and Compound GD01 (4 wt% compared to PMMA) were mixed with each other in CH₂Cl₂ solution, and the resultant obtained therefrom was coated on a quartz substrate using a spin coater, heat-treated in an oven at 80 °C, and cooled to room temperature, thereby obtaining Film GD01 having a thickness of 40 nm. Films GD02 to GD05, R-GD1, GD24, and GD25 were manufactured in the same method as used to manufacture Film GD01, except that Compounds GD02 to GD05, R-GD1, GD24, and GD25 were each used instead of Compound GD01.

For each of Films GD01 to GD05, R-GD1, GD24, and GD25, the luminescence spectrum was measured by a Quantaurus-QY Absolute PL quantum yield spectrometer manufactured by Hamamatsu Company (equipped with a xenon light source, a monochromator, a photonic multichannel analyzer, and an integrating sphere, and using photoluminescence quantum yield (PLQY) measurement software (Hamamatsu Photonics, Ltd., Shizuoka, Japan)). During measurement, the excitation wavelength was scanned from 320 nm to 380 nm at 10 nm intervals, and the spectrum measured at the excitation wavelength of 340 nm was used to obtain the maximum emission wavelength (emission peak wavelength) of the compound included in each film. Results thereof are shown in Table 9.

**[Table 9]**

| Film no. | Compound included in film (4 wt% in PMMA) | Maximum emission wavelength (nm) |
|---|---|---|
| GD01 | GD01 | 526 |
| GD02 | GD02 | 543 |
| GD03 | GD03 | 502 |
| GD04 | GD04 | 528 |
| GD05 | GD05 | 527 |
| R-GD1 | R-GD1 (Ir(ppy)3) | 530 |
| GD24 | GD24 | 532 |
| GD25 | GD25 | 539 |

### Example 1

A glass substrate (product of Corning Inc.) with a 15 Ω/cm² (1,200 Å) ITO formed thereon as an anode was cut to a size of 50 mm × 50 mm × 0.7 mm, sonicated using isopropyl alcohol and pure water each for 5 minutes, cleaned by irradiation of ultraviolet rays and exposure of ozone thereto for 30 minutes, and mounted on a vacuum deposition apparatus.

A third material (HT01) was vacuum-deposited on the anode to form a third layer having a thickness of 1,300 Å, and a second material (G'01) was vacuum-deposited on the third layer to form a second layer having a thickness of 250 Å, and a first material (GI01) was vacuum-deposited on the second layer to form a first layer having a thickness of 50 Å.

On the first layer, a first host (Host1) and a first emitter (GD01) were vacuum-deposited at a weight ratio of 93:7 to form an emission layer having a thickness of 400 Å.

A buffer layer material (BF03) was vacuum-deposited on the emission layer to form a buffer layer having a thickness of 50 Å, and an electron transport layer material (ET02) was vacuum-deposited on the buffer layer to form an electron transport layer having a thickness of 310 Å. Yb was vacuum-deposited on the electron transport layer to form an electron injection layer having a thickness of 15 Å, Ag and Mg were vacuum-deposited to form a cathode having a thickness of 800 Å, and Compound CP7 was vacuum-deposited on the cathode to form a capping layer having a thickness of 600 Å.

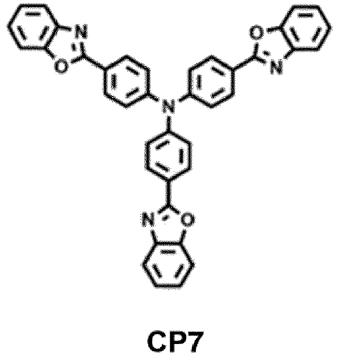

### Examples 2 to 10 and Comparative Examples 1, 2, and 4

Organic light-emitting devices were manufactured in the same manner as in Example 1, except that the compounds listed in Table 10 were used as a third material, a second material, a first material, a first host, a first emitter, a buffer layer material, and an electron transport layer material.

### Comparative Example 3

An organic light-emitting device was manufactured in the same method as in Comparative Example 2, except that a mixture of the compounds listed in Table 10 (weight ratio of 1:1) was used as the first host when forming the emission layer.

### Comparative Example 5

An organic light-emitting device was manufactured in the same method as in Comparative Example 4, except that a mixture of the compounds listed in Table 10 (weight ratio of 1:1) was used as the first host when forming the emission layer.

### Comparative Example 6

An organic light-emitting device was manufactured in the same manner as in Example 1, except that as the third layer, a 650 A-thick 2-TNATA layer and a 650 Å-thick NPB layer were sequentially formed using a vacuum deposition method, and the second material, the first material, the first host, the first emitter, the buffer layer material, and the electron transport layer material listed in Table 10 were used.

### Evaluation Example 3

The driving voltage, maximum power efficiency, and maximum emission wavelength of the electroluminescent (EL) spectrum of each of the organic light-emitting devices manufactured according to Examples 1 to 10 and Comparative Example 1 to 6 were measured using Keithley MU 236 and a luminance meter (Minolta Cs-1000A). Results thereof are summarized in Table 11, respectively. On the other hand, the numbers in parentheses in Table 10 represent the HOMO energy level (eV) values of corresponding compounds.

**[Table 10]**

| | Third material | Second material | First material | First host | | First emitter | Buffer layer material | Electron transport layer material |
|---|---|---|---|---|---|---|---|---|
| Example 1 | HT01 | G'01 | GI01 (-4.94) | Host1 (-4.97) | | GD01 (-4.98) | BF03 | ET02 |
| Example 2 | HT01 | G'02 | GI02 (-4.94) | Host1 (-4.97) | | GD02 (-5.20) | BF04 | ET03 |
| Example 3 | HT02 | G'03 | GI03 (-4.94) | Host2 (-4.84) | | GD03 (-5.45) | BF01 | ET01 |
| Example 4 | HT02 | G'04 | GI04 (-4.94) | Host2 (-4.84) | | GD04 (-5.36) | BF02 | ET01 |
| Example 5 | HT03 | G'05 | GI05 (-4.94) | Host3 (-4.88) | | GD05 (-5.35) | BF05 | ET04 |
| Example 6 | HT04 | G'06 | GI06 (-4.94) | Host3 (-4.88) | | GD01 (-4.98) | BF06 | ET05 |
| Example 7 | HT05 | G'07 | GI07 (-4.94) | Host3 (-4.88) | | GD02 (-5.20) | BF07 | ET01 |
| Example 8 | HT05 | G'01 | GI08 (-4.94) | Host4 (-4.89) | | GD03 (-5.45) | BF08 | ET01 |
| Example 9 | HT06 | G'02 | GI09 (-4.94) | Host4 (-4.89) | | GD04 (-5.36) | BF09 | ET07 |
| Example 10 | HT07 | G'09 | GI10 (-4.94) | Host4 (-4.89) | | GD05 (-5.35) | BF10 | ET01 |
| Comparative Example 1 | R-HT1 | R-G'1 | R-GI1 (-5.52) | R-Host1 (-5.14) | | R-GD1 (-4.93) | R-BF1 | R-ET1 |
| Comparative Example 2 | HAT | NPB | R-GI2 (-4.98) | R-Host2 (-5.36) | | R-GD2 (-4.95) | R-BF2 | R-ET2 |
| Comparative Example 3 | HAT | NPB | R-GI2 (-4.98) | R-Host2 (-5.36) | R-Host3 (-5.23) | R-GD2 (-4.95) | R-BF2 | R-ET2 |
| Comparative Example 4 | HAT | NPB | R-GI2 (-4.98) | R-Host2 (-5.36) | | R-GD3 (-4.89) | R-BF2 | R-ET2 |
| Comparative Example 5 | HAT | NPB | R-GI2 (-4.98) | R-Host2 (-5.36) | R-Host3 (-5.23) | R-GD3 (-4.89) | R-BF2 | R-ET2 |
| Comparative Example 6 | 2-TNATA | NPB | R-G'2 | R-GI3 (-5.14) | CBP (-5.59) | Ir(ppy)3 (-4.93) | BAlq | BeBq₂ |

**[Table 11]**

| | Driving voltage (V) | Maximum power efficiency (cd/W) | Maximum emission wavelength (nm) |
|---|---|---|---|
| Example 1 | 3.42 | 58.94 | 530 |
| Example 2 | 3.49 | 58.93 | 546 |
| Example 3 | 3.52 | 58.86 | 508 |
| Example 4 | 3.60 | 58.20 | 530 |
| Example 5 | 3.37 | 58.18 | 533 |
| Example 6 | 3.31 | 58.00 | 529 |
| Example 7 | 3.41 | 57.85 | 541 |
| Example 8 | 3.53 | 57.59 | 508 |
| Example 9 | 3.60 | 57.51 | 531 |
| Example 10 | 3.48 | 57.39 | 535 |
| Comparative Example 1 | 3.59 | 45.89 | 525 |
| Comparative Example 2 | 3.6 | 50.48 | 537 |
| Comparative Example 3 | 3.57 | 52.44 | 532 |
| Comparative Example 4 | 3.62 | 48.40 | 542 |
| Comparative Example 5 | 3.59 | 51.23 | 539 |
| Comparative Example 6 | 3.57 | 48.18 | 530 |

From Table 11, it can be confirmed that the driving voltage and maximum power efficiency of Examples 1 to 10 are improved compared to the driving voltage and maximum power efficiency of Comparative Examples 1 to 6.

As discussed, embodiments may provide a light-emitting device comprising: a first electrode; a second electrode facing the first electrode; and an interlayer disposed between the first electrode and the second electrode, wherein the interlayer includes a hole transport region and an emission layer, the hole transport region is disposed between the first electrode and the emission layer, the hole transport region includes a first layer, the first layer directly contacts the emission layer, the emission layer includes a first host and a first emitter, the first emitter is arranged to emit first light having a first emission spectrum, the first layer includes a first material, an absolute value of a difference between a highest occupied molecular orbital, HOMO, energy level of the first material and a HOMO energy level of the first host is in a range of about 0 eV to about 0.20 eV, an absolute value of a HOMO energy level of the first emitter is greater than an absolute value of the HOMO energy level of the first host, and the HOMO energy level of each of the first material, the first host, and the first emitter is a negative value measured by cyclic voltammetry.

The hole transport region may further comprise a second layer and a third layer, the second layer is disposed between the first electrode and the first layer, the third layer is disposed between the first electrode and the second layer, the second layer includes a second material, the third layer includes a third material, and the first material, the second material, and the third material are different from each other.

The hole transport region may comprise a compound represented by Formula 201 (as shown above), a compound represented by Formula 202 (as shown above), or any combination thereof.

The first material, the second material, and the third material described in the specification may each be a compound that satisfies conditions as described in the specification (for example, the highest occupied molecular orbital (HOMO) energy level conditions, etc.) among the compounds represented by Formula 201 (as shown above) and the compounds represented by Formula 202 (as shown above).

In some embodiments, the hole transport region further includes a p-dopant. The p-dopant may include a quinone derivative, a cyano group-containing compound, a compound including element EL1 and element EL2, or any combination thereof. Examples of the quinone derivative may include TCNQ, F4-TCNQ, etc. Examples of the cyano group-containing compound may include HAT-CN (or HAT), a compound represented by Formula 221 (as shown above).

In some embodiments, the light-emitting device further comprises at least one of a first capping layer outside the first electrode and a second capping layer outside the second electrode. The first capping layer and the second capping layer may each independently include a compound represented by Formula 201, a compound represented by Formula 202.

In some embodiments, the first emitter may be an organometallic compound that includes platinum, and a first ligand bound to the platinum. The platinum-containing organometallic compound may comprise a compound represented by Formula 10 (as shown above).

In some embodiments, the first emitter may be an iridium-containing organometallic compound. The iridium-containing organometallic compound may comprise a compound represented by Formula 11 (as shown above).

The interlayer may include the hole transport region between the first electrode and the emission layer, and an electron transport region between the emission layer and the second electrode.

The electron transport region may comprise a compound represented by Formula 601 (as shown above).

Embodiments may provide an electronic device or an electronic apparatus comprising a light-emitting device of any of the above discussed embodiments.

The light-emitting devices may have a low driving voltage and high power efficiency. Accordingly, the light-emitting devices may enable the manufacture of a high-quality electronic device and a high-quality electronic apparatus.

Embodiments have been disclosed herein, and although terms are employed, they are used and are to be interpreted in a generic and descriptive sense only and not for purpose of limitation. In some instances, as would be apparent by one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the scope of the disclosure as set forth in the claims.

## Claims

1. A light-emitting device comprising:
a first electrode;
a second electrode facing the first electrode; and
an interlayer disposed between the first electrode and the second electrode, wherein
the interlayer includes a hole transport region and an emission layer,
the hole transport region is disposed between the first electrode and the emission layer,
the hole transport region includes a first layer,
the first layer directly contacts the emission layer,
the emission layer includes a first host and a first emitter,
the first emitter is arranged to emit first light having a first emission spectrum,
the first layer includes a first material,
an absolute value of a difference between a highest occupied molecular orbital, HOMO, energy level of the first material and a HOMO energy level of the first host is in a range of about 0 eV to about 0.20 eV,
an absolute value of a HOMO energy level of the first emitter is greater than an absolute value of the HOMO energy level of the first host, and
the HOMO energy level of each of the first material, the first host, and the first emitter is a negative value measured by cyclic voltammetry.

2. The light-emitting device of claim 1, wherein the HOMO energy level of the first material is in a range of about -5.60 eV to about -4.80 eV.

3. The light-emitting device of claim 1 or 2, wherein the HOMO energy level of the first host is in a range of about -5.10 eV to about -4.50 eV.

4. The light-emitting device of any one of claims 1 to 3, wherein an absolute value of a difference between the HOMO energy level of the first emitter and the HOMO energy level of the first host is in a range of about 0.01 eV to about 1.0 eV.

5. The light-emitting device of any one of claims 1 to 4, wherein
the hole transport region further comprises a second layer and a third layer,
the second layer is disposed between the first electrode and the first layer,
the third layer is disposed between the first electrode and the second layer,
the second layer includes a second material,
the third layer includes a third material, and
the first material, the second material, and the third material are different from each other.

6. The light-emitting device of claim 5, wherein
one of the following conditions are satisfied:
HOMO energy level of the third material > HOMO energy level of the second material > HOMO energy level of the first material; or
HOMO energy level of the third material > HOMO energy level of the first material > HOMO energy level of the second material, and
the HOMO energy level of each of the second material and the third material is a negative value measured by cyclic voltammetry.

7. The light-emitting device of claim 5 or 6, wherein
a HOMO energy level of the second material is in a range of about -5.40 eV to about -4.70 eV, and
the HOMO energy level of the second material is a negative value measured by cyclic voltammetry.

8. The light-emitting device of any one of claims 5 to 7, wherein
a HOMO energy level of the third material is in a range of about -5.25 eV to about -4.50 eV, and
the HOMO energy level of the third material is a negative value measured by cyclic voltammetry.

9. The light-emitting device of any one of claims 1 to 8, wherein the hole transport region further includes a p-dopant.

10. The light-emitting device of any one of claims 1 to 9, wherein a HOMO energy level of the first emitter is in a range of about -5.50 eV to about -4.00 eV.

11. The light-emitting device of any one of claims 1 to 10, wherein a peak wavelength of the first light is in a range of about 510 nm to about 610 nm.

12. The light-emitting device of any one of claims 1 to 11, wherein a full width at half maximum of the first light is in a range of about 15 nm to about 85 nm.

13. The light-emitting device of any one of claims 1 to 12, further comprising:
at least one of a first capping layer outside the first electrode and a second capping layer outside the second electrode, wherein
the at least one of the first capping layer and the second capping layer each independently includes a material having a refractive index of greater than or equal to about 1.6 with respect to a wavelength of about 589 nm;
optionally wherein the at least one of the first capping layer and the second capping layer each independently includes a material having a refractive index of greater than or equal to about 1.8 with respect to a wavelength of about 589 nm.

14. The light-emitting device of any one of claims 1 to 13, wherein
the first emitter is an organometallic compound that includes platinum, and a first ligand bound to the platinum, and
the first emitter satisfies at least one of Conditions A to C:
[Condition A]
the first ligand is a tetradentate ligand, and a number of cyclometallated rings formed by a chemical bond between the platinum and the first ligand is three;
[Condition B]
each of carbon, nitrogen, and oxygen of the first ligand is chemically bonded to the platinum;
[Condition C]
the first ligand includes an imidazole group, a benzimidazole group, a naphthoimidazole group, or a combination thereof.

15. The light-emitting device of any one of claims 1 to 13, wherein the first emitter is an organometallic compound that includes:
iridium; and
a first ligand, a second ligand, and a third ligand, each of which is bonded to the iridium,
the first ligand is a bidentate ligand comprising Y₁-containing ring B₁ and Y₂-containing ring B₂,
the second ligand is a bidentate ligand including Y₃-containing ring B₃ and Y₄-containing ring B₄,
the third ligand is a bidentate ligand comprising Y₅-containing ring B₅ and Y₆-containing ring B₆,
ring B₁ to ring B₆ are each independently a C₃-C₆₀ carbocyclic group or a C₁-C₆₀ heterocyclic group,
Y₁, Y₃, and Y₅ are each nitrogen (N),
Y₂, Y₄, and Y₆ are each carbon (C), and
Y₂-containing ring B₂ and Y₄-containing ring B₄ are different from each other.

16. An electronic device comprising the light-emitting device of any one of claims 1 to 15;
optionally further comprising:
a color filter, a color conversion layer, a touch screen layer, a polarizing layer, or a combination thereof.

17. An electronic apparatus comprising the light-emitting device of any one of claims 1 to 15;
optionally wherein the electronic apparatus is a flat panel display; a curved display; a computer monitor; a medical monitor; a TV; a billboard; an indoor light; an outdoor light; a signal light; a head-up display; a fully transparent display; a partially transparent display; a flexible display; a rollable display; a foldable display; a stretchable display; a laser printer; a phone; a cell phone; a tablet; a phablet; a personal digital assistant, PDA; a wearable device; a laptop computer; a digital camera; a camcorder; a viewfinder; a microdisplay; a three-dimensional, 3D, display; a virtual reality display; an augmented reality display; a vehicle; a video wall including multiple displays tiled together; a theater screen; a stadium screen; a phototherapy device; or a signage.
